# EUROPÄISCHE PATENTSCHRIFT

(11) **EP 2 057 625 B1**
(45) Veröffentlichungstag und Bekanntmachung des Hinweises auf die Patenterteilung: **27.04.2011**
(21) Anmeldenummer: 07818607.9
(22) Anmeldetag: 01.10.2007
(51) Int. Cl.: G10L 19/02, G10L 21/02

(54) **KODIERUNG EINES INFORMATIONSSIGNALS**
CODING OF AN INFORMATION SIGNAL
CODAGE D'UN SIGNAL D'INFORMATION

(30) Priorität: 18.10.2006 DE 102006049154
(43) Veröffentlichungstag der Anmeldung: 13.05.2009
(73) Patentinhaber: Fraunhofer-Gesellschaft zur Förderung der angewandten Forschung e.V., 80686 München (DE)
(72) Erfinder: SCHNELL, Markus, 91052 Erlangen (DE); SCHULDT, Michael, 82110 Germering (DE); LUTZKY, Manfred, 90409 Nürnberg (DE); JANDER, Manuel, 91052 Erlangen (DE)
(74) Vertreter: Schoppe, Fritz
(86) Internationale Anmeldenummer: PCT/EP2007/008527
(87) Internationale Veröffentlichungsnummer: WO 2008/046505

(56) Entgegenhaltungen:
- WO-A-01/26095
- "ISO/IEC 14496-3:2001/FDAM 1:2003(E), Bandwidth extension, ISO/IEC JTC1/SC29/WG11/N5570, International Standard, Amendment, Document stage (50) Approval" ISO/IEC, 10. Februar 2003 (2003-02-10), XP030012750
- GEIGER R ET AL: "ISO/IEC 14496-3:2005/PDAM 9, AAC ELD, ISO/IEC JTC1/SC29/WG11, MPEG2006/N8616, International Standard, Amendment, Document stage (30) Committee"[Online] 27. Oktober 2006 (2006-10-27), XP002458792 Gefunden im Internet: URL:http://www.itscj.ipsj.or.jp/sc29/open/ 29view/29n5462t.doc> [gefunden am 2007-11-13]
- SCHNELL M ET AL: "Enhanced MPEG-4 low delay AAC - Low bitrate high quality communication" CONVENTION PAPER 6998, PRESENTED AT THE 122ND AES CONVENTION, AUDIO ENGINEERING SOCIETY, 5. Mai 2007 (2007-05-05), - 8. Mai 2007 (2007-05-08) Seiten 1211-1223, XP009092156

## Beschreibung

Die vorliegende Erfindung bezieht sich auf die Audiocodierung und dort insbesondere die SBR- (Spectral Band Replication) Codierung.

Bei Anwendungen mit sehr geringer zur Verfügung stehender Bitrate ist es in dem Zusammenhang mit der Codierung von Audiosignalen bekannt, eine SBR-Technik zur Codierung zu verwenden. Dabei wird lediglich der niederfrequente Anteil vollständig codiert, d. h. in angemessener zeitlicher und spektraler Auflösung. Für den hochfrequenten Anteil wird lediglich die Spektraleinhüllende (spectral envelope) bzw. die Einhüllende des spektralen zeitlichen Verlaufs des Audiosignals erfasst und codiert. Decoderseitig wird der niederfrequente Anteil aus dem codierten Signal wiedergewonnen und anschließend herangezogen, um daraus den hochfrequenten Anteil zu rekonstruieren bzw. "nachzubilden". Um dabei aber die Energie des so vorläufig rekonstruierten Hochfrequenzanteils an die tatsächliche Energie in dem Hochfrequenzanteil des ursprünglichen Audiosignals anzupassen, wird decoderseitig die übertragene Spektraleinhüllende zur spektralen Gewichtung des vorläufig rekonstruierten Hochfrequenzanteils verwendet.

Damit sich der obige Aufwand lohnt, ist es natürlich wichtig, dass die verwendeten Anzahl von Bits zur Übertragung der Spektraleinhüllenden möglichst gering sind. Deshalb ist es wünschenswert, wenn das zeitliche Raster, in welchem die Spektraleinhüllende codiert wird, möglichst grob ist. Andererseits führt jedoch ein zu grobes Raster zu hörbaren Artefakten, was sich insbesondere bei Transienten bemerkbar macht, d. h. Stellen, an denen nicht, wie üblich, die Niederfrequenzanteile überwiegen, sondern vielmehr vornehmlich die Hochfrequenzanteile, oder an denen zumindest ein schneller Anstieg der Amplitude der Hochfrequenzanteile vorliegt. In Audiosignalen entsprechen solche Transienten beispielsweise den Notenanfängen, wie z. B. dem Anschlag einer Klavierseite oder dergleichen. Ist das Raster über den Zeitraum eines Transienten hinweg zu grob, so kann dies bei der decoderseitigen Rekonstruktion des gesamten Audiosignals zu hörbaren Artefakten führen. Denn decoderseitig wird ja das Hochfrequenzsignal aus dem Niederfrequenzanteil rekonstruiert, indem innerhalb eines Rasterbereichs die spektrale Energie des decodierten Niederfrequenzanteils normiert und dann durch Gewichtung an die übermittelte Spektraleinhüllende angepasst wird. Anders ausgedrückt wird innerhalb des Rasterbereichs einfach eine spektrale Gewichtung durchgeführt, um den Hochfrequenzanteil aus dem Niederfrequenzanteil zu reproduzieren. Ist aber der Rasterbereich um den Transienten herum zu groß, so steckt innerhalb dieses Rasterbereichs neben der Energie des Transienten viel Energie in dem Hintergrund- bzw. Akkordanteil in den Niederfrequenzanteil, der zur Reproduktion des Hochfrequenzanteils herangezogen wird. Dieser wird durch den Gewichtungsfaktor mitverstärkt, obwohl dies zu keiner guten Schätzung des Hochfrequenzanteils führt. Dies führt über den gesamten Rasterbereich hinweg zu einem hörbaren Artefakt, der zudem zeitlich noch vor dem eigentlichen Transienten einsetzt. Dieses Problem kann man auch als "vorecho" bzw. Pre-Echo bezeichnen.

Lösbar wäre das Problem, wenn der Rasterbereich um den Transienten herum eng genug ist, so dass sich das Transienten-Hintergrund-Verhältnis des Teils des Niederfrequenzanteils innerhalb dieses Rasterbereichs verbessert. Kleine Rasterbereichen bzw. kleine Rastergrenzabstände stehen jedoch dem oben skizzierten Wunsch nach einem geringen Bitverbrauch zur Codierung der Spektraleinhüllenden entgegen.

WO-A1-01/26095 offenbart ein Verfahren zur Kodierung mit geringer Datenrate: Segmentgrenzen und Frequenzauflösungen werden implizit durch die Angaben "Transientenanwesenheit" und "Transientenposition" signalisiert.

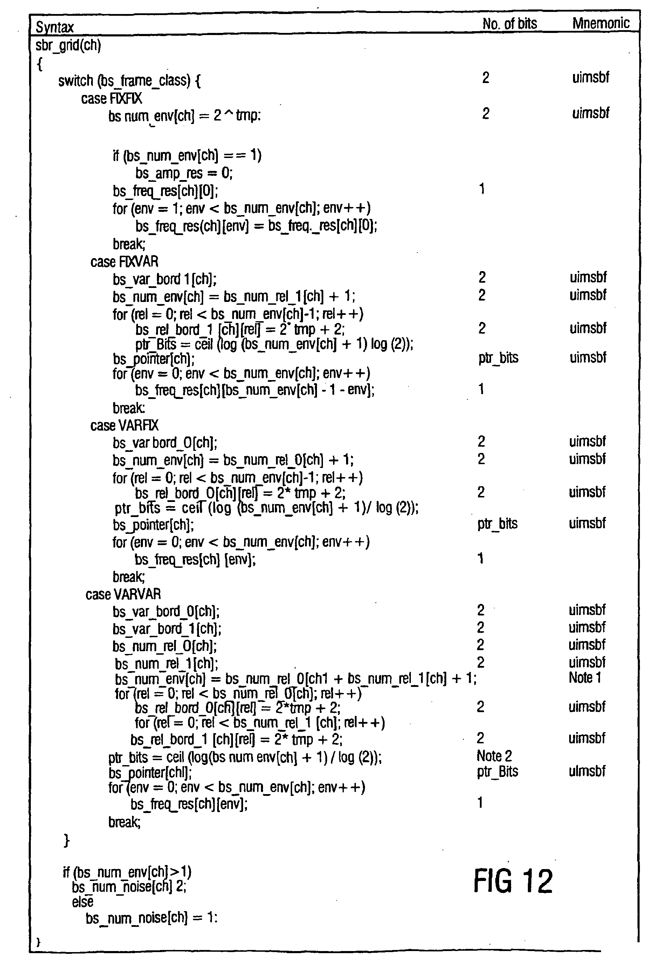

In dem Standard ISO/IEC 14496-3 - im Folgenden einfach mit "dem Standard" bezeichnet - wird eine SBR-Codierung im Zusammenhang mit dem AAC-Codierer beschrieben. Der AAC-Codierer codiert dabei den niederfrequenten Anteil frameweise. Für jedes solche SBR-Frame wird die oben erläuterte Zeit- und Frequenzauflösung definiert, in welcher die Spektraleinhüllende des Hochfrequenzanteils in diesem Frame codiert wird. Um das Problem zu adressieren, dass Transienten auch auf SBR-Framegrenzen fallen können, lässt es der Standard zu, dass das zeitliche Raster vorübergehend so definiert werden kann, dass die Rastergrenzen nicht unbedingt mit den Framegrenzen zusammenfallen. Vielmehr überträgt bei diesem Standard der Codierer an den Decodierer pro Frame ein Syntaxelement bs_frame_class, das pro Frame angibt, ob das zeitliche Raster der Spektraleinhüllendenrasterung für das jeweilige Frame exakt zwischen den beiden Framegrenzen definiert wird oder zwischen Grenzen, die von den Framegrenzen verschoben sind, und zwar vorne und/oder hinten. Insgesamt gibt es vier verschiedene Klassen von SBR-Frames, nämlich FIXFIX, FIXVAR, VARFIX und VARVAR. Die Syntax, die der Codierer in dem Standard dazu verwendet, pro SBR-Frame das Raster zu definieren, ist in Fig. 12 in einer Pseudo-Code-Darstellung gezeigt. Insbesondere sind bei der Darstellung von Fig. 12 diejenigen Syntax-Elemente, die von dem Codierer tatsächlich codiert bzw. übertragen werden, in Fig. 12 fett gedruckt, wobei die Anzahl der zur Übertragung bzw. Codierung verwendeten Bits in der zweiten Spalte von Rechts in der jeweiligen Zeile angezeigt ist. Wie es zu sehen ist, wird zunächst für jedes SBR-Frame das soeben genannte Syntaxelement bs_frame_class übertragen. Abhängig davon folgen weitere Syntaxelemente, die, wie es noch skizziert wird, die zeitliche Auflösung bzw. Rasterung definieren. Zeigt beispielsweise das 2-Bit-Syntexelement bs_frame_class an, dass es sich um ein FIXFIX-SBR-Frame handelt, so wird als zweites Syntaxelement das Syntaxelement tmp übertragen, das die Anzahl von Rasterbereichen in dieserim SBR-Frame bzw. die Anzahl von "Envelopes" als 2^{tmp} definiert. Das Syntax-Element bs_amp_res, das die Quantisierungsschrittweite zur Codierung der Sprektraleinhüllenden in dem aktuellen SBR-Frame verwendet wird, wird automatisch in Abhängigkeit von bs_num_env eingestellt und nicht codiert bzw. übertragen. Schließlich wird für ein FIXFIX-Frame noch ein Bit zur Bestimmung der Frequenzauflösung des Rasters bs_freq_res übertragen. FIXFIX-Frames sind genau für ein Frame definiert, d. h. die Rastergrenzen fallen mit den Framegrenzen zusammen, wie sie durch den AAC-Codierer definiert werden.

Dies ist anders für die anderen drei Klassen. Für FIXVAR, VARFIX und VARVAR-Frames werden Syntaxelemente bs_var_bord_1 und/oder bs_bar_bod_0 übertragen, um anzuzeigen, um wie viele Zeitschlitze, d. h. die Zeiteinheiten in denen die Filterbank zur spektralen Zerlegung des Audiosignals arbeitet, gegenüber den normalen Framegrenzen verschoben sind. Je nachdem werden dann auch Syntaxelemente bs_num_rel_1 und ein dazugehöriges tmp und/oder bs_num_rel_0 und ein dazugehöriges tmp übertragen, um eine Anzahl an Rasterbereichen bzw. Envelopes und die Größe derselben von der verschobenen Framegrenze aus zu definieren. Schließlich wird in den variablen SBR-Frames noch ein Syntaxelement bs_pointer übertragen, das auf eine der definierten Envelopes zeigt und dazu dient, um eine oder zwei Rausch-Envelopes zur Bestimmung des Rauschanteils in dem Frame abhängig von der Spektraleinhüllendenrasterung zu definieren, worauf jedoch im Folgenden.zur Vereinfachung der Darstellung nicht eingegangen werden soll. Schließlich wird noch für alle Rasterbereiche bzw. Envelopes in den jeweiligen variablen Frames die jeweilige Frequenzauflösung bestimmt, nämlich durch ein jeweiliges Ein-Bit-Syntaxelement bs_freq_res pro Envelope.

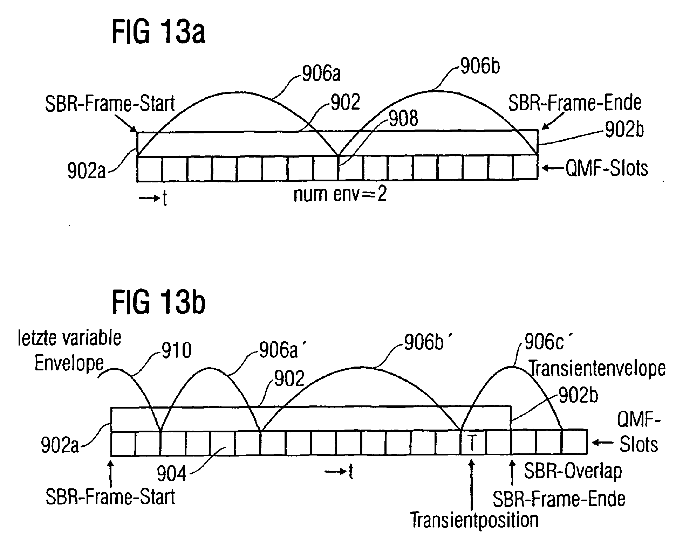

Fig. 13a stellt exemplarisch ein FIXFIX-Frame dar, bei dem das Syntaxelement tmp 1 ist, so dass die Anzahl der Envelopes bs_num_env 2¹=2 beträgt. In Fig. 13a wird angenommen, dass die Zeitachse waagerecht von links nach rechts verläuft. Ein SBR-Frame, d. h. eines der Frames, in welchem der AAC-Codierer die Kodierung des Niederfrequenzanteils vornimmt, ist in Fig. 13a mit den Bezugszeichen 902 angezeigt. Wie es zu sehen ist, ist das SBR-Frame 902 16 QMF-Slots lang, wobei es sich bei den QMF-Slots wie erwähnt um die Zeitschlitze handelt, in welchen Einheiten die Analyse Filterbank arbeitet, wobei die QMF-Slots in Fig. 13a mit Kästchen 904 angezeigt sind. Bei FIXFIX-Frames nehmen die Envelopes bzw. Rasterbereiche 906a und 906b, hier also zwei an Zahl, die gleiche Länge innerhalb der SBR-Frames 902 ein, so dass eine Zeitraster- bzw. Envelope-Grenze 908 genau in der Mitte des SBR-Frames 902 definiert wird. Auf diese Weise definiert das exemplarische FIXFIX-Frame von Fig. 13a, dass aus den Spektralwerten der Analysefilterbank zeitlich eine spektrale Verteilung für den Rasterbereich bzw. die Envelope 906a und ein weiteres für die Envelope 906 bestimmt wird. Die Envelopes bzw. Rasterbereiche 906a und 906b legen somit das Raster fest, in welchem die Spektraleinhüllende codiert bzw. übertragen wird.

Fig. 13b zeigt zum Vergleich ein VARVAR-Frame. SBR-Frame 902 und die zugehörigen QMF-Slots 904 sind wieder angezeigt. Für dieses SBR-Frame ist allerdings durch die Syntaxelemente bs_var_bord_0 bzw. bs_var_bord_1 definiert worden, das die zu diesem gehörenden Envelopes 906a', 906b' und 906c' nicht an dem SBR-Frame-Start 902a beginnen bzw. an dem SBR-Frame-Ende 902b enden sollen. Vielmehr ist aus Fig. 13b erkennbar, dass bereits das vorhergehende SBR-Frame (in Fig. 13b nicht zu sehen) zwei QMF-Slots über den SBR-Frame-Start 902a des aktuellen SBR-Frame hinaus verlängert worden ist, so dass sich die letzte Envelope 910 des vorhergehenden SBR-Frames noch in das aktuelle SBR-Frame 902 hinein erstreckt. Die letzte Envelope 906c' das aktuellen Frames erstreckt sich ebenfalls über das SBR-Frame-Ende des aktuellen SBR-Frames 902 hinaus, nämlich hier exemplarisch ebenfalls um zwei QMF-Slots. Ferner sieht man hier exemplarisch, dass die Syntaxelemente des VARVAR-Frames bs_num_rel_0 und bs_num_rel_1 auf jeweils 1 eingestellt sind, mit der zusätzlichen Information, dass die so definierten Envelopes zu Beginn und Ende des SBR-Frames 902, nämlich 906a' und 906b' gemäß tmp = 1 vier QMF-Slots lang sind, um sich somit um diese Anzahl von Slots von den Framegrenzen in das SBR-Frame 902 hinein zu erstrecken. Der verbleibende Raum des SBR-Frames 902 wird dann durch die verbleibende Envelope, hier die dritte Envelope 906b' eingenommen.

In Fig. 13b ist mit T in einem der QMF-Slots 904 auch exemplarisch der Grund dafür angezeigt, dass hier ein VARVAR-Frame definiert worden ist, nämlich weil sich die Transientenposition T nahe an dem SBR-Frameende 902b befindet, und auch in dem SBR-Frame vor dem aktuellen wohl ein Transient war (nicht zu sehen).

Die standardisierte Version nach ISO/ICE 14496-3 beinhaltet also eine Überlappung von zwei aufeinander folgenden SBR-Främes. Dieses ermöglicht ein variables Setzen der Envelopegrenzen, unabhängig von den eigentlichen SBR-Framegrenzen entsprechend dem Signalverlauf. Transienten können so durch eigene Envelopes eingehüllt werden und deren Energie vom restlichen Signal abgekapselt werden. Eine Überlappung beinhaltet aber auch ein zusätzliches Systemdelay, wie es im Vorhergehenden dargestellt worden ist. Insbesondere werden in dem Standard für die Signalisierung vier Frame-Klassen verwendet. Bei der FIXFIX-Klasse fallen die Grenzen der SBR-Envelopes, wie in Fig. 13a gezeigt, mit den Grenzen des Core-Frames zusammen. Die FIXFIX-Klasse wird verwendet, wenn sich kein Transient in diesem Frame befindet. Die Anzahl der Envelopes legt deren äquidistante Verteilung innerhalb des Frames fest. Die FIXVAR-Klasse ist vorgesehen, wenn sich ein Transient im aktuellen Frame befindet. Hier beginnt also das jeweilige Set von Envelopes an der SBR-Frame-Grenze und endet variabel im SBR-Übertragungsbereich. Die VARFIX-Klasse ist für den Fall vorgesehen, dass sich ein Transient nicht in dem aktuellen aber in dem vorhergehenden Frame befindet. Die Folge der Envelopes aus dem letzten Frame wird hier durch ein neues Set von Envelopes fortgesetzt, das an der SBR-Framegrenze endet. Die VARVAR-Klasse ist vorgesehen für den Fall, dass sich ein Transient sowohl in dem letzten als auch in dem aktuellen Frame befindet. Hier wird eine variable Folge von Envelopes durch eine weitere variable Folge fortgesetzt. Wie oben beschrieben werden dabei die Grenzen der variablen Envelopes relativ zueinander übertragen.

Obwohl die Anzahl der QMF-Slots, um die die Grenzen durch die Syntaxelemente bs_var_bord_0 und bs_var_bord_1 gegenüber den festen Framegrenzen verschoben werden können, erzeugt diese Möglichkeit aufgrund des Auftretens von Envelopes, die sich über SBR-Framegrenzen hinaus erstrecken und somit die Bildung bzw. Mittlung von Spektralsignalenergien über SBR-Framegrenzen hinweg erforderlich machen, eine Verzögerung auf Decoderseite. Diese zeitliche Verzögerung ist aber bei manchen Anwendungen nicht duldbar, wie z. B. bei Anwendungen im Bereich des Telefonierens oder anderen Life-Anwendungen, bei denen es darauf ankommt, dass die zeitlichen Verzögerung durch die Codierung und Decodierung gering ist. Obwohl also das Auftreten von Pre-Echos verhindert wird, ist die Lösung für Anwendungen, die eine kurze Verzögerungszeit benötigen, nicht geeignet. Ferner ist die Anzahl an Bits, die zur Übertragung der SBR-Frames in dem oben beschriebenen Standard erforderlich ist, relativ hoch.

Die Aufgabe der vorliegenden Erfindung besteht darin, ein Codierschema zu schaffen, das bei ausreichender Adressierung des Transienten- bzw. Pre-Echo-Problems mit moderater oder sogar niedriger Bitrate niedrigere Verzögerungszeiten oder bei ausreichender Adressierung des Transienten- bzw. Pre-Echo-Problems eine reduzierte Verzögerungszeit bei moderaten Bitrateneinbußen zulässt.

Diese Aufgabe wird durch einen Codierer gemäß Anspruch 1 oder 32, einen Decodierer gemäß Anspruch 12, 26 oder 36, ein codiertes Audio signal gemäß Anspruch 23 oder 39 sowie durch ein Verfahren gemäß Anspruch 24, 25, 31, 33, 37 oder 38 gelöst.

Eine Erkenntnis der vorliegenden Erfindung besteht darin, dass das Transientenproblem ausreichend adressiert und dafür eine weitere Verzögerung auf Seiten der Decodierung reduziert werden kann, wenn eine neue SBR-Frame-Klasse verwendet wird, bei der die Framegrenzen nicht verschoben werden, d. h. die Rastergrenzen immer noch mit den Framegrenzen synchronisiert sind, aber bei der ferner eine Transientenpositionsangabe als Syntaxelement verwendet wird, um codierer- bzw. decodiererseitig innerhalb der Frames dieser neuen Frameklasse zur Bestimmung der Rastergrenzen innerhalb dieser Frames verwendet zu werden.

Gemäß einem Ausführungsbeispiel der vorliegenden Erfindung wird die Transientenpositionsangabe so verwendet, dass um die Transientenposition herum ein relativ kurzer Rasterbereich, im Folgenden als Transientenenvelope bezeichnet, definiert ist, während sich in dem restlichen Teil davor und/oder dahinter in dem Frame lediglich eine Envelope von der Transientenenvelope bis zu dem Start bzw. dem Ende des Frames erstreckt. Die Anzahl an zu übertragenden bzw. zu codierenden Bits für die neue Klasse von Frames ist damit ebenfalls sehr gering. Andererseits können Transienten bzw. damit verbundene Pre-Echo-Probleme ausreichend adressiert werden. Variable SBR-Frames, wie FIXVAR, VARFIX und VARVAR, sind dann nicht mehr erforderlich, so dass Verzögerungen zur .Kompensation von Envelopes, die sich über SBR-Framegrenzen hinaus erstrecken, nicht mehr notwendig sind. Gemäß einem Ausführungsbeispiel der vorliegenden Erfindung sind demnach auch lediglich noch zwei Frameklassen zugelassen, nämlich eine FIXFIX-Klasse und diese eben beschriebene Klasse, die im Folgenden als LD_TRAN-Klasse bezeichnet wird.

Gemäß einem weiteren Ausführungsbeispiel der vorliegenden Erfindung wird nicht immer für jeden Rasterbereich in den Frames der LD_TRAN-Klasse ein bzw. mehrere Spekraleinhüllenden- bzw. Spektralenergiewerte übertragen bzw. in das codierte Informationssignal eingefügt, nämlich dann nicht, wenn die in ihrer Position innerhalb des Frames durch die Transientenpositionsangabe festgelegte Transientenenvelope nahe an der zeitlich vorderen Framegrenze liegt, so dass sich die sich zwischen der zeitlich vorderen Framegrenze und der Transientenenvelope befindliche Envelope dieses LD_TRAN-Frames über lediglich einen kurzen Zeitraum hinweg erstreckt, was aus Sicht der Codiereffizienz heraus aber nicht gerechtfertigt ist, da ja die Kürze dieser Envelope nicht durch einen Transienten bedingt ist sonder viel mehr durch die zufällige zeitliche Nähe der Framegrenze und des Transienten. Gemäß diesem alternativen Ausführungsbeispiel werden deshalb für diese betreffende Envelope der bzw. die Spektralenergiewerte und die entsprechende Frequenzauflösung der vorhergehenden Envelope übernommen, ebenso wie beispielsweise der Rauschanteil. Eine Übertragung kann also unterbleiben, weshalb die Komprimierungsrate erhöht ist. Umgekehrt sind Einbußen an Hörqualität nur gering, da an dieser Stelle keine Transientenproblematik besteht. Ferner tritt decoderseitig auch keine Verzögerung auf, da für alle beteiligten Envelopes, d. h. Envelope aus vorhergehendem Frame, Transientenenvelope und dazwischen befindliche Envelope, die Verwendung zur Hochfrequenzrekonstruktion unmittelbar möglich ist.

Gemäß einem weiteren Ausführungsbeispiel wird die Problematik einer ungewollt hohen Datenmenge bei Aufkommen eines Transienten an dem Ende eines LD_TRAN-Frames dadurch begegnet, dass zwischen Encoder und Decoder vereinbart wird, wie viel die an die hintere Framegrenze des aktuellen LD_TRAN-Frames befindliche Transientenenvelope in das nachfolgende Frame virtuell hineinragen soll. Die Entscheidung wird beispielsweise mittels Tabellenzugriff in Encoder und Decoder .gleichermaßen getroffen. Vereinbarungsgemäß wird dann die erste Envelope des nachfolgenden Frames, wie z. B. die einzige Envelope eines FIXFIX-Frames, verkürzt, um erst am Ende der virtuellen erstreckten Envelope zu beginnen. Den bzw. die spektralen Energiewerte für die virtuelle Envelope berechnet der Encoder für die gesamte Zeitdauer dieser virtuellen Envelope hinweg und überträgt aber das Ergebnis vordergründig nur für die Transientenenvelope, gegebenenfalls in einer abhängig von dem Verhältnis des zeitlichen Anteils der virtuellen Envelope in dem vorderen und hinteren Frame reduzierten Weise. Decoderseitig werden der bzw. die spektralen Energiewerte der am Ende befindlichen Transientenenvelope sowohl zur Hochfrequenzrekonstruktion in dieser Transientenenvelope als auch, getrennt hiervon, zu Hochfrequenzrekonstruktion in dem anfänglichen Erstreckungsbereich in dem nachfolgenden Frames verwendet, indem ein bzw. mehrere Spektralenergiewerte für diesen Bereich aus dem bzw. denen der Transientenenvelope hergeleitet werden. Ein "Überabtasten" von an Framegrenzen befindlichen Transienten wird dadurch vermieden.

Gemäß einem weiteren Aspekt der vorliegenden Erfindung besteht eine Erkenntnis der vorliegenden Erfindung darin, dass die in der Beschreibungseinleitung beschriebene Transientenproblematik ausreichend adressiert und eine Verzögerung auf Seiten der Decodierung reduziert werden kann, wenn zwar eine Envelope- bzw. Rasterbereicheinteilung verwendet wird, nach welcher sich Envelopes zwar über Framegrenzen erstrecken können, um mit zwei benachbarten Frames zu überlappen, aber dabei diese Envelopes von dem Decodierer noch einmal an der Framegrenze unterteilt werden und die Hochfrequenzrekonstruktion an dem so unterteilten mit den Framegrenzen zusammenfallenden Raster durchgeführt wird. Für die so erhaltenen Teilrasterbereiche der Oberlappungsrasterbereiche wird decoderseitig jeweils ein bzw. eine Mehrzahl von spektralen Energiewerten aus dem einen bzw. der Mehrzahl von spektralen Energiewerten gewonnen, wie sie für die sich über die Framegrenze hinweg erstreckende Envelope übertragen worden ist.

Gemäß einem noch weiteren Aspekt der vorliegenden Erfindung besteht eine Erkenntnis der vorliegenden Erfindung darin, dass eine Verzögerung auf Seiten der Decodierung durch Reduzierung der Framegröße bzw. der Anzahl der darin enthaltenen Abtastwerte erhalten und der Effekt der damit verbundenen erhöhten Bitrate reduziert werden kann, wenn für Frames mit Rekonstruktionsmodi, nach denen die Rastergrenzen mit den Framegrenzen dieser Frames zusammenfallen, wie z.B. FIXFIX-Frames, bzw. für den entsprechenden Rekonstruktionsmodus ein neues Flag eingeführt wird bzw. eine Transientenabwesenheitanzeige eingeführt wird. Findet sich nämlich kein Transient in einem solchen kürzeren Frame, und findet sich auch sonst kein Transient in der Nähe dieses Frames, so dass das Informationssignal an dieser Stelle stationär ist, so kann die Transientenabwesenheitanzeige dazu verwendet werden, für den ersten Rasterbereich eines solches Frames keinen die Spektraleinhüllende beschreibenden Wert in das codierte Informationssignal einzubringen, sondern diesen decoderseitig vielmehr aus dem bzw. den die Spektraleinhüllende darstellenden Werten herzuleiten bzw. zu gewinnen, die in dem codierten Informationssignäl für den letzten Rasterbereich bzw. die letzte Envelope des zeitlich vorhergehenden Frames vorgesehen sind. Auf diese Weise ist eine Verkürzung der Frames mit reduzierter Auswirkung auf die Bitrate möglich, welche Verkürzung einerseits niedrigere Verzögerungszeiten ermöglicht und andererseits die Transientenproblematik aufgrund der kleineren Frameeinheiten ermöglicht.

Bevorzugte Ausführungsbeispiele der vorliegenden Erfindung werden nachfolgend Bezug nehmend auf die beiliegenden Zeichnungen näher erläutert. Es zeigen:
- Fig. 1: ein Blockschaltbild eines Codierers gemäß einem Ausführungsbeispiel der vorliegenden Erfindung;

- Fig. 2: einen Pseudo-Code zur Beschreibung der Syntax der Syntaxelemente, die der Codierer nach Fig. 1 zur Definition der SBR-Framerasteraufteilung verwen- det;
- Fig. 3: eine Tabelle, die codierer- und decodiererseitig definiert sein kann, um aus dem Syntaxelement bs_transient_position in Fig. 2 die Information über Anzahl der Envelopes bzw. Rasterbereiche und die Positionen der Rasterbereichsgrenzen inner- halb eines LD_TRAN-Frames zu gewinnen;
- Fig. 4a: eine schematische Darstellung zur Veranschauli- chung eines LD_TRAN-Frames;
- Fig. 4b: eine schematische Darstellung zur Veranschauli- chung des Zusammenspiels der Analysefilterbank und des Envelopedatenberechners in Fig. 1;
- Fig. 5: ein Blockschaltbild eines Decodierers gemäß einem Ausführungsbeispiel der vorliegenden Erfindung;
- Fig. 6a: eine schematische Darstellung zur Veranschauli- chung eines LD_TRAN-Frames mit weit vorne befind- licher Transientenenvelope zur Veranschaulichung der sich ergebenden Problematik in diesem Fall;
- Fig. 6b: eine schematische Darstellung zur Veranschauli- chung eines Falles, bei dem sich ein Transient zwischen zwei Frames befindet, zur Veranschauli- chung der entsprechenden Problematik im Hinblick auf den hohen Codierungsaufwand in diesem Fall;
- Fig. 7a: eine schematische Darstellung zur Veranschauli- chung einer Envelopecodierung gemäß einem Ausfüh- rungsbeispiel zur Überwindung der Problematik nach Fig. 6a;

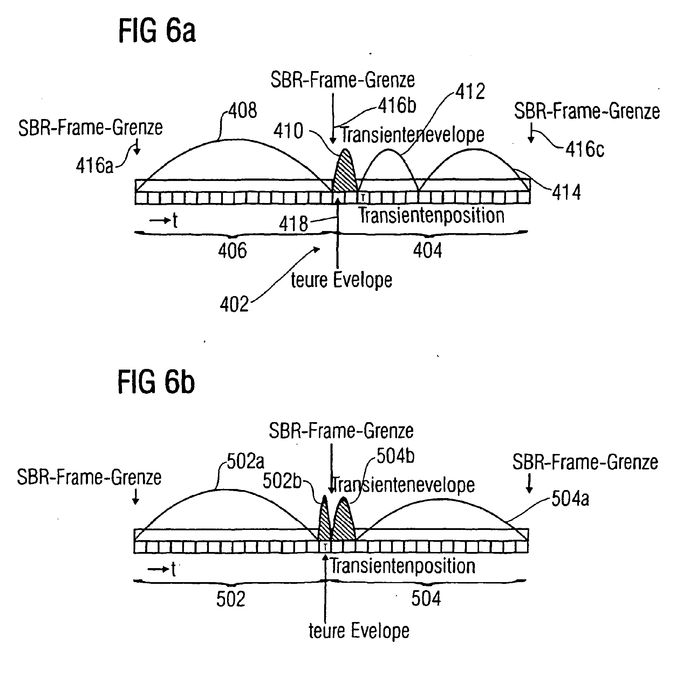

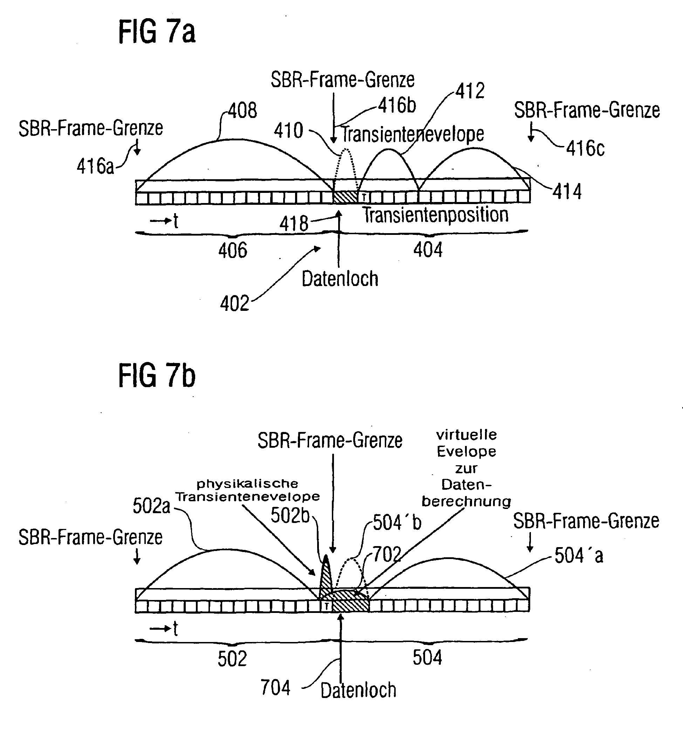

- Fig. 7a: eine schematische Darstellung zur Veranschauli- chung einer Envelopecodierung gemäß einem Ausfüh- rungsbeispiel zur Überwindung der Problematik nach Fig. 6b;

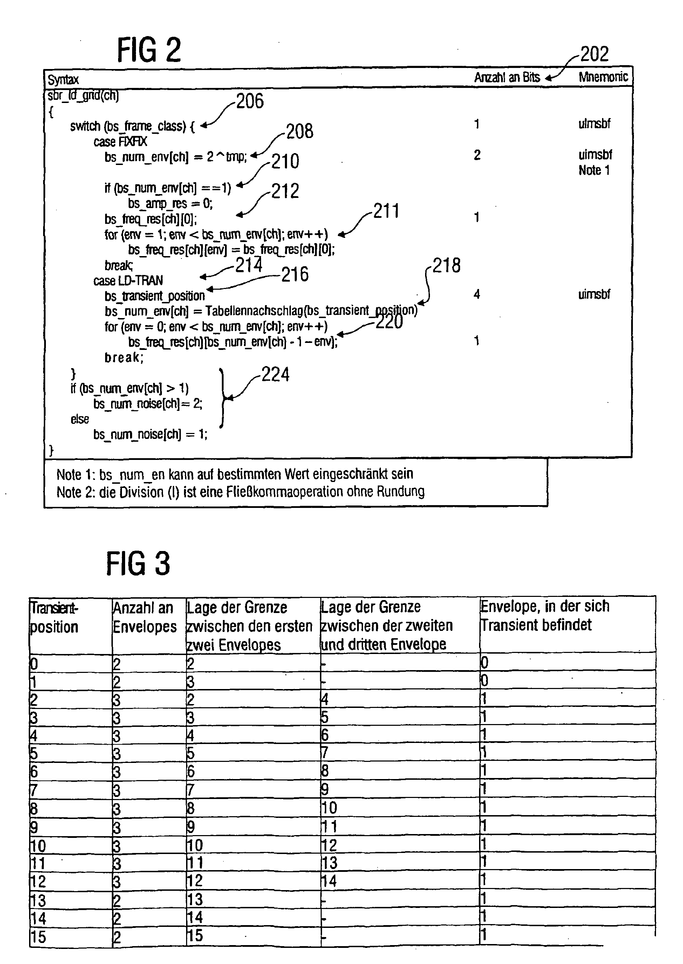

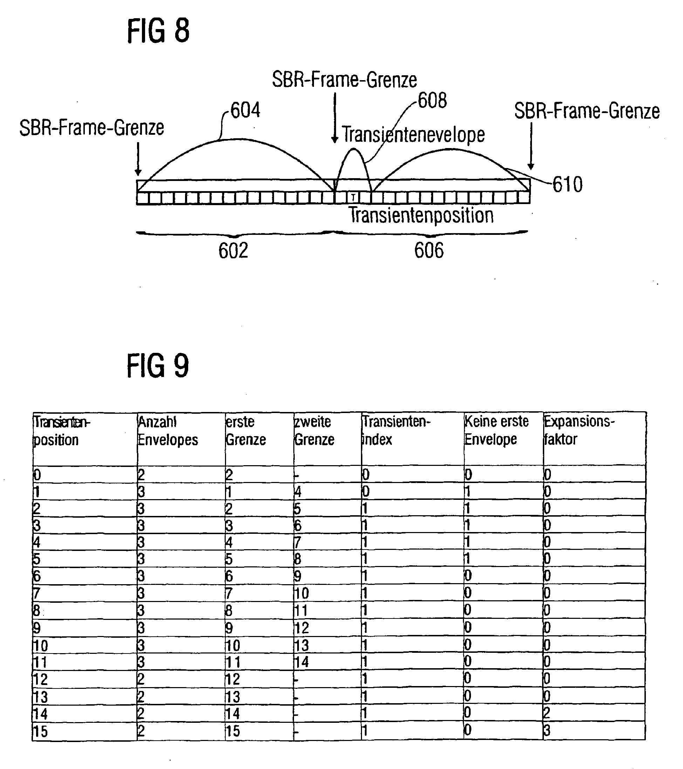

- Fig. 8: eine schematische Darstellung zur Veranschauli- chung eines LD_TRAN-Frames mit Transientenpositi- on TranPos = 1 gemäß Tabelle von Fig. 3;
- Fig. 9: eine Tabelle, die codierer- und decodiererseitig definiert sein kann, um aus dem Syntaxelement bs_transient_position in Fig. 2 die Information über Anzahl der Envelopes bzw. Rasterbereiche und die Positionen der Rasterbereichsgrenze(n) inner- halb eines LD_TRAN-Frames zu gewinnen sowie die Information über die Datenübernahme aus dem vor- hergehenden Frame gemäß Fig. 7a und die Daten- erstreckung in das nachfolgende Frame hinein ge- mäß Fig. 7b;

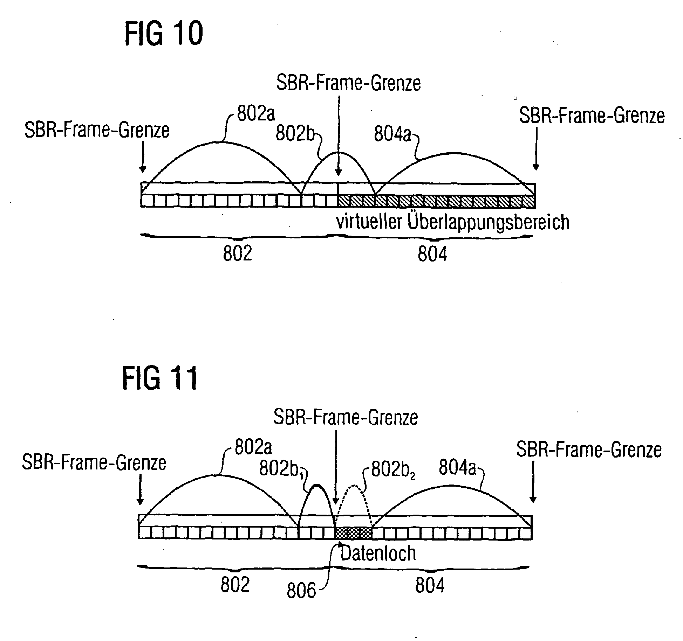

- Fig. 10: eine schematische Darstellung einer FIXVAR- VARFIX-Sequenz zur Veranschaulichung einer Enve- lopesignalisierung mit sich über Framegrenzen erstreckenden Envelopes;
- Fig. 11: eine schematische Darstellung einer Decodierung, die eine geringere Verzögerungszeit trotz einer Envelopesignalisierung nach Fig. 10 ermöglicht, gemäß einem weiteren Ausführungsbeispiel der vor- liegenden Erfindung;
- Fig. 12: ein Pseudo-Code der Syntax zur SBR-Frame- Envelope-Aufteilung gemäß dem ISO/IEC 14496-3- Standard; und
- Fig. 13a: und 13b schematische Darstellungen eines FIXFIX- bzw. VARVAR-Frames.

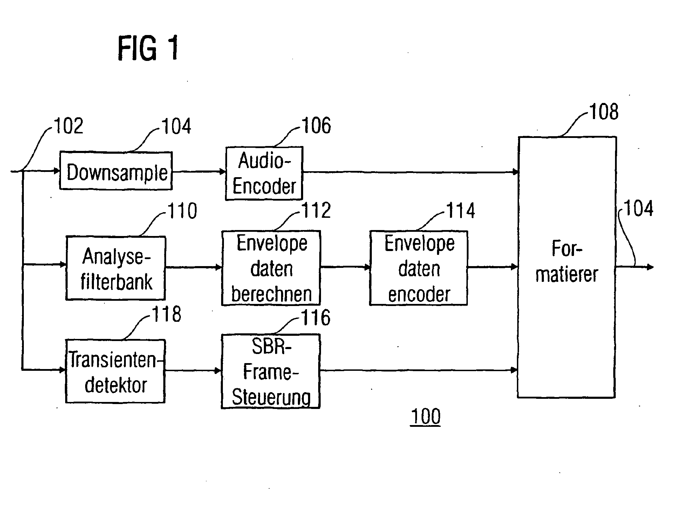

Fig. 1 zeigt den Aufbau eines Codierers gemäß einem Ausführungsbeispiel der vorliegenden Erfindung. Der Codierer von Fig. 1 ist exemplarisch ein Audiocodierer, der allgemein mit dem Bezugszeichen 100 angezeigt ist. Er umfasst einen Eingang 102 für das zu codierende Audiosignal und einen Ausgang 104 für das codierte Audiosignal. Im Folgenden wird davon ausgegangen, dass es sich bei dem Audiosignal in dem Eingang 102 um ein abgetastetes Audiosignal handelt, wie z. B. um ein PCM-codiertes Signal. Eine andere Implementierung des Codierers von Fig. 1 ist aber ebenfalls möglich.

Der Codierer von Fig. 1 umfasst ferner einen Abwärtsabtaster bzw. Downsampler 104 sowie einen Audiocodierer 106, die in der genannten Reihenfolge zwischen den Eingang 102 und einen ersten Eingang eines Formatierers 108 geschaltet sind, dessen Ausgang wiederum mit dem Ausgang 104 des Codierers 100 verbunden ist. Durch die Verschaltung der Komponenten 104 und 106 ergibt sich an dem Ausgang des Audiocodierers 106 eine Codierung des abwärts abgetasteten Audiosignals 102, was wiederum einer Codierung des Niederfrequenzanteils des Audiosignals 102 entspricht. Der Audiocodierer 106 ist ein frameweise arbeitender Codierer in dem Sinne, dass das Codierergebnis, das an den Ausgang des Audiocodierers 106 anliegt, nur in Einheiten dieser Frames decodierbar ist. Exemplarisch wird im Folgenden davon ausgegangen, dass es sich bei dem Audiocodierer 106 um einen AAC-LD-konformen Codierer gemäß dem Standard nach ISO/IEC 14496-3 handelt.

Zwischen den Eingang 102 und einen weiteren Eingang des Formatierers 108 sind eine Analysefilterbank 110, ein Envelopedatenberechner 112 sowie ein Envelopedatencodierer 114 in der genannten Reihenfolge geschaltet. Zusätzlich umfasst der Codierer 100 eine SBR-Frame-Steuerung 116, zwischen deren Eingang und den Eingang 102 ein Transientendetektor 118 geschaltet ist. Ausgänge der SBR-Framesteuerung 116 sind sowohl mit einem Eingang des Envelopedatenberechners 112 als auch mit einem weiteren Eingang des Formatierers 108 verbunden.

Nachdem im Vorhergehenden der Aufbau des Codierers von Fig. 1 beschrieben worden ist, wird im Folgenden dessen Funktionsweise beschrieben. Wie bereits erwähnt, trifft an dem ersten Eingang des Formatierers 108 eine codierte Version des Niederfrequenzanteils des Audiosignals 102 ein, indem der Audiocodierer 106 die abwärts abgetastete Version des Audiosignals 102, in der beispielsweise nur jeder zweite Abtastwert des ursprünglichen Audiosignals weitergeleitet wird, codiert. Die Analysefilterbank 110 erzeugt eine spektrale Zerlegung des Audiosignals 102 mit einer gewissen zeitlichen Auflösung. Exemplarisch wird davon ausgegangen, dass es sich bei der Analysefilterbank 110 um eine QMF-Filterbank (QMF = quadrature mirror filter) handelt. Die Analysefilterbank 110 erzeugt pro QMF-Zeitschlitz M Subbandwerte, wobei die QMF-Zeitschlitze beispielsweise jeweils 64 Audioabtastwerte umfassen. Um die Datenrate zu reduzieren, bildet der Envelopedatenberechner 112 aus den zeitlich und spektral hochaufgelösten Spektralinformationen der Analysefilterbank 110 eine Darstellung der Spektralenhüllenden des Audiosignals 102 mit einer geeignet niedrigeren Auflösung, d. h. in einem geeigneten Zeit- und Frequenzraster. Dabei wird das Zeit- und Frequenzraster durch die SBR-Frame-Steuerung 116 pro Frame eingestellt, d. h. pro Frame der Frames, wie sie durch den Audiocodierer 106 definiert sind. Diese Steuerung nimmt die SBR-Framesteuerung 116 wiederum abhängig von erfassten bzw. lokalisierten Transienten vor, wie sie von dem Transientendetektor 118 erfasst bzw. lokalisiert werden. Zur Erfassung von Transienten bzw. Notenanfangszeitpunkten nimmt der Transientendetektor 118 eine geeignete statistische Analyse des Audiosignals 102 vor. Die Analyse kann dabei im Zeitbereich oder im Spektralbereich durchgeführt werden. Der Transientendetektor 118 kann beispielsweise die zeitliche Hüllkürve des Audiosignals auswerten, wie z. B. die Auswertung des Anstiegs der zeitlichen Hüllkurve. Wie es im Folgenden noch näher beschrieben werden wird, ordnet die SBR-Frame-Steuerung 116 jedes Frame bzw. SBR-Frame einer von zwei möglichen SBR-Frameklassen zu, nämlich entweder der FIXFIX-Klasse oder der LD_TRAN-Klasse. Insbesondere ordnet die SBR-Framesteuerung 116 jedem Frame, in dem sich kein Transient befindet, die FIXFIX-Klasse zu, wohingegen die Frame-Steuerung jedem Frame, indem sich ein Transient befindet, die LD_TRAN-Klasse zuordnet. Der Envelopedatenberechner 112 stellt das zeitliche Raster gemäß den SBR-Frame-Klassen ein, wie sie den Frames durch die SBR-Framesteuerung 116 zugeordnet worden sind. Unabhängig von der genauen Zuordnung fallen alle Framegrenzen immer mit Rastergrenzen zusammen. Lediglich die Rastergrenzen innerhalb der Frames werden durch die Klassenzuordnung beeinflusst. Wie ferner im Folgenden noch näher erörtert wird, stellt die SBR-Framesteuerung je nach zugeordneter Frameklasse noch weitere Syntaxelemente ein, und gibt diese an den Formatierer 108 aus. Obwohl in Fig. 1 nicht explizit dargestellt, können die Syntaxelemente dabei natürlich noch einer Codierung unterzogen werden.

Der Envelopedatenberechner 112 gibt also eine Darstellung der Spektraleinhüllenden in einer Auflösung aus, die dem zeitlichen und spektralen Raster entspricht, der durch die SBR-Framesteuerung 116 vorgegeben wird, nämlich durch einen Spektralwert pro Rasterbereich. Diese Spektralwerte werden durch den Envelopedatencodierer 114 codiert und an den Formatierer 108 weitergegeben. Gegebenenfalls kann der Envelopedatencodierer 114 auch fehlen. Der Formatierer 108 fasst die erhaltenen Informationen zu dem codierten Audiodatenstrom 104 bzw. dem codierten Audiosignal zusammen und gibt selbiges an dem Ausgang 104 aus.

Im Folgenden wird die Funktionsweise des Codierers von Fig. 1 noch ein wenig genauer unter Zuhilfenahme der Fig. 2 bis 4b im Hinblick auf die zeitliche Rastereinteilung beschrieben, die durch die SBR-Frame-Steuerung 116 eingestellt und von dem Envelopedatenberechner 112 herangezogen wird, um aus dem Analysefilterbankausgangssignal die Signaleinhüllende in der vorgegebenen Rastereinteilung zu bestimmen.

Fig. 2 zeigt zunächst durch einen Pseudo-Code, durch welche Syntaxelemente die SBR-Frame-Steuerung 116 die Rastereinteilung vorgibt, die der Envelopedatenberechner 112 verwenden soll. Wie in dem Fall von Fig. 12 sind in Fig. 2 diejenigen Syntaxelemente, die tatsächlich von der SBR-Framesteuerung 116 an den Formatierer 108 zur Codierung bzw. zur Übertragung weitergeleitet werden, fettgedruckt dargestellt, wobei in der Spalte 202 in der jeweiligen Zeile die Anzahl an Bits angezeigt ist, die zur Darstellung des jeweiligen Syntaxelements verwendet wird. Wie es zu sehen ist, wird zunächst für das SBR-Frame durch das Syntaxelement bs_frame_class bestimmt, ob es sich bei dem SBR-Frame um ein FIXFIX-Frame bzw. ein LD_TRAN-Frame handelt. Je nachdem (204) erfolgt dann die Übertragung unterschiedlicher Syntaxelemente. In dem Fall der FIXFIX-Klasse (206) wird zunächst durch das 2-Bit-Syntax-Element tmp das Syntaxelement bs_num_env[ch] des aktuellen SBR-Frames ch auf 2^{tmp} eingestellt (208). Abhängig von der Anzahl bs_nüm_env[ch] wird das Syntaxelement bs_amp_res auf einem vorher vorgabemäßig eingestellten Wert von 1 belassen oder auf Null eingestellt (210), wobei das Syntaxelement bs_amp_res die Quantisierungsgenauigkeit angibt, mit der die in der vorgegebenen Rasterung durch den Berechner 112 erhaltenen spektraleinhüllenden Werte durch den Codierer 114 codiert an den Formatierer 108 weitergegeben werden. Die durch bs_num_env[ch] in ihrer Anzahl vorgegebenen Rasterbereiche bzw. Envelopes werden bezüglich ihrer Frequenzatiflösung, die in denselben durch den Envelopedatenberechner 112 herangezogen werden soll, um in denselben die Spektraleinhüllende zu bestimmen, durch ein gemeinsames (211) Syntaxelement bs_freq_res[ch] eingestellt, das mit einem Bit von der SBR-Framesteuerung 116 an den Formatierer 108 weitergeleitet wird (212).

Anhand von Fig. 13a soll im Folgenden noch einmal die Funktionsweise des Envelopedatenberechners 112 beschrieben werden, wenn durch die SBR-Framesteuerung 116 vorgegeben wird, dass es sich bei einem aktuellen SBR-Frame 902 um ein FIXFIXFIX-Frame handelt. In diesem Fall unterteilt der Envelopedatenberechner 112 das aktuelle Frame 902, das aus hier exemplarisch N = 16 Analysefilterbankzeitschlitzen 904 besteht, gleichmäßig in Rasterbereiche bzw. Envelopes 906a und 906b auf, so dass hier beide Rasterbereiche bzw. beide Envelopes 906a, 906b N/bs_num_inv[ch] Zeitschlitze 904 lang sind und so viele Zeitschlitze zwischen den SBR-Framegrenzen 902a und 902b einnehmen. Anders ausgedrückt ordnet der Envelopedatenberechner 112 bei FIXFIX-Frames die Rästergrenzen 908 innerhalb dieser SBR-Frames äquidistant verteilt gleichmäßig zwischen den SBR-Framegrenzen 902a, 902b an. Wie bereits erwähnt gibt die Analysefilterbank 110 pro Zeitschlitz 904 Subbandspektralwerte aus. Der Envelopedatenberechner 112 fasst nun zeitlich die Subbandwerte envelopeweise zusammen und addiert ihre Quadratsummen um die .Sübbandenergien in Envelopeauflösung zu erhalten. Je nach dem Syntaxelement bs_freq_res[ch] fasst der Envelopedatenberechner 112 zudem in Spektralrichtung einige Subbänder zusammen, um die Frequenzauflösung zu verringern. Auf diese Weise gibt der Envelopedatenberechner 112 pro Envelope 906a, 906b eine spektraleinhüllendene Energieabtastung mit einer Frequenzauflösung aus, die von bs_freq_res[ch] abhängt. Diese Werte werden dann mit einer Quantisierung durch den Codierer 114 codiert, die wiederum von bs_amp_res abhängt.

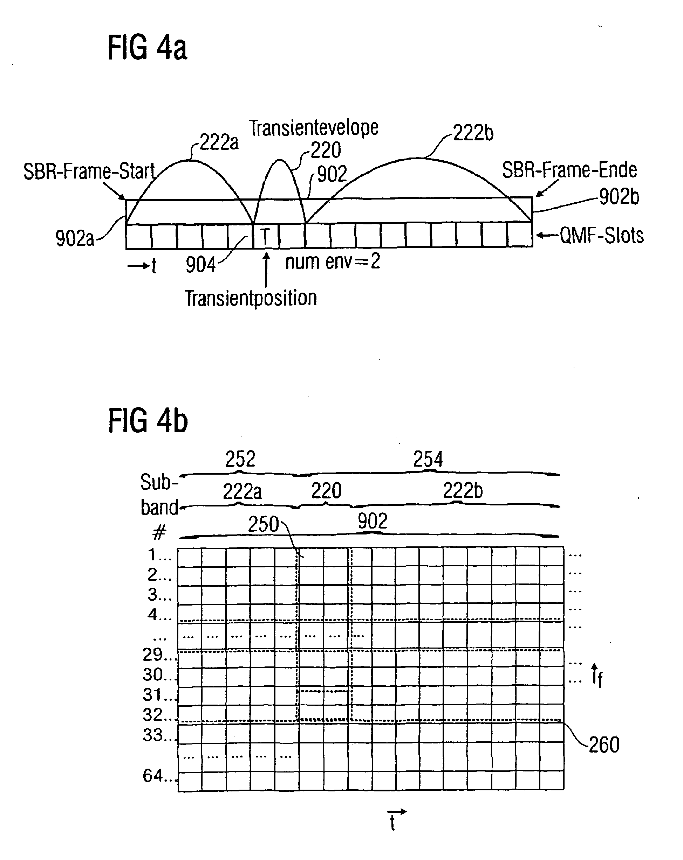

Soweit betraf die vorhergehende Beschreibung den Fall, dass die SBR-Framesteuerung 116 ein bestimmtes Frame der FIXFIX-Klasse zuordnete, was, wie im Vorhergehenden beschrieben, dann der Fall ist, wenn sich kein Transienten in diesem Frame befindet. Die folgende Beschreibung bezieht sich jedoch auf die andere Klasse, nämlich die LDN-TRAN-Klasse, die einem Frame zugeordnet wird, wenn sich in ihm ein Transient befindet, wie es durch den Detektor 118 angezeigt wird. Zeigt also das Syntaxelement bs_frame_class an, dass es sich bei diesem Frame um ein LDN-TRAN-Frame handelt (214), so bestimmt und überträgt die SBR-Frame-Steuerung 116 mit vier Bits ein Syntaxelement bs_transient_position, um in Einheiten der Zeitschlitze 904 beispielsweise relativ zu dem Framestart 902a oder alternativ relativ zu dem Frameende 902b die Position des Transienten anzugeben, wie sie durch den Transientendetektor 118 lokalisiert worden ist (216). Vorliegend sind hierzu vier Bits ausreichend. Ein exemplarischer Fall ist in Fig. 4a dargestellt. Fig. 4a zeigt wiederum das SBR-Frame 902 umfassend die 16 Zeitschlitze 904. In dem sechsten Zeitschlitz 904 von dem SBR-Frame-Start 902a aus befindet sich ein Transient T, was bs_tränsient_position = 5 (der erste Zeitschlitz ist der Zeitschlitz Null) entspräche. Wie es nun bei 218 in Fig. 2 angedeutet ist, ist die nachfolgende Syntax zur Rastereinstellung eines LD_TRAN-Frames von bs_transient_position abhängig, was decoderseitig bei dem durch einen entsprechenden Demultiplexer durchgeführten Parsen berücksichtigt werden muss. An 218 lässt sich aber auch die Funktionsweise des Envelopedatenberechners 112 auf den Erhalt des Syntaxelements bs_transient_position von der SBR-Framesteuerung 116 hin erläutern, die die folgende ist. Der Berechner 112 schlägt mittels der Transientenpositionsangabe bs_transient_position in einer Tabelle nach, für die ein Beispiel in Fig. 3 gezeigt ist. Wie im Folgenden Bezug nehmend auf die Tabelle von Fig. 3 noch näher erörtert wird, stellt der Berechner 112 mittels der Tabelle eine Envelope-Unterteilung innerhalb des SBR-Frames so ein, dass eine kurze Transientenenvelope um die Transientenposition T herum angeordnet ist, während eine oder zwei Envelopes 222a und 222b den restlichen Teil des SBR-Frames 902 einnehmen, nämlich den Teil von der Transienten-Envelope 220 bis zu dem SBR-Framestart 902a bzw. den Teil von der Transientenenvelope 220 bis zu dem SBR-Frame-Ende 902b.

Die in Fig. 3 gezeigte und von dem Berechner 112 verwendete Tabelle umfasst nun fünf Spalten. In der ersten Spalte sind die möglichen Transientenpositionen eingetragen, die sich in dem vorliegenden Beispiel von Null bis 15 erstrecken. In der zweiten Spalte sind die Anzahl an Envelopes bzw. Rasterbereiche 220, 222a bzw. 222b angezeigt, die sich bei der jeweiligen Transientenposition ergeben. Wie es zu erkennen ist, liegen die möglichen Anzahlen bei 2 oder 3, je nachdem, ob die Transientenposition nahe dem SBR-Frame-Start oder dem SBR-Frame-Ende 902a, 902b liegt, in welchem Fall lediglich zwei Envelopes vorhanden sind. In der dritten Spalte wird die Position der ersten Envelopegrenze innerhalb des Frames angegeben, d. h. die Grenze der ersten beiden benachbarten Envelopes in Einheiten der Zeitschlitze 904, und zwar genau genommen die Position des Beginns der zweiten Envelope, wobei die Position = Null den ersten Zeitschlitz in dem SBR-Frame angibt. In der vierten Spalte ist in entsprechender Weise die Position der zweiten Envelopegrenze angegeben, d. h. die Grenze zwischen der zweiten und der dritten Envelope, wobei natürlich diese Angabe nur für die Transientenpositionen definiert ist, für die drei Envelopes vorgesehen sind. Andernfalls sind in dieser Spalte die eingetragenen Werte unbeachtlich, was in Fig. 3 mit "-" angezeigt ist. Wie es in der Tabelle von Fig. 3 exemplarisch zu sehen ist, existiert beispielsweise lediglich die Transientenenvelope 220 und die nachfolgende Envelope 222b für den Fall, dass die Transientenposition T in einem der ersten beiden Zeitschlitze 904 von dem SBR-Frame-Start 902a aus liegt. Erst dann, wenn die Transienteriposition in dem dritten Zeitschlitz von dem SBR-Frame-Start 902a aus liegt, existieren drei Envelopes 222a, 220, 222b, wobei die Envelope 222a die ersten beiden Zeitschlitze umfasst, die Transientenenvelope 220 den dritten und vierten Zeitschlitz umfasst, und die Envelope 222b die restlichen Zeitschlitze, d. h. die von dem fünften an, umfasst. In der letzten Spalte in der Tabelle von Fig. 3 wird für jede Transientenpositionsmöglichkeit angegeben, die wievielte der zwei bzw. drei Envelopes derjenigen entspricht, in der sich der Transient bzw. die Transientenposition befindet, wobei diese Information offenbar redundant ist und somit nicht unbedingt tabellarisch festgehalten werden muss. Die Informationen in der letzten Spalte dient jedoch dazu, um auf eine Weise, wie sie im Folgenden noch näher beschrieben wird, die Grenze zwischen zwei Rausch- bzw. Noise-Envelopes festzulegen, innerhalb welcher durch den Berechner 112 ein Wert bestimmt wird, der angibt, wie hoch der rauschartige Anteil innerhalb dieser Rausch-Envelopes ist. Die Art und Weise, wie die Grenze zwischen diesen Rausch-Envelopes bzw. Rasterbereichen durch den Berechner 112 bestimmt wird, ist decoderseitig bekannt, und wird decoderseitig auf die gleiche Art und Weise vorgenommen, ebenso wie die Tabelle von Fig. 3 auch decoderseitig vorliegt, nämlich zum Parsen und zur Rastereinteilung.

Zurückkehren zu Fig. 2 kann also der Berechner 112 die Anzahl an Envelopes bzw. Rasterbereichen in den LD_TRAN-Frames aus der Tabelle 2 von Fig. 3 bestimmen, wobei die SBR-Framesteuerung (116) für jede dieser zwei oder drei Envelopes die Frequenzauflösung durch ein entsprechendes 1-Bit-Syntaxelement bs_freq_res[ch] pro Envelope angibt (220). Die die Frequenzauflösung einstellenden Syntaxwerte bs_freq_res[ch] überträgt die Steuerung 116 ebenfalls an den Formatierer 108 (220).

Der Berechner 112 berechnet also für alle LD_TRAN-Frames Spektraleinhüllendenenergiewerte als zeitliche Mittelwerte über die Dauer der einzelnen Envelopes 222a, 220, 222b hinweg, wobei er dabei in der Frequenzauflösung abhängig von bs_freq_res der jeweiligen Envelope verschieden viele Subbänder zusammenfasst.

Die vorhergehende Beschreibung ging vornehmlich auf die Funktionsweise des Codierers im Hinblick auf die Berechnung der Signalenergien zur Darstellung der Spektraleinhüllenden in dem Zeit/Frequenz-Raster ein, wie sie durch die SBR-Framesteuerung festgelegt wird. Zusätzlich überträgt der Codierer von Fig. 1 aber auch für jeden Rasterbereich eines Rausch-Rasters einen Rauschwerte, der für diesen zeitlichen Rausch-Rasterbereich angibt, wie hoch der rauschartige Anteil in dem Hochfrequenzanteil des Audiosignals ist. Mit Hilfe dieser Rauschwerte kann decoderseitig noch eine bessere Reproduktion des Hochfrequenzanteils aus dem decodierten Niederfrequenzanteil durchgeführt werden, wie es im Folgenden noch beschrieben wird. Wie es aus Fig. 2 hervorgeht beträgt die Anzahl bs_num_noise der Rausch-Envelopes für LD_TRAN-Frames stets Zwei, wohingegen die Anzahl für FIXFIX-Frames mit bs_num_env gleich 1 auch Eins betragen kann.

Die Aufteilung der LD_TRAN-SBR-Frames in die zwei Rausch-Envelopes aber auch der FIXFIX-Frames in die ein oder zwei Noise-Envelopes kann dabei beispielsweise auf die gleiche Art und Weise durchgeführt werden, wie sie in dem vor erwähnten Standard in Kap. 4.6.18.3.3 beschrieben wird, worauf diesbezüglich verwiesen wird, und welche Passage in dieser Hinsicht auch in die Beschreibung der vorliegenden Anmeldung unter Bezugnahme aufgenommen wird. Insbesondere wird beispielsweise durch den Envelope-Datenberechner 112 für LD_TRAN-Frames die Grenze zwischen den beiden Rausch-Envelopes auf die gleiche Grenze gelegt wie, wenn die Envelope 220a existiert, die Envelopegrenze zwischen der Envelope 220a und der Transienten-Envelope 220, und, falls die Envelope 222 nicht existiert, die Envelopegrenze zwischen der Transienten-Envelope 220 und der Envelope 222b.

Bevor im Folgenden mit der Beschreibung eines Decodierers fortgefahren wird, der in der Lage ist, das codierte Audiosignal am Ausgang 104 des Codierers 100 von Fig. 1 zu decodieren, wird im Folgenden Bezug nehmend auf Fig. 4b noch näher auf das Zusammenspiel zwischen der Analysefilterbank 110 und dem Envelopedatenberechner 112 eingegangen. In Fig. 4b sind die einzelnen Subbandwerte, die durch die Analysefilterbank 110 ausgegeben werden exemplarisch durch Kästchen 250 dargestellt. In Fig. 4b wird davon ausgegangen, dass die Zeitachse t wiederum waagrecht von links nach rechts verläuft. Eine Spalte von Kästchen in senkrechter
Richtung entspricht somit den Subbandwerten, wie sie durch die Analysefilterbank 110 zu einem bestimmten Zeitschlitz erhalten werden, wobei durch eine Achse f angedeutet werden soll, dass die Frequenz nach oben hin zunehmen soll. In Fig. 4b sind exemplarisch 16 aufeinander folgende Zeitschlitze gezeigt, die zu einem SBR-Frame 902 gehören. In Fig. 4b wird davon ausgegangen, dass es sich vorliegend um ein LD_TRAN-Frame handelt, und die Transientenposition die gleiche ist, wie sie in Fig. 4 exemplarisch angezeigt worden ist. Die sich ergebende Rastereinteilung innerhalb des Frames 902 bzw. die sich ergebenden Envelopes sind in Fig. 4b ebenfalls veranschaulicht. Ebenfalls sind in der Fig. 4b die Rausch-Envelopes angegeben, nämlich durch 252 und 254. Mit Hilfe der Quadratsummenbildung ermittelt nun der Envelopedatenberechner 112 mittlere Signalenergien in dem zeitlichen und spektralen Raster, wie es in Fig. 4b durch die gestrichelten Linien 260 angezeigt ist. Bei dem Ausführungsbeispiel von Fig. 4b ermittelt der Envelopedatenberechner 112 somit für die Envelope 222a und die Envelope 222b lediglich halb so viele Spektralenergiewerte zur Darstellung der Spektraleinhüllenden wie für die Transientenenvelope 220. Wie es aber ebenfalls zu erkennen ist, werden die Spektralenergiewerte für die Darstellung der Spektraleinhüllenden nur über die Subbandwerte 250 gebildet, die sich in den höher frequenten Subbändern 1 bis 32 befinden, wohingegen die niederfrequenteren Subbänder 33 bis 64 ignoriert werden, da der niederfrequente Anteil ja durch den Audioencoder 106 codiert wird. Dabei wird lediglich vorsichtshalber darauf hingewiesen, dass die Anzahl der Subbänder hier natürlich lediglich exemplarisch Natur ist, ebenso wie die Bündelung der Subbänder innerhalb der einzelnen Envelopes zu vierer bzw. zweier Gruppen, wie es in Fig. 4b angedeutet ist. Um bei dem Beispiel von Fig. 4b zu bleiben, werden durch den Envelopedatenberechner 112 in dem Beispiel von Fig. 4b insgesamt 32 Spektralenergiewerte zur Darstellung der Spektraleinhüllenden berechnet, deren Quantisierungsgenauigkeit zur Codierung wiederum abhängig von bs_amp_res vorgenommen wird, wie es im Vorhergehenden beschrieben worden ist. Ferner bestimmt der Envelopedatenberechner 112 jeweils einen Rauschwert für die Rausch-Envelope 252 bzw. 254 auf der Basis der Subbandwerte der Subbänder 1 bis 32 innerhalb der entsprechenden Envelope 252 bzw. 254.

Nachdem im Vorhergehenden der Encoder beschreiben worden ist, wird im Folgenden ein Decodierer gemäß einem Ausführungsbeispiel der vorliegenden Erfindung beschrieben, der dazu geeignet ist, das codierte Audiosignal am Ausgang 103 zu decodieren, wobei hierbei auch auf die Vorteile eingegangen wird, die die beschriebene LD_TRAN-Klasse in Bezug auf Bitrate und Verzögerung mit sich bringt.

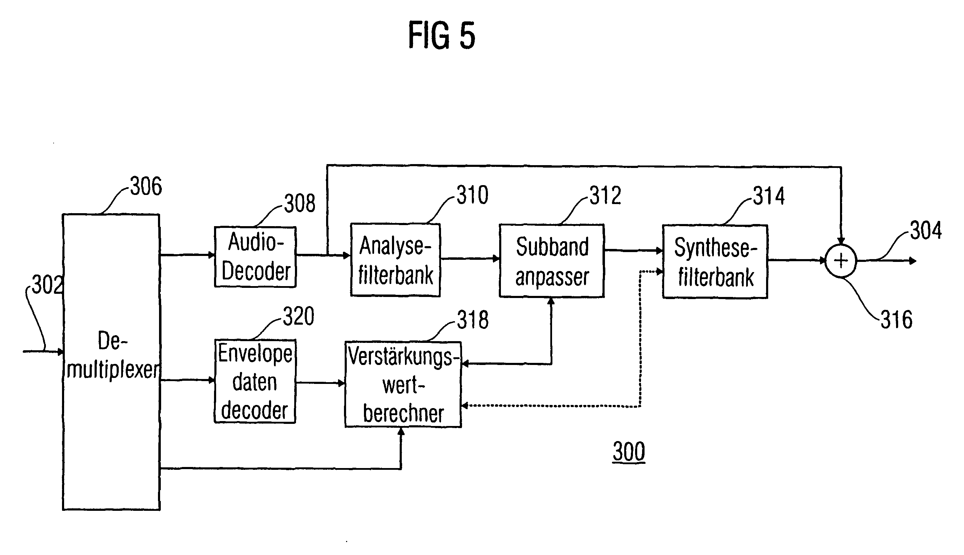

Der Decodierer von Fig. 5, der allgemein mit 300 angezeigt ist, umfasst einen Dateneingang 302 zum Empfangen des codierten Audiosignals sowie einen Ausgang 304 zur Ausgabe eines decodierten Audiosignals. An den Eingang 302 schließt sich der Eingang eines Demultiplexers 306 an, der drei Ausgänge besitzt. Zwischen einen ersten dieser Ausgänge und den Ausgang 304 ist ein Audiodecodierer 308, eine Analysefilterbank 310, ein Subband-Anpasser 312, eine Synthesefilterbank 314 sowie ein Addierer 316 in der genannten Reihenfolge geschaltet. Der Ausgang des Audiodecodierers 308 ist ferner mit einem weiteren Eingang des Addierers 316 verbunden. Wie es im Folgenden noch beschrieben werden wird, kann anstelle des Addierers 316 mit dessen zusätzlichem Eingang auch eine Verbindung des Ausgangs der Analysefilterbank 310 mit einem weiteren Eingang der Synthesefilterbank 314 vorgesehen sein. Der Ausgang der Analysefilterbank 310 ist jedenfalls ferner mit einem Eingang eines Verstärkungswerteberechners 318 verbunden, dessen Ausgang mit einem weiteren Eingang des Subbandanpassers 312 verbunden ist, und der auch einen zweiten und einen dritten Eingang aufweist, von denen der zweite mit einem weiteren Ausgang des Demultiplexers verbunden ist, und von denen der dritte Eingang über einen Envelopedatendecodierer 320 mit dem dritten Ausgang des Demultiplexers 306 verbunden ist.

Die Funktionsweise des Decodierers 300 ist wie folgt. Der Demultiplexer 306 gliedert das ankommende codierte Audiosignal an dem Eingang 302 mittels Parsens zunächst auf. Und zwar gibt der Demultiplexer 306 das codierte den niederfrequenten Anteil betreffende Audiosignal, wie es von dem Audiocodierer 106 erzeugt worden ist, an den Audiodecodierer 308 aus, der derart ausgebildet ist, dass er in der Lage ist, aus den erhaltenen Informationen eine decodierte Version des niederfrequenten Anteils des Audiosignals zu erhalten und an seinem Ausgang auszugeben. Der Decodierer 300 besitzt somit schon mal Kenntnis über den niederfrequenten Anteil des zu decodierenden Audiosignals. Direkte Informationen über den Hochfrequenzanteil erhält der Decodierer 300 jedoch nicht. Vielmehr dient das Ausgangssignal des Decodierers 308 auch gleichzeitig als vorläufiges Hochfrequenzanteilsignal oder zumindest als Vorlage bzw. Basis für die Reproduktion des Hochfrequenzanteils des Audiosignals im Decodierer 300. Die Komponenten 310, 312, 314, 318 und 320 aus dem Decodierer 300 dienen dazu, diese Vorlage zu verwenden, um daraus den schließlichen Hochfrequenzanteil zu reproduzieren bzw. zu rekonstruieren, wobei dieser so rekonstruierte Hochfrequenzanteil dann durch den Addierer 316 wieder mit dem decodierten Niederfrequenzanteil kombiniert wird, um schließlich das decodierte Audiosignal 304 zu erhalten. Dabei wird lediglich der Vollständigkeit halber darauf hingewiesen, dass das decodierte Niederfrequenzsignal aus dem Decodierer 308 auch weiteren vorbereitenden Bearbeitungen unterzogen werden könnte, bevor dasselbe in das Analysefilterbank 310 eingegeben wird, wobei dies in Fig. 5 jedoch nicht gezeigt ist.

In der Analysefilterbank 310 wird das decodierte Niederfrequenzsignal wiederum einer spektralen Zerlegung mit einer festen Zeitauflösung und einer Frequenzauflösung unterzogen, die derjenigen der Analysefilterbank des Codierers 110 im wesentlichen entspricht. Um bei dem Beispiel von Fig. 4b zu bleiben, würde die Analysefilterbank 310 beispielsweise pro Zeitschlitz 32 Subbandwerte ausgeben, die den 32 niederfrequenten Subbändern entsprechen (33-64 in Fig. 4b). Es ist möglich, dass die Subbandwerte, wie sie von der Analysefilterbank 310 ausgegeben werden, schon bereits am Ausgang dieser Filterbank bzw. vor dem Eingang des Subbandanpassers 312 uminterpretiert werden als die Subbandwerte des Hochfrequenzanteils, d. h. quasi in den Hochfrequenzanteil kopiert werden. Ferner ist es jedoch möglich, dass in dem Subbandanpasser 312 den von der Analysefilterbank 310 erhaltenen Niederfrequenzsubbandwerte Hochfrequenzsubbandwerte zunächst hinzugefügt werden, indem alle oder ein Teil der Niederfrequenzsubbandwerte in den höher frequenten Anteil kopiert werden, wie z. B. die Subbandwerte der Subbänder 33 bis 64, wie sie von der Analysefilterbank 310 erhalten werden, in die Subbänder 1 bis 32.

Um nun die Anpassung an die Spektraleinhüllende vorzunehmen, wie sie encoderseitig in das codierte Audiosignal 104 codiert worden ist, leitet zunächst der Demultiplexer 306 denjenigen Teil des codierten Audiosignals 302, der die Codierung der Darstellung der Spektraleinhüllenden betrifft, wie sie durch den Codierer 114 auf Encoderseite erzeugt worden ist, an den Envelopedatendecodierer 320 weiter, der wiederum die decodierte Darstellung dieser Spektraleinhüllenden an den Verstärkungswerteberechner 318 weitergibt. Ferner gibt der Demultiplexer 306 denjenigen Teil des codierten Audiosignals, der die Syntaxelemente zur Rastereinteilung betrifft, wie sie von der SBR-Framesteuerung 116 in das codierte Audiosignal eingebracht worden sind, an den Verstärkungswerteberechner 318 weiter. Der Verstärkungswerteberechner 318 ordnet nun ebenso synchronisiert wie die SBR-Framesteuerung 116 auf Encoderseite die Syntaxelemente aus Fig. 2 den Frames des Audiodecodierers 308 zu. Für das in Fig. 4b betrachtete exemplarische Frame erhält beispielsweise der Verstärkungswerteberechner 318 zu jedem Zeit/Frequenz-Bereich des gestrichelten Rasters 260 von dem Envelopedatendecodierer 320 einen Energiewert, die zusammen die Spektraleinhüllende darstellen.

In dem gleichen Raster 260 berechnet der Verstärkungswerteberechner 318 auch die Energie in dem vorläufig reproduzierten Hochfrequenzanteil, um den reproduzierten Hochfrequenzanteil in diesem Raster normieren und mit den entsprechenden Energiewerten gewichten zu können, die er von dem Envelopedatendecodierer 320 erhalten hat, wodurch der vorläufig reproduzierte Hochfrequenzanteil spektral an die Spektraleinhüllende des ursprünglichen Audiosignals angepasst wird. Dabei berücksichtigt der Verstärkungswerteberechner die ebenfalls von dem Envelopedatendecodierer 320 pro Rausch-Envelope erhaltenen Rauschwerte, um die Gewichtüngswerte für die einzelnen Subbandwerte innerhalb dieser Rausch-Frame zu korrigieren. Am Ausgang des Subbandanpassers 312 werden somit Subbänder mit Subbandwerten weitergeleitet, die mit korrigierten Gewichtswerten an die Spektraleinhüllende des ursprünglichen Signals im Hochfrequenzanteil angepasst sind. Die Synthese Filterbank 314 setzt unter Zuhilfenahme dieser Spektralwerte dann wieder den so reproduzierten Hochfrequenzanteil in der Zeitdomäne zusammen_{,} woraufhin der Addierer 316 diesen Hochfrequenzanteil mit dem Niederfrequenzanteil aus dem Audiodecodierer 308 zu dem schließlichen decodierten Audiosignal am den Ausgang 304 kombiniert. Wie es mit der gestrichelten Linie in Fig. 5 angedeutet ist, ist es alternativ möglich, das die Synthesefilterbank 314 zur Synthese nicht nur die Hochfrequenzsubbänder verwendet, wie sie durch den Subbandanpasser 312 angepasst wurden, sondern ferner die Niederfrequenzsubbänder, wie sie der Ausgabe der Analyse Filterbank 310 unmittelbar entsprechen. Auf diese Weise entspräche das Ergebnis der Synthesefilterbank 314 unmittelbar dem decodierten Ausgangssignal, dass dann an dem Ausgang 304 ausgegeben werden könnte.

Den obigen Ausführungsbeispielen war gemeinsam, dass die SBR-Frames einen Überlappungsbereich aufwiesen. Anders ausgedrückt wurde die Zeiteinteilung der Envelopes an die Zeiteinteilung der Frames angepasst, so dass keine Envelope mit zwei benachbarten Frames überlappt, wozu eine entsprechende Signalisierung des Envelope-Zeitrasters vorgenommen wurde, nämlich mittels LD_TRAN- und FIXFIX-Klassen. Probleme entstehen nun aber, wenn Transienten an den Rändern der Blöcke bzw. Frames auftreten. In diesem Fall werden unverhältnismäßig viele Envelopes benötigt, um die Spektraldaten umfassend die Spektralenergiewerte bzw. Spektraleinhüllendenwerte und die Frequenzauflösungswerte zu codieren. Anders ausgedrückt werden mehr Bits verbraucht als dies nach Lage der Transienten notwendig wäre. Prinzipiell lassen sich zwei solche "ungünstigen" Fälle unterscheiden, die in den Fig. 6a und 6b veranschaulicht sind.

Die erste ungünstige Situation tritt auf, wenn der Transient, der durch den Transientendetektor 118 festgestellt wird, fast an einem Frame-Anfang eines Frames 404 liegt, wie es in Fig. 6a veranschaulicht ist. Fig. 6a zeigt einen exemplarischen Fall, bei dem ein Frame 406 der FIXFIX-Klasse mit einer einzigen sich über alle 16 QMF-Slots erstreckenden Envelope 408 dem Frame 404 vorangeht, an dessen Beginn ein Transient durch den Transientendetektor 118 detektiert worden ist, weshalb das Frame 404 durch die SBR-Framesteuerung 116 einer LD_TRAN-Klasse zugeordnet worden ist mit einer Transientenposition, die auf den dritten QMF-Slott des Frames 404 zeigt, so dass das Frame 404 in drei Envelopes 410, 412 und 414 aufgegliedert ist, unter welchen die Envelope 412 die Transientenenvelope darstellt und die anderen Envelopes 410 und 414 dieselbe umgebenden und sich bis zu den Framegrenzen 416b und 416c des jeweiligen Frames 404 erstrecken. Lediglich zur Vermeidung von Verwirrungen wird darauf hingewiesen, dass für die Fig. 6a davon ausgegangen wurde, dass eine andere Tabelle als in Fig. 3 verwendet wurde.

Wie es nun mit dem Pfeil 418 angezeigt ist, der auf die erste Envelope 410 in dem LD_TRAN-Frame 404 zeigt, ist die eigene Übertragung von spektralen Energiewerten bzw. Frequenzauflösungswert sowie Rauschwert für den entsprechenden Zeitbereich, d. h. QMF-Slott 0 und 1, eigentlich nicht gerechtfertigt, da der Bereich ja keinem Transienten entspricht aber umgekehrt zeitlich sehr klein ist. Diese "teuere" Envelope ist in Fig. 6a deshalb schraffiert hervorgehoben.

Ein ähnliches Problem tritt auf, wenn ein Transient zwischen zwei Frames vorliegt bzw. durch den Transientendetektor 118 erkannt wird. Dieser Fall ist in Fig. 6b dargestellt. Fig. 6b zeigt zwei aufeinander folgende Frames 502 und 504, die jeweils 16 QMF-Slotts lang ist, wobei von dem Transientendetektor 118 zwischen den beiden Frames 502 und 504 bzw. in der Nähe der Frame-Grenze zwischen diesen beiden SBR-Frame 502 und 504 ein Transient erfasst worden ist, so dass durch die SBR-Framesteuerung 116 beide Frames 502 und 504 einer LD TRAN-Klasse zugeordnet worden sind, beide mit lediglich zwei Envelopes 502a, 502b bzw. 504a und 504b, derart, dass die Transientenenvelopes 502b des vorderen Frames 502 und die Transientenenvelope 504b des nachfolgenden Frames 504 an der SBR-Frame-Grenze angrenzen. Wie es zu erkennen ist, ist die TRansienterienvelope 502b des ersten Frames 502 äußerst kurz und erstreckt sich lediglich über einen QMF-Slott. Selbst für die Anwesenheit eines Transienten bedeutet dies einen unverhältnismäßig großen Aufwand zur Einhüllendencodierung, da ja auch für die nachfolgende Transientenenvelope 504b erneut Spektraldaten codiert werden, wie es im Vorhergehenden beschrieben ist. In Fig. 6b sind deshalb die beiden Transientenenvelopes 502b und 504b schraffiert hervorgehoben.

Beide oben Bezug nehmend auf die Fig. 6a und 6b skizzierten Fälle haben also gemeinsam, dass jeweils Envelopes (schraffierte Fläche) benötigt werden, die einen relativ kleinen Zeitraum beschreiben und dementsprechend zu viele bzw. relativ viele Bits kosten. Diese Envelopes enthalten einen spektralen Datensatz, der genauso eines komplettes Frame beschreiben könnte. Die genaue Zeiteinteilung ist aber nötig, um die Energie um die Transienten herum zu kapseln, da ansonsten Vorechos entstehen, wie es ja in der Beschreibungseinleitung der vorliegenden Anmeldung beschrieben worden ist.

Im Folgenden wird deshalb eine alternative Funktionsweise von Codierer bzw. Decodierer beschrieben, mittels welcher obige Problematiken bei Fig. 6a und 6b adressiert werden bzw. Datensätze, die einen zu kleinen Zeitraum beschreiben, encoderseitig nicht übertragen werden müssen.

Betrachtet man beispielsweise den Fall aus Fig. 6a, nach welchem der Transientendetektor 118 die Anwesenheit eines transienten in der Nähe des Beginns des Frames 404 anzeigt, so ordnet nach dem nun beschriebenen Ausführungsbeispiel die SBR-Framesteuerung 116 diesem Frame zwar immer noch die LD_TRAN-Klasse mit der gleichen Transientenpositionsangabe zu, allerdings werden durch den Envelopedatenberechner 112 und den Envelopedatenencoder 114 für die Envelope 410 keine Skalenfaktoren bzw. Spektralenergiewerte und kein Rauschanteil erzeugt bzw. von der SBR-Framesteuerung 116 für diese Envelope 410 keine Frequenzauflösungsangabe an den Formatierer 108 weitergegeben, was in Fig. 7a, die der Situation aus Fig. 6a entspricht, dadurch angedeutet ist, dass die Linie der Envelope 410 gestrichelt angedeutet ist, und die entsprechenden QMF-Slotts schraffiert sind, um anzuzeigen, dass hierfür in dem von dem Formatierer 108 in dem Ausgang 104 ausgegeben Datenstrom eigentlich keine Daten zur Hochfrequenzrekonstruktion enthalten sind. Decoderseitig wird dieses "Datenloch" 418 dadurch gefüllt, dass alle benötigten Daten, wie Skalenfaktoren, Rauschanteil und Frequenzauflösung, aus den entsprechenden Daten der vorangegangenen Envelope 408 gewonnen werden. Genauer ausgedrückt und wie es später Bezug nehmend auf Fig. 9 noch detaillierter erörtert werden wird, schließt der Envelopedatendecoder 320 aus der Transientenpositionsangabe für das Frame 404, dass ein Fall gemäß Fig. 6a vorliegt, so dass es für die erste Envelope in dem Frame 404 keine Envelopedaten erwartet. Um diese alternative Funktionsweise zu versinnbildlichen, ist in Fig. 5 mit einem gestrichelten Pfeil angedeutet, dass der Envelopedatendecoder 320 in seiner Funktionsweise bzw. syntaktischen Analyse auch von den fett geschriebenen Syntaxelementen in Fig. 2 abhängt, hier insbesondere von dem Syntaxelement bs_transient_position. Das Datenloch 418 füllt nun der Envelopedatendecoder 320 dadurch, dass er die entsprechenden Daten aus der vorhergehenden Envelope 408 für die Envelope 410 kopiert. Damit wird der Datensatz der Envelope 408 aus dem vorhergehenden Frame 406 quasi auf die ersten (schraffierten) QMF-Slotts des zweiten Frames 404 ausgeweitet. Damit wird das Zeitraster der fehlenden Envelope 410 im Decoder 300 wieder rekonstruiert und die entsprechenden Datensätze werden kopiert. Das Zeitraster aus Fig. 7a entspricht somit wieder demjenigen aus Fig. 6a im Hinblick auf das Frame 404.

Die Vorgehensweise nach Fig. 7a bietet einen weiteren Vorteil gegenüber der Vorgehensweise, wie sie im Vorhergehenden Bezug nehmend auf Fig. 3 beschrieben worden ist, da es auf diese Weise möglich ist, den Transientenanfang stets auf dem QMF-Slott genau zu signalisieren. Die Transienten, die durch den Transientendetektor 118 erfasst werden, können hierdurch schärfer abgebildet werden. Um dies näher zu veranschaulichen, zeigt Fig. 8 den Fall, dass gemäß Fig. 3 einem FIXFIX-Frame 602 mit einer Envelope 604 ein LD_TRAN-Frame 606 mit zwei Envelopes, nämlich einer Transientenenvelope 608 und einer abschließenden Envelope 610, folgt, wobei die Transientenpositionsangabe auf den zweiten QMF-Slott zeigt. Wie es aus Fig. 8 zu erkennen ist, beginnt die TRansientenenvelope 608, mit dem ersten QMF-Slot des Frames 606 ebenso, wie es in dem Fall einer Transientenpositionsangabe der Fall gewesen wäre, die auf den ersten QMF-Slot zeigt, wie es aus Fig. 3 erkennbar ist. Der Grund für diese Vorgehensweise besteht darin, dass aus Gründen der Codiereffizienz es weniger lohnenswert ist, bei der Verschiebung der Transientenpositionsangabe von TRANS-POS = 0 auf TRANS-POS = 1 eine dritte Envelope am Beginn des Frames 606 vorzusehen, da hierfür eigens wieder Envelopedaten übertragen werden müssten. Nach der Vorgehensweise von Fig. 7a stellt dies kein Problem dar, da ja für die Anfangsenvelope 410 sowieso gar keine Envelopedaten übertragen werden müssen. Aus diesem Grund ist eine QMF-Slot-genaue Ausrichtung der Transientenenvelope abhängig von der Transientenpositionsangabe in LD_TRAN-Klassen nach der Vorgehensweise von Fig. 7a in effektiver Weise möglich, wozu ein mögliches Ausführungsbeispiel in der Tabelle von Fig. 9 dargestellt ist. Die Tabelle von Fig. 9 stellt eine mögliche Tabelle dar, wie sie bei dem Codierer von Fig. 1 und dem Decodierer von Fig. 5 alternativ zur Tabelle von Fig. 3 im Rahmen der alternativen Vorgehensweise von Fig. 7a verwendet werden kann. Die Tabelle umfasst sieben Spalten, von denen die Rubriken der ersten Fünf den ersten fünf Spalten in Fig. 3 entsprechen, d. h. von der ersten bis zur fünften Spalte die Transientenpositionsangabe sowie für diese Transientenpositionsangabe die Anzahl der vorgesehenen Envelopes in dem Frame, die Lage der ersten Envelopegrenze, die Lage der zweiten Envelopegrenze und der Transientenindex, der auf die Envelope zeigt, in der sich der Transient befindet, aufgelistet sind. Die sechste Spalte zeigt an, für welche Transientenpositionsangabe ein Datenloch 418 gemäß Fig. 7a vorgesehen wird. Wie es durch eine Eins angezeigt ist, ist dies für Transientenpositionsangaben der Fall, die zwischen Eins und Fünf (jeweils einschließlich) liegen. Für die restlichen Transientenpositionsangaben ist in dieser Spalte eine Null eingetragen. Auf die letzte Spalte wird im Folgenden Bezug nehmend auf Fig. 7b eingegeben.

Betrachtet man den Fall von Fig. 6b, so wird gemäß einer alternativ oder zusätzlich zur Modifikation gemäß Fig. 7a vorgesehenen Vorgehensweise eine ungünstige Teilung des Transientenbereiches in die Transientenenvelopes 502b und 50.4b dadurch verhindert, dass virtuell eine sich über die QMF-Slotts beider Transientenenvelopes 502b und 504b erstreckende Envelope 502 verwendet wird, die über diese Envelope 402 hinweg erhaltenen Skalenfaktoren zusammen mit dem Rauschanteil und der Frequenzauflösung aber nur für die Transientenenvelope 502b des Frames 502 übertragen und decodierseitig einfach auch für die QMF-Slotts am Beginn des Nachfolgeframes verwendet werden, wie es in Fig. 7b, die der Fig. 6b ansonsten entspricht, durch die Einfachschraffur der Envelope 502b, die Andeutung der Transientenenvelope 504b durch eine gestrichelte Linie und die Schraffur der QMF-Slotts am Beginn des zweiten Frames 504 angedeutet ist.

Genauer ausgedrückt agiert der Codierer 100 in dem Fall des Auftretens eines Transienten zwischen den Frames 502 und 504 gemäß Fig. 7b auf die folgende Art und Weise. Der Transientendetektor 118 zeigt das Auftreten des Transienten an. Daraufhin wählt die SBR-Framesteuerung 116 für das Frame 502 wie in dem Fall von Fig. 6b die LD_TRAN-Klasse mit einer Transientenpositionsangabe aus, die auf den letzten QMF-Slot zeigt. Aufgrund der Tatsache, dass die Transientenpositionsangabe an das Ende des Frames 502 zeigt, bildet jedoch der Envelopedatenberechner 112 aus den QMF-Ausgangswerten die Skalenfaktoren bzw. Spektralenergiewerte jedoch nicht nur über den QMF-Slot der Transientenenvelope 502b hinweg sondern vielmehr über alle QMF-Slots der virtuellen Envelope 702, die zusätzlich die drei unmittelbar nachfolgenden QMF-Slots des nachfolgenden Frames 504 umfasst. Ein Delay ist dadurch an dem Ausgang 104 des Codierers 100 nicht verbunden, da ja der Audioencoder 106 das Frame 504 ja ohnehin erst an dem Frameende an den Formatierer 108 weitergeben kann. In anderen Worten ausgedrückt, bildet der Envelopedatenberechner 112 die Skalenfaktoren durch Mittelung über die QMF-Werte der QMF-Slotts der virtuellen Envelope 702 in einer vorbestimmten Frequenzauflösung, wobei die sich so ergebenden Skalenfaktoren von dem Envelopedatenencoder 114 für die Transientenenvelope 502b des ersten Frames 502 codiert und an den Formatierer 108 ausgegeben werden, wobei die SBR-Framesteuerung 116 den entsprechenden Frequenzauflösungswert für diese Transientenenvelope 502b weitergibt. Unabhängig von der Entscheidung bezüglich der Klasse des Frames 502 trifft die SBR-Framesteuerung 116 die Entscheidung über die Klassenzugehörigkeit des Frames 504. In dem vorliegenden Fall befindet sich exemplarisch kein Transient mehr in der Nähe des Frames 504 oder in dem Frame 504, so dass die SBR-Framesteuerung 116 in diesem exemplarischen Fall von Fig. 7b eine FIXFIX-Klasse für das Frame 504 mit nur einer Envelope 504a' auswählt. Die entsprechende Entscheidung gibt die SBR-Framesteuerung 116 an den Formatierer 108 sowie an den Envelopedatenberechner 112 aus. Die Entscheidung wird jedoch anders interpretiert als üblich. Der Envelopedatenberechner 112 hat sich nämlich "gemerkt", dass sich die virtuelle Envelope 702 in das aktuelle Frame 504 hineinerstreckt hat, und verkürzt deshalb die sich unmittelbar anschließende Envelope 504a' des Frames 504 um die entsprechende Anzahl an QMF-Slots, um die entsprechenden Skalenwerte nur über diese geringere Anzahl an QMF-Slots hinweg zu ermitteln und an den Envelopedatenencoder 114 auszugeben. Über die ersten drei QMF-Slotts entsteht somit ein Datenloch 704 in dem Datenstrom am Ausgang 104. In anderen Worten ausgedrückt, wird gemäß der Vorgehensweise von Fig. 7b encoderseitig zunächst der komplette Datensatz für die Envelope 702 berechnet, wozu auch Daten aus den aus Sicht des Frames 502 zukünftigen QMF-Slotts am Beginn des Frames 504 herangezogen werden, wodurch die spektrale Einhüllende an der virtuellen Envelope errechnet wird. Dieser Datensatz wird dann zu dem Decoder übermittelt, als zu der Envelope 502b gehörig.

Beim Decodierer erzeugt der Envelopedatendecoder 320 aus seinen Eingangsdaten die Skalenfaktoren für die virtuelle Envelope 702, wodurch der Verstärkungswerteberechner 318 für den letzten QMF-Slot des Frames 502 bzw. die letzte Envelope 502b alle notwendigen Informationen hat, um die Rekonstruktion noch in diesem Frame vorzunehmen. Der Envelopedatendecoder 320 erhält auch Skalenfaktoren für die Envelope bzw. die Envelopes des Folgeframes 504 und gibt sie an den Verstärkungswerteberechner 318 weiter. Dieser allerdings weis aus der Tatsache, dass die Transienten Positionseingabe des vorhergehenden LD_TRAN-Frames auf den Schluss dieses Frames 502 zeigt, dass die für die abschließende Transientenenvelope 502b dieses Frames 502 übertragenen Envelopedaten auch die QMF-Slots am Beginn des Frames 504 betreffen, die zu der virtuellen Envelope 702 gehören, weshalb er für diese QMF-Slots eine eigene Envelope 504b' einfügt bzw. einrichtet, und für diese eingerichtete Envelope 504b' von Skalenfaktoren, Rauschanteil und Frequenzauflösung ausgeht, die der Envelopedatenberechner 112 aus den entsprechenden Envelopedaten der Vorgängerenvelope 502b gewinnt, um für diese Envelope 504b' die spektralen Gewichtungswerte für die Rekonstruktion in dem Modul 312 zu berechnen. Die von dem Envelopedatendecoder 320 erhaltenen Envelopedaten für die eigentliche Folgeenvelope 504a' wendet der Verstärkungswerteberechner 318 dann erst für die nachfolgenden QMF-Slotts an, die auf die virtuelle Envelope 702 hin folgen, und leitet entsprechend berechnete Verstärkungs- bzw. Gewichtungswerte an den Subbandanpasser 312 zur Hochfrequenzrekonstruktion weiter. In anderen Worten ausgedrückt wird decoderseitig zunächst der Datensatz für die virtuellen Envelope 702 nur auf den letzten QMF- bzw. die letzten QMF-Slotts des aktuellen Frames 502 angewendet und der aktuelle Frame 502 somit ohne Verzögerung rekonstruiert. Der Datensatz des zweiten, folgenden Frames 504 beinhaltet ein Datenloch 704, d. h. die neuen übertragenen Envelopedaten sind erst ab dem folgenden, in dem exemplarischen Beispiel von Fig. 7b dritten QMF-Slot gültig. Es wird somit in dem Fall von Fig. 7b nur eine einzelne Envelope übermittelt. Die fehlende Envelope 504b' wird wieder, wie im ersten Fall, rekonstruiert und mit den Daten der vorangegangenen Envelope 502b gefüllt. Das Datenloch 704 ist somit geschlossen und der Frame 504 kann ausgespielt werden.

In dem exemplarischen Fall von Fig. 7b ist der zweite Frame 504 mit einer FIXFIX-Klasse signalisiert worden, bei der eigentlich die Envelope(s) den kompletten Frame überspannen. Wie es jedoch soeben beschrieben wurde, wird aufgrund des vorangegangenen Frames 502 bzw. dessen LD_TRAN-Klassenzugehörigkeit mit hoher transienten Positionsangabe, die Envelope 504a' im Decoder eingeschränkt und die Gültigkeit des Datensatzes beginnt zeitlich erst einige QMF-Slotts später. Dabei adressierte Fig. 7b den Fall, dass die Transientenrate dünn ist. Treten in mehreren aufeinander folgenden Frames Transienten jedoch jeweils an den Rändern auf, wird die Transientenposition jeweils mit der LDN-TRAN-Klasse übermittelt und im folgenden Frame entsprechend expandiert, wie es im Vorhergehenden Bezug nehmend auf Fig. 7b beschrieben worden ist. Die jeweils erste Envelope wird entsprechend der Expansion verkleinert bzw. an ihrem Anfang eingeschränkt, wie es im Vorhergehenden Bezug nehmend auf die Envelope 504a' Bezug nehmend auf eine FIXFIX-Klasse exemplarisch beschrieben worden ist.

Wie es im Vorhergehenden beschrieben worden ist, ist unter Encoder und Decoder bekannt, wieweit eine Transientenenvelope an dem Ende eines LD_TRAN-Frames in das Nachfolgeframe expandiert wird, wobei eine mögliche Vereinbarung hierfür ebenfalls in dem Ausführungsbeispiel von Fig. 9 bzw. in der dort dargestellten Tabelle gezeigt ist, die somit ein Beispiel darstellt, das beide modifizierten Vorgehensweisen nach Fig. 7a und 7b verbindet. Tabelle 9 wird bei diesem Ausführungsbeispiel von Encoder und Decoder verwendet. Zur Signalisierung des Zeitrasters der Envelopes wird wiederum nur der Transientenindex bs_transient_position verwendet. Bei Transientenpositionen am Beginn des Frames wird eine Übertragung einer Envelope verhindert (Fig. 7a), wie es im Vorhergehenden beschrieben wurde und aus der vorletzten Spalte der Tabelle von Fig. 9 hervorgeht. In der letzten Spalte von Fig. 9 ist dabei ferner festgehalten, mit welchem Expansionsfaktor bzw. über wie viel QMF-Slotts hinweg eine Transientenenvelope am Ende des Frames in das Nachfolgeframe expandiert werden soll (vgl. Fig. 7b). Ein Unterschied bei der Signalisierung nach Fig. 9 bezüglich des ersten Falles (Fig. 7a) und dem zweiten Fall (Fig. 7b) besteht in dem Zeitpunkt der Signalisierung. Bei Fall 1 findet die Signalisierung im aktuellen Frame statt, d. h. es besteht keine Abhängigkeit zum vorangegangenen Frame. Entscheidend ist lediglich die Transientenposition. Für welche Fälle die erste Envelope eines Frames nicht übertragen wird, kann dementsprechend decoderseitig aus einer Tabelle wie in Fig. 9 mit Einträgen für alle Transientenpositionen entnommen werden.

Im zweiten Fall wird die Entscheidung jedoch im vorangegangenen Frame getroffen und in den nächsten übertragen. Anhand der letzten Tabellenspalte in Fig. 9 wird nämlich ein Expansionsfaktor festgelegt, bei welcher Transientenposition des Vorgängerframes die Transientenenvelope des Vorgängerframes wie weit in den nächsten Frame hineinexpandiert werden soll. Das bedeutet, dass, wenn in einem Frame eine Transientenposition am Ende des aktuellen Frames festgestellt wird - gemäß Fig. 9 an dem letzten oder vorletzten QMF-Slot-, der in der letzten Spalte von Fig. 9 stehende Expansionsfaktor für den nächsten Frame gespeichert wird, wodurch das Zeitraster für den nächsten Frame dadurch feststeht bzw. festgelegt ist.

Bevor im Folgenden auf ein nächstes Ausführungsbeispiel der vorliegenden Erfindung eingegangen wird, soll im Vorhergehenden noch erwähnt werden, dass ähnlich zu der Vorgehensweise zur Erzeugung der Envelopedaten für die virtuelle Envelope nach Fig. 7b die Erzeugung der Envelopedaten für die Envelope 408 in dem Beispiel von Fig. 7a ebenfalls über einen erweiterten Zeitraum hinweg, nämlich um die beiden QMF-Slotts der "eingesparten" Envelope 410, ermittelt werden könnten, so dass die QMF-Ausgangswerte der Analysefilterbank 110 für diese QMF-Slotts auch in die entsprechenden Envelopedaten der Envelope 408 eingehen. Die alternative Vorgehensweise ist jedoch ebenfalls möglich, nach welcher die Envelopedaten für die Envelope 408 lediglich über die zu ihr gehörenden QMF-Slotts ermittelt werden.

Die vorhergehenden Ausführungsbeispiele vermieden eine hohe Verzögerung unter Verwendung einer LD_TRAN-Klasse. Im Folgenden wird ein Ausführungsbeispiel beschrieben, nach welchem die Vermeidung mittels einer Raster- bzw. Envelopeeinteilung erzielt wird, bei welcher sich Envelopes auch über Framegrenzen hinweg erstrecken können. Insbesondere wird im Folgenden davon ausgegangen, dass der Encoder von Fig. 1 einen Datenstrom an seinem Ausgang 104 erzeugt, bei dem die Frames in vier Frame-Klassen eingeteilt sind, nämlich eine FIXFIX-, eine FIXVAR-, eine VARFIX- und VARVAR-Klasse, wie es in dem vorhergehenden erwähnten MPEG4-SBR-Standard festgelegt ist.

Wie in der Beschreibungseinleitung der vorliegenden Anmeldung beschrieben teilt also die SBR-Framesteuerung 116 die Abfolge von Frames in Envelopes ein, die sich auch über Framegrenzen erstrecken können. Dabei sind Syntaxelemente bs_num_rel_# vorgesehen, die für die Frameklassen FIXVAR, VARFIX und VARVAR unter Anderem festlegen, an welcher Position relativ zu der vorderen oder hinteren Framegrenze des Frames die erste Envelope beginnt bzw. die letzte Envelope dieses Frames endet. Der Envelopedatenberechner 112 berechnet die Spektralwerte bzw. Skalenfaktoren für das durch die Envelopes festgelegte Raster mit der durch die SBR-Framesteuerung 116 festgelegten Frequenzauflösung. Mittels dieser Klassen lassen sich folglich für die SBR-Framesteuerung 116 Envelopegrenzen beliebig über die Frames und einen Überlappungsbereich verteilen. Der Codierer nach Fig. 1 kann die Signalisierung mit den vier verschiedenen Klassen so durchführen, dass ein maximaler Überlappungsbereich von einem Frame entsteht, was der Verzögerung des CORE-Coders 106 entspricht und somit auch der Zeitspanne, die gepuffert werden kann, ohne eine zusätzliche Verzögerung zu verursachen. Damit ist sichergestellt, dass immer genügend "zukünftige" Werte für den Envelopedatenberechner 112 zur Verfügung stehen, um Envelopedaten vorab zu berechnen und zu senden, obwohl diese zum Großteil erst in späteren Frames Gültigkeit besitzen.

Gemäß dem vorliegenden Ausführungsbeispiel verarbeitet nun aber der Decodierer von Fig. 5 einen solchen Datenstrom mit den vier SBR-Klassen auf eine Art und Weise, die zu einer geringen Latenz bei gleichzeitiger Kompaktierung der Spektraldaten führt. Das wird durch Datenlöcher im Bitstrom erreicht. Dazu wird zunächst auf Fig. 10 Bezug genommen, die zwei Frames inklusive ihrer Einteilung zeigt, wie sie sich durch den Codierer von Fig. 1 nach dem Ausführungsbeispiel ergibt, wobei in diesem Fall exemplarisch das erste Frame ein FIXVAR-Frame und das zweite Frame ein VARFIX-Frame ist. In dem exemplarischen Fall von Fig. 10 umfassen die beiden aufeinander folgenden Frames 802 und 804 zwei bzw. eine Envelope, nämlich die Envelopes 802a und 802b bzw. die Envelopes 804a, wobei sich die zweite Envelope des FIXVAR-Frames 802 um drei QMF-Slots in das Frame 804 erstreckt und der Beginn der Envelope 804a des VARFIX-Frames 804 erst bei dem QMF-Slot 3 liegt. Zu jeder Envelope 802a, 802b und 804a enthält der Datenstrom an dem Ausgang 104 Skälenfaktorwerte, die der Envelopedatenberechner 112 durch Mittelung des QMF-Ausgangssignals der Analysefilterbank 110 über die entsprechenden QMF-Slotts hinweg ermittelt hat. Zur Ermittlung der Envelopedaten für die Envelope 802b greift der Berechner 112 wie im Vorhergehenden erwähnt auf "zukünftige" Daten der Analysefilterbank 110 zurück, wozu ein virtueller Überlappungsbereich der Größe eines Frames zur Verfügung steht, wie es in Fig. 10 schraffiert angedeutet ist.

Um den Hochfrequenzanteil für die Envelope 802b zu rekonstruieren, müsste der Decodierer den Erhalt des rekonstruierten Niederfrequenzanteils von der Analysefilterband 310 abwarten, was wie bereits im Vorhergehenden erwähnt zu einer Verzögerung der Größe eines Frames führen würde. Diese Verzögerung kann verhindert werden, wenn der Decodierer nach Fig. 5 auf folgende Weise arbeitet. Der Envelopedatendecoder 320 gibt die Envelopedaten und insbesondere die Skalenfaktoren für die Envelopes 802a, 802b und 804a an den Verstärkungswerteberechner 318 aus. Dieser allerdings verwendet die Envelopedaten für die sich in das nachfolgende Frame 804 erstreckende Envelope 802b allerdings zunächst einmal nur für einen ersten Teil der QMF-Slotts, über den sich diese Envelope 802b erstreckt, nämlich über denjenigen Teil, der bis zu der SBR-Framegrenze zwischen den beiden Frames 802 und 804 geht. Der Verstärkungswerteberechner 318 interpretiert folglich die Envelopeeinteilung relativ zu der Einteilung, wie sie der Codierer von Fig. 1 bei der Codierung vorsah, um und verwendet die Envelopedaten zunächst nur für denjenigen Teil der Überlapp-Envelope 802b, der sich in dem aktuellen Frame 802 befindet. Dieser Teil ist in der Fig. 11, die der Situation von Fig. 10 entspricht, als Envelope 802b₁ veranschaulicht. Auf diese Weise sind Verstärkungswerteberechner 318 und Subbandanpasser 312 in der Lage, den Hochfrequenzanteil für diese Envelope 802b₁ ohne Verzögerung zu rekonstruieren.

Durch diese Uminterpretierung fehlen dem Datenstrom an dem Eingang 302 natürlich Envelopedaten für den restlichen Teil der Überlapp-Envelope 802b. Dieses Problem überwindet der Verstärkungswerteberechner 318 auf eine ähnliche Art und Weise wie bei dem Ausführungsbeispiel von Fig. 7b, d. h. er verwendet Envelopedaten, die aus denen für die Envelope 802b₁ hergeleitet sind, um basierend auf denselben zusammen mit dem Subbandanpasser 312 den Hochfrequenzanteil an der Envelope 802b₂ zu rekonstruieren, die sich über die ersten QMF-Slotts des zweiten Frames 804 erstreckt, die dem restlichen Teil der Überlapp-Envelope 802b entsprechen. Das Datenloch 806 wird auf diese Weise gefüllt.

Im Anschluss an die vorhergehenden Ausführungsbeispiele, bei denen das Transientenproblem Bitraten-effektiv auf verschiedene Arten adressiert wurde, soll im Folgenden ein Ausführungsbeispiel beschrieben werden, wonach eine modifizierte FIXFIX-Klasse als Beispiel einer Klasse mit Frame- und Rastergrenzenübereinstimmung in ihrer Syntax derart gestaltet wird, dass sie ein Flag bzw. eine Transientenabwesenheitsanzeige aufweist, wodurch es möglich ist, unter Bitrateneinbußen die Framegröße zu reduzieren, aber dabei auch die Einbußen in ihrem Ausmaß zu reduzieren, da stationäre Teile des Informations- bzw. Audiosignals Bitrateneffektiver codiert werden können. Dabei ist dieses Ausführungsbeispiel sowohl zusätzlich jeweils bei den in vorhergehenden beschriebenen Ausführungsbeispielen einsetzbar als auch unabhängig von den anderen Ausführungsbeispielen in dem Zusammenhang mit einer Frame-Klasseneinteilung mit FIXFIX-, FIXVAR-, VARFIX- und VARVAR-Klassen, wie es in der Beschreibungseinleitung der vorliegenden Anmeldung beschrieben wurde, aber eben unter Modifikation der FIXFIX-Klasse, wie es im Folgenden beschrieben wird. Und zwar wird gemäß diesem Ausführungsbeispiel die Syntaxbeschreibung einer FIXFIX-Klasse, wie sie im Vorhergehenden auch Bezug nehmend auf Fig. 2 beschrieben worden ist, um ein weiteres Syntax-Element ergänzt, wie z.B. ein Ein-Bit-Flag, wobei das Flag codiererseitig durch die SBR-Framesteuerung 116 abhängig von der Lage der durch den Transientendetektor 118 erfassten Transienten gesetzt wird, um anzuzeigen, dass das Informationssignal in der Gegend des entsprechenden FIXFIX-Frames stationär ist oder nicht. In dem ersteren Fall, wie z.B. bei gesetztem Transientenabwesenheitsflag, wird in dem codierten Datenstrom 104 für die Envelope des entsprechenden FIXFIX-Frames oder die zeitlich erste Envelope in diesen FIXFIX-Frame in dem Fall, dass dasselbe mehrere Envelopes aufweist, keine Envelopedatensignalisierung bzw. keine Übertragung von Rauschenergiewerten und Skalenfaktoren sowie Frequenzauflösungswerten vorgenommen, sondern diese fehlenden Informationen werden decoderseitig aus den entsprechenden Envelopedaten für die zeitlich unmittelbar vorausgehende Envelope des vorhergehenden Frames, das z.B. ebenfalls ein FIXFIX-Frame oder aber ein anderes Frame sein kann, gewonnen, die in dem codierten Informationssignal enthalten sind. Auf diese Weise lässt sich also eine Bitratenreduktion für eine Variante der SBR-Codierung mit niedriger Verzögerung erzielen, bzw. eine Kombination der Bitratenerhöhung in einer solchen Low-Delay-Variante aufgrund der erhöhten bzw. der verdoppelten Wiederholungsrate. In Kombination mit den im vorhergehenden beschriebenen Ausführungsbeispielen liefert eine solche Signalisierung eine Komplettierung in Bezug auf die Bitratenreduktion, da nicht nur transiente Signale, sondern auch stationäre Signale Bitraten-reduziert übertragbar bzw. codierbar sind. In Bezug auf die Gewinnung bzw. Herleitung der fehlenden Envelopedateninformation wird auf die Beschreibung in Bezug auf die vorhergehenden Ausführungsbeispiele insbesondere in Bezug auf die Fig. 12 und 7b verwiesen.

Im Hinblick auf die Ausführungen zu den Fig. 6a bis 11 soll noch auf Folgendes hingewiesen werden. Bei diesen Figuren sind teilweise unterschiedliche Tabellen zugrunde gelegt worden zu derjenigen von Fig. 3. Solche Unterschiede können natürlich auch die Definition der Rausch-Envelopes betreffen. Die Rausch-Envelopes können sich bei LD_TRAN-Klassen beispielsweise immer über das vollständige Frame erstrecken. In dem Fall von Fig. 7a und 7b würden dann beispielsweise für die ersten dort exemplarisch 2 bzw. 3 QMF-Slotts sie Rausch-Werte des vorhergehenden Frames bzw. der vorhergehenden Envelope durch den Decodierer zur Hochfrequenzrekonstruktion herangezogen werden und die eigentliche Rauschenvelope entsprechend verkürzt werden.

Ferner wird bezüglich der Vorgehensweise nach Fig. 7b und 11 darauf hingewiesen, dass zahlreiche Möglichkeiten bestehen, wie die Envelopedaten bzw. die Skalenfaktoren für die virtuelle Envelope 702 bzw. 802b übertragen werden. Wie es beschrieben worden ist, werden Skalenfaktoren für die virtuelle Envelope über die in Fig. 7b exemplarisch vier und in Fig. 11 exemplarisch sechs QMF-Slotts ermittelt, nämlich durch Mittelung wie es im Vorhergehenden beschrieben wurde. In dem Datenstrom können nun diese über die entsprechenden QMF-Slots ermittelten Skalenfaktoren für die Transientenenvelope 502b bzw. die Envelope 502b₁ übertragen werden. In diesem Fall würde gegebenenfalls dekoderseitig der Berechner 318 berücksichtigen, dass die Skalenfaktoren bzw. spektralen Energiewerte allerdings über den vollständigen Bereich zu vier bzw. sechs QMF-Slotts ermittelt worden sind, und würde deshalb den Betrag dieser Werte zu einem Verhältnis, das beispielsweise dem Verhältnis zwischen den zu dem ersten Frame 502 bzw. 802 und den dem zweiten Frame 504 bzw. 804 gehörigen QMF-Slotts entspricht, auf die beiden Teilenvelopes 502b bzw. 504b' bzw. 802b₁ und 802-b₂ aufteilen, um die derart aufgeteilten Anteile der übertragenen Skalenfaktoren für die Steuerung der spektralen Formung in dem Subbandanpasser 312 heranzuziehen. Allerdings wäre es ebenfalls möglich, dass der Codierer gleich solche Skalenfaktoren überträgt, die decoderseitig für die erste Teilenvelope 502b bzw. 802b₁ zunächst unmittelbar angewendet werden können, und die für die nachfolgende Teilenvelope 504b' bzw. 804b' bzw. 802b₂ entsprechend umskaliert werden je nach Überlapp der virtuellen Envelope 702 bzw. 802b mit dem zweiten Frame 504 bzw. 804. Wie die Aufteilung der Energie auf die beiden Teilenvelopes vorgenommen wird, kann dabei beliebig zwischen Encoder und Decoder festgelegt sein. In anderen Worten ausgedrückt, kann der Codierer gleich solche Skalenfaktoren übertragen, die decoderseitig für die erste Teilenvelope 502b bzw. 502b₁ unmittelbar angewendet werden können, weil die Skalenfaktoren lediglich über diese Teilenvelopes bzw. die entsprechenden QMF-Slotes gemittelt worden sind. Dieser Fall kann exemplarisch auf folgende Weise veranschaulicht werden. Im Falle einer quasi überlappenden Envelope, wobei der erste Teil aus zwei Zeiteinheiten bzw. QMF-Slotes besteht, und der zweite aus drei Zeiteinheiten, wird codiererseitig nur der erste Teil korrekt berechnet bzw. die Mittelung der Energiewerte nur in diesem Teil vorgenommen und die entsprechenden Skalenfaktoren ausgegeben. Auf diese Weise passen die Envelopedaten genau zu dem entsprechenden Zeitabschnitt in dem ersten Teil. Die Skalenfaktoren für den zweiten Teil werden allerdings aus dem ersten Teil gewonnen und entsprechend dem Größenverhältnis im Vergleich zu dem ersten Teil skaliert, also in diesem Fall 3/2 mal Skalenfaktoren des ersten Teils. Bei dieser Gelegenheit soll darauf hingewiesen werden, dass im Vorhergehenden der Begriff Energie synonym mit Skalenfaktor verwendet worden ist, wobei sich Energie bzw. Skalenfaktor aus der Summe aller Energiewerte eines SBR-Bandes entlang einer Zeitspanne einer Envelope ergibt. In dem soeben dargestellten Beispiel beschreiben die Hilfsskalenfaktoren jeweils die Summe der Energien der zwei Zeiteinheiten in dem ersten Teil der quasi überlappenden Envelope für das jeweilige SBR-Band.

Ferner kann es aber natürlich auch vorgesehen sein, dass die Spektraleinhüllenden- bzw. Skalenwerte in den obigen Ausführungsbeispielen stets in einer auf die zur Ermittlung des jeweiligen Werts herangezogene Anzahl von QMF-Slots normierten Weise übertragen werden, wie z.B. als die quadratischen durchschnittliche, d.h. auf die Anzahl von beitragendes QMF-Slots und die Anzahl von QMF-Spektralbändern normierte, Energie innerhalb jeder Frequenz/Zeit-Rasterbereiches. In diesem Fall sind die soeben beschrieben Maßnahmen zur encoder- oder dekoderseitigen Aufteilung der Skalenfaktoren für die virtuellen Envelopes auf die jeweiligen Teileabschnitte nicht notwendig.

Bezug nehmend auf die vorhergehende Beschreibung wird zudem noch auf verschiedenes hingewiesen. Obwohl beispielsweise in Fig. 1 beschrieben worden ist, dass mittels der Analysefilterbank 110 eine spektrale Zerlegung mit einer festen Zeitauflösung durchgeführt wird, die dann durch den Envelopedatenberechner 112 an das durch die Steuerung 116 eingestellte Zeit/Frequenz-Raster angepasst wird, sind alternative Vorgehensweisen ebenfalls denkbar, nach welchen in Zeit/Frequenz-Auflösung an die Vorgabe durch die Steuerung 316 angepasst die Spektraleinhüllende in dieser Auflösung unmittelbar berechnet wird, ohne die Zweistufigkeit, wie sie Fig. 1 zeigt. Der Envelopedatencodierer 114 aus Fig. 1 kann fehlen. Andererseits könnte die Art der Codierung der die Spektraleinhüllenden darstellenden Signalenergien beispielsweise mittels Differenzcodierung durchgeführt werden, wobei die Differenzcodierung in Zeit- oder Frequenzrichtung ausgeführt sein kann oder gemischt, wie z. B. frame- oder envelopeweise in Zeit- und/oder Frequenzrichtung. Bezug nehmend auf Fig. 5 wird darauf hingewiesen, dass es beispielsweise unbeachtlich ist, in welcher Reihenfolge der Verstärkungswerteberechner die Normierung mit der in dem vorläufig reproduzierten Hochfrequenzanteil enthaltenen Signalenergien vornimmt und die Gewichtung mit den von dem Encoder übertragenen Signalenergien zur Signalisierung der Spektraleinhüllenden. Ähnliches gilt natürlich für die Korrektur zur Berücksichtigung der Rauschanteilswerte pro Rausch-Envelope. Ferner wird darauf hingewiesen, dass die vorliegende Erfindung nicht auf spektrale Zerlegungen mittels Filterbänken eingeschränkt ist. Vielmehr könnten natürlich auch eine Fourier-Transformation bzw. inverse Fourier-Transformation oder ähnliche Zeit/Frequenz-Transformationen verwendet werden, bei denen beispielsweise das jeweilige Transformationsfenster um die Anzahl an Audiowerten verschoben wird, die einem Zeitschlitz entsprechen soll. Ferner wird darauf hingewiesen, dass es vorgesehen sein kann, dass der Codierer die Spektraleinhüllende nicht bezüglich aller Subbänder in dem Hochfrequenzanteil in dem Zeit/Frequenz-Raster bestimmt, codiert und in das codierte Audiosignal einbringt. Vielmehr könnte der Codierer auch solche Anteile des Hochfrequenzanteils bestimmen, für die es sich nicht lohnt, decoderseitig eine Reproduktion durchzuführen. In diesem Fall übermittelt der Codierer den Decodierer beispielsweise die Abschnitte des Hochfrequenzanteils bzw. die Subbandbereiche in dem Hochfrequenzanteil, für die die Reproduktion durchgeführt werden soll. Ferner sind verschiedene Modifikationen auch in Bezug auf die Einstellung des Rasters in Frequenzrichtung möglich. Beispielsweise könnte es vorgesehen sein, dass keine Einstellung des Frequenzrasters vorgenommen wird, in welchem Fall die Syntaxelemente bs_freq_res fehlen könnten und beispielsweise stets die volle Auflösung verwendet würde. Ferner könnte eine Einstellbarkeit der Quantisierungsschrittweite der Signalenergien zur Darstellung der Spektraleinhüllenden weggelassen werden, d. h. das Syntax-element bs_amp_res könnte fehlen. Zudem könnte statt einer Abwärtsabtastung um jeden zweiten Audiowert in dem Down sampler von Fig. 1 auch eine andere Abwärtsabtastung vorgenommen werden, so dass hoch- und niederfrequenter Anteil spektral unterschiedliche Ausdehnung besäßen. Ferner ist die tabellenunterstützte Abhängigkeit der Rastereinteilung der LD_TRAN-Frames von bs_transient_position nur exemplarisch und eine analytische Abhängigkeit der Envelopausdehnungen und der Frequenzauflösung wäre ebenfalls denkbar.

Jedenfalls ermöglichen es die oben beschriebenen Beispiele für Codierer und Decodierer die SBR-Technologie auch für das AAC-LD-Codierschema des oben zitierten Standards zu verwenden. Die hohe Verzögerung von AAC + SBR, das dem Ziel von AAC-LD mit einem kurzen algorithmischen Delay von etwa 20ms bei 48 kHz und einer Blocklänge von 480 widerspricht, kann mit obigen Ausführungsbeispielen überwunden werden. Dabei wäre auch der Nachteil einer Verknüpfung von AAC-LD mit dem bisherigen in dem Standard definierten SBR, der in der kürzeren Framelänge des AAC-LD 480 oder 512 gegenüber 960 oder 1024 bei AAC-LC begründet liegt, die die Datenrate für ein unverändertes SBR-Element, wie in dem Standard definiert, doppelt so hoch gegenüber HE AAC werden lässt, überwunden. Obige Ausführungsbeispiele ermöglichen folglich die Verringerung des Delay von AAC-LD + SBR und eine gleichzeitige Verringerung der Datenrate für die Seiteninformationen.

Insbesondere wurde bei den obigen Ausführungsbeispielen zur Verringerung des Systems die Delays für eine LD-Variante des SBR-Moduls der Überlappungsbereich der SBR-Frames entfernt. Damit entfällt die Möglichkeit Envelopegrenzen bzw. Rastergrenzen unabhängig von der SBR-Framegrenze platzieren zu können. Die Behandlung von Transienten wird dann allerdings durch die neue Frame-Klasse LD_TRAN übernommen, so dass die obigen Ausführungsbeispiele auch lediglich noch ein Bit zur Signalisierung benötigen, um anzuzeigen, ob es sich bei dem augenblicklichen SBR-Frame um das einer FIXFIX-Klasse oder einer LD_TRAN-Klasse handelt.

Dabei wurde bei den obigen Ausführungsbeispielen die LD_TRAN-Klasse derart definiert, dass sie stets zum SBR-Frame synchronisiert Envelope-Grenzen an den Rändern und variable Grenzen in dem Innern des Frames besitzt. Die innere Verteilung wurde durch die Position der Transienten in im QMF-Slot-Raster bzw. Zeitschlitzraster bestimmt. Um die Position des Transienten herum wurde eine schmale Envelope verteilt, die die Energie des Transienten abkapselt. Die restlichen Bereiche wurden bis zu den Rändern mit Envelopes nach vorne und nach hinten aufgefüllt. Dazu wurde von dem Envelopedatenberechner 312 encoderseitig und durch den Verstärkungswerteberechner 318 decoderseitig die Tabelle aus Fig. 3 verwendet, wo entsprechend der Transientenposition ein vordefiniertes Enveloperaster gespeichert ist, wobei die Tabelle aus Fig. 3 natürlich nur exemplarischer natur ist, und im Einzelfall natürlich auch vom Anwendungsfall abhängig variiert werden kann.

Insbesondere ermöglicht somit die LD_TRAN-Klasse der obigen Aüsführungsbeispiele eine kompakte Signalisierung und eine Anpassung des Bitbedarfs an eine LD-Umgebung mit doppelter Framerate, die somit auch eine doppelte Datenrate für die Grid- bzw. Rasterinformation erfordert. Somit beseitigen oblige Ausführungsbeispiele Nachteile der bisherigen SBR-Envelope-Signalisierung nach dem Standard, die darin bestanden, dass für VARVAR-, VARFIX- und FIXVAR-Klassen der Bitbedarf zur Übertragung der Syntaxelemente bzw. Seiteninformationen hoch war, und für die FIXFIX-Klasse eine genaue zeitliche Anpassung der Envelopes an Transienten innerhalb des Blocks nicht möglich war. Demgegenüber ermöglichen es die obigen Ausführungsbeispiele eine Delayoptimierung Decoderseitig vorzunehmen, und zwar genau genommen eine Delayoptimierung um sechs QMF-Zeitschlitze bzw. 384 Audioabtastwerte im Audiosignaloriginalbereich, was in etwa 8 ms bei 48 kHz Audiosignalabtastung entspricht. Ferner ermöglicht der Wegfall der VARVAR-, VARFIX- und FIXVAR-Frameklassen eine Einsparung der Datenrate für die Übertragung der Spektraleinhüllenden, woraus die Möglichkeit für höhere Datenraten für die Niederfrequenzcodierung bzw. den Core und damit auch eine bessere Audioqualität resultiert. Effektiv schaffen obige Ausführungsbeispiele eine Einhüllung der Transienten innerhalb der zu den SBR-Framegrenzen synchronen LD_TRAN-Klasse-Frames.

Insbesondere wird darauf hingewiesen, dass im Unterschied zu der vorhergehenden exemplarischen Tabelle aus Fig. 3 die Transienten-Envelopelänge auch mehr als nur 2 QMF-Zeitschlitze umfassen kann, wobei jedoch bevorzugter Weise aber die Transienten-Envelopelänge kleiner als 1/3 der Framelänge ist.

Ferner wird Bezug nehmend auf die vorhergehende Beschreibung darauf hingewiesen, dass die vorliegende Erfindung nicht auf Audiosignale eingeschränkt ist. Vielmehr könnten obige Ausführungsbeispiele natürlich auch bei der Videocodierung Verwendung finden.

In Bezug auf die vorhergehenden Ausführungsbeispiele wird ferner darauf hingewiesen, dass die einzelnen Blöcke in den Fig. 1 und 5 beispielsweise sowohl in Hardware als auch in Software implementiert sein können, wie z. B. als Teile einer ASIC oder als Programmroutinen eines Computerprogramms.

Bei dieser Gelegenheit wird ferner darauf hingewiesen, dass, abhängig von den Gegebenheiten das erfindungsgemäße Schema auch in Software implementiert sein kann. Die Implementation kann auf einem digitalen Speichermedium, insbesondere einer Diskette oder einer CD mit elektronisch auslesbare Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt, mit auf einem maschinenlesbaren Träger gespeicherten Programmcode, zur Durchführung des erfindungsgemäßen Verfahrens, wenn das Computerprogrammprodukt auf einem Rechner abläuft. In anderen Worten ausgedrückt, kann die Erfindung somit als ein Computerprogramm mit einem Programmcode zur Durchführung des Verfahrens realisiert werden, wenn das Computerprogramm auf einem Computer abläuft. Ferner sei bezüglich der im Vorhergehenden erörterten Ausführungsbeispiele darauf hingewiesen, dass die dort generierten codierten Informationssignale beispielsweise auf einem Speichermedium gespeichert sein können, wie z.B. auf einem elektronischen Speichermedium.

## Patentansprüche

1. Codierer mit
einer Einrichtung (104, 106) zum Codieren eines Niederfrequenzanteils eines Audiosignals in Einheiten von Frames (902) des Audiosignals;
einer Einrichtung (118) zum Lokalisieren von Transienten in dem Audiosignal;
einer Einrichtung (116) zum, in Abhängigkeit von der Lokalisation, Zuordnen eines jeweiligen Rekonstruktionsmodus unter zumindest zwei möglichen Rekonstruktionsmodi zu den Frames des Audiosignals, und, für Frames, denen ein erster der zumindest zwei möglichen Rekonstruktionsmodi zugeordnet ist, Zuordnen einer jeweiligen Transientenpositionsangabe zu diesen Frames; und
einer Einrichtung (110, 112, 114) zum Erzeugen einer Darstellung einer Spektraleinhüllenden eines Hochfrequenzanteils des Audiosignals in einem zeitlichen Raster, das von den Frames zugeordneten Rekonstruktionsmodi abhängt, derart, dass für Frames, denen der erste der zumindest zwei möglichen Rekonstruktionsmodi zugeordnet ist, die Framegrenzen (902a, 902b) dieser Frames (902) mit Rastergrenzen des Rasters (222a, 220, 222b) zusammenfallen, und die Rastergrenzen des Rasters im Innern dieser Frames von der Transientenpositionsangabe abhängen; und
einer Einrichtung (108) zum Zusammenfassen des codierten Niederfrequenzanteils, der Darstellung der Spektraleinhüllenden und von Informationen über die zugeordneten Rekonstruktionsmodi und die Transientenpositionsangaben zu einem codierten Audiosignal.

2. Codierer gemäß Anspruch 1, bei dem die Einrichtung zum Erzeugen derart ausgebildet ist, dass die Rastergrenzen im Innern der Frames, denen der erste der zumindest zwei möglichen Rekonstruktionsmodi zugeordnet ist, derart liegen, dass sie zumindest einen ersten Rasterbereich (220) festlegen, dessen Position innerhalb des jeweiligen Frame von der Transientenpositionsangabe abhängt und dessen zeitliche Ausdehnung kleiner als 1 / 3 einer Länge der Frames ist, sowie einen zweiten und/oder dritten Rasterbereich (222a, 222b), der bzw. die den restlichen Teil des jeweiligen Frames von dem ersten Rasterbereich bis zu der zeitlich vorderen bzw. zeitlich hinteren Framegrenze (902a, 902b) des jeweiligen Frames einnimmt bzw. einnehmen.

3. Codierer gemäß Anspruch 2, bei dem die Einrichtung zum Erzeugen und die Einrichtung zum Zusammenfassen ausgebildet sind, um für ein Frame (404), dem der erste Rekonstruktionsmodus zugeordnet ist, der drei Rasterbereichte (410, 412, 414) aufweist, und bei dem der erste Rasterbereiche (412) unter den drei Rasterbereichen näher als ein vorbestimmter Wert an einem vorhergehenden Frame liegt, nur für den ersten und dritten Rasterbereich (412, 414) einen oder mehrere Spektraleinhüllendenwerte, der bzw. die die Spektraleinhüllende mit einer jeweiligen Frequenzauflösung beschreibt bzw. beschreiben, in das codierte Audiosignal einzubringen, und für den zweiten Rasterbereich (410) dieses Frames (404) keinen Spektraleinhüllendenwert in das codierte Audiosignal einzubringen.

4. Codierer gemäß Anspruch 2 oder 3, bei dem die Einrichtung zum Erzeugen und die Einrichten zum Zusammenfassen ausgebildet sind, um für ein Frame (502), dem der erste Rekonstruktionsmodus zugeordnet ist, das nur zwei Rasterbereiche (502a, 502b) aufweist, und bei dem der erste Rasterbereich (502b) an die zeitlich hintere Framegrenze angrenzt, für beide Rasterbereiche einen oder mehrere Spektraleinhüllendenwerte, der bzw. die die Spektraleinhüllende mit einer jeweiligen Frequenzauflösung beschreibt bzw. beschreiben, in das codierte Audiosignal einzubringen, und zur Ermittlung des bzw. der Spektraleinhüllendenwerte für den ersten Rasterbereich (502b) auch Teile des Audiosignals zu verwenden, die sich in einem Erstreckungsrasterbereich (504b') in dem nachfolgenden Frame (504) befindet, der an die hintere Framegrenze angrenzt, und einen zeitlich vordersten Rasterbereich (504a') des nachfolgenden Frames (504), wie er durch den Rekonstruktionsmodus des nachfolgenden Frames festgelegt wird, entsprechend zu verkürzen, um erst an dem Erstreckungsrasterbereich (504b') zu beginnen.

5. Codierer gemäß Anspruch 3 oder 4, bei dem die Einrichtung zum Erzeugen und die Einrichtung zum Zusammenfassen ausgebildet sind, um für ein Frame, dem der zweite Rekonstruktionsmodus zugeordnet ist, oder dem der erste Rekonstruktionsmodus zugeordnet ist, aber für den weder die Bedingung erfüllt ist, dass er drei Rasterbereiche aufweist und dabei der erste Rasterbereich unter den drei Rasterbereichen näher als der vorbestimmte Wert an dem vorhergehenden Frame liegt, noch die Bedingung, dass er nur zwei Rasterbereiche aufweist und dabei der erste Rasterbereich an die zeitlich hintere Framegrenze angrenzt, für jeden Rasterbereich dieses Frames einen oder mehrere Spektraleinhüllendenwerte in das codierte Audiosignal einzubringen.

6. Codierer gemäß Anspruch 2, bei dem die Einrichtung zum Erzeugen derart ausgebildet ist, dass der erste Rasterbereich (220) an die zeitlich vordere Framegrenze (902a) des jeweiligen Frames angrenzt, wenn kein zweiter Rasterbereich (222a) existiert, und der erste Rasterbereich (220) an die zeitliche hintere Framegrenze (902b) des jeweiligen Frames angrenzt, wenn kein dritter Rasterbereich (222b) existiert.

7. Codierer gemäß einem der vorhergehenden Ansprüche, bei dem die Einrichtung zum Erzeugen derart ausgebildet ist, dass die Rastergrenzen im Innern von Frames, denen der zweite der zumindest zwei möglichen Rekonstruktionsmodi zugeordnet ist, zeitlich gleichmäßig verteilt angeordnet sind, so dass diese Frames nur einen Rasterbereich aufweisen oder in gleich große Rasterbereiche (906a, 906b) gegliedert sind.

8. Codierer gemäß einem der vorhergehenden Ansprüche, bei der die Einrichtung zum Zuordnen ausgebildet ist, um jedem Frame, dem die zweite der zumindest zwei möglichen Rekonstruktionsmodi zugeordnet ist, eine Frameunterteilungsanzahlangabe zuzuordnen, wobei die Einrichtung zum Erzeugen derart ausgebildet ist, dass die Rastergrenzen im Innern dieser Frames diese Frames in eine Anzahl von Rasterbereichen unterteilen, die von der jeweiligen Frameunterteilungsanzahlangabe abhängt.

9. Codierer gemäß einem der vorhergehenden Ansprüche, bei dem die Einrichtung zum Erzeugen derart ausgebildet ist, dass unabhängig von den möglichen Rekonstruktionsmodi, die den Frames zugeordnet sind, die Framegrenzen der Frames stets mit Rastergrenzen des Rasters zusammenfallen.

10. Codierer gemäß einem der vorhergehenden Ansprüche, bei dem die Einrichtung zum Erzeugen eine Analysefilterbank (110) aufweist, die pro Filterbankzeitschlitz (904) des Audiosignals einen Satz von Spektralwerten (250) erzeugt, wobei jedes Frame (902) mehrere Filterbankzeitschlitze lang ist, und wobei die Einrichtung (112) zum Erzeugen ferner eine Einrichtung zum Mitteln der Energiespektralwerte in der Auflösung des Rasters aufweist.

11. Codierer gemäß Anspruch 10, bei dem die Transientenpositionsangabe in Einheiten der Filterbankzeitschlitze (904) definiert ist.

12. Decodierer mit
einer Einrichtung (306) zum Extrahieren eines codierten Niederfrequenzanteils eines Audiosignals, einer Darstellung einer Spektraleinhüllenden eines Hochfrequenzanteils des Audiosignals, von Informationen über Rekonstruktionsmodi, die Frames des Audiosignals zugeordnet sind und jeweils einem von zumindest zwei Rekonstruktionsmodi entsprechen, und Transientenpositionsangaben, die jeweils Frames zugeordnet sind, denen ein erster der zumindest zwei Rekonstruktionsmodi zugeordnet sind, aus dem codierten Audiosignal;
einer Einrichtung (308) zum Decodieren des codierten Niederfrequenzanteils des Audiosignals in Einheiten von Frames des Audiosignals;
einer Einrichtung (310) zum Bereitstellen eines vorläufigen Hochfrequenzanteilsignals auf der Basis des dekodierten Niederfrequenzanteils; und
einer Einrichtung (318, 312, 314) zum spektralen Anpassen des vorläufigen Hochfrequenzanteilsignals an die Spektraleinhüllenden durch spektrale Gewichtung des vorläufigen Hochfrequenzanteilsignals in Abhängigkeit von der Darstellung der Spektraleinhüllenden in einem zeitlichen Raster, das von den den Frames zugeordneten Rekonstruktionsmodi abhängt, derart, dass für Frames, denen der erste der zumindest zwei möglichen Rekonstruktionsmodi zugeordnet ist, die Framegrenzen dieser Frames mit Rastergrenzen des Rasters zusammenfallen, und die Rastergrenzen des Rasters im Innern dieser Frames von der Transientenpositionsangabe abhängen.

13. Decodierer gemäß Anspruch 12, bei dem die Einrichtung zum spektralen Anpassen derart ausgebildet ist, dass die Rastergrenze(n) im Innern eines Frames, dem der erste der zumindest zwei möglichen Rekonstruktionsmodi zugeordnet ist, derart liegt/en, dass sie zumindest einen ersten Rasterbereich (220) festlegt/en, dessen Position innerhalb des jeweiligen Frame von der Transientenpositionsangabe abhängt und dessen zeitliche Ausdehnung kleiner als 1 / 3 einer Länge der Frames ist, sowie einen zweiten und/oder dritten Rasterbereich (222a, 222b), der bzw. die den restlichen Teil des jeweiligen Frames von dem ersten Rasterbereich bis zu der zeitlich vorderen bzw. zeitlich hinteren Framegrenze (902a, 902b) des jeweiligen Frames einnimmt bzw. einnehmen.

14. Decodierer gemäß Anspruch 13, bei dem die Einrichtung zum Extrahieren ausgebildet ist, um für ein Frame (404), dem der erste Rekonstruktionsmodus zugeordnet ist, der drei Rasterbereiche (410, 412, 414) aufweist, und bei dem der erste Rasterbereich (412) unter den drei Rasterbereichen mehr als ein vorbestimmter Wert an einem vorhergehenden Frame (406) liegt, nur für den ersten und dritten Rasterbereich (412, 414) einen oder mehrere Spektraleinhüllendenwerte in dem codierten Audiosignal zu erwarten und aus dem codierten Audiosignal zu extrahieren, der bzw. die die Spektraleinhüllende mit einer jeweiligen Frequenzauflösung beschreibt bzw. beschreiben, und für den zweiten Rasterbereich (410) einen oder mehrere Spektraleinhüllendenwerte für die Darstellung der Spektraleinhüllenden aus dem zeitlich letzten Rasterbereich (408) des vorhergehenden Frames (406) zu gewinnen.

15. Decodierer gemäß Anspruch 13 oder 14, bei dem die Einrichtung zum Extrahieren ausgebildet ist, um für ein Frame (502), dem der erste Rekonstruktionsmodus zugeordnet ist, der zwei Rasterbereiche (502a, 502b) aufweist, und bei dem der erste Rasterbereich (502b) an die zeitlich hintere Framegrenze des Frames (502) angrenzt, für beide Rasterbereiche einen oder mehrere Spektraleinhüllendenwerte in dem codierten Audiosignal zu erwarten und aus dem codierten Audiosignal zu extrahieren, der bzw. die die Spektraleinhüllende mit einer jeweiligen Frequenzauflösung beschreibt bzw. beschreiben, und aus dem bzw. den Spektraleinhüllendenwerten für den ersten Rasterbereich (502b) einen bzw. mehrere Spektraleinhüllendenwerte für einen Ergänzungsrasterbereich (504b') in dem nachfolgenden Frame (504) zu gewinnen, der an die hintere Framegrenze angrenzt, und einen zeitlich vordersten Rasterbereich (504a') des nachfolgenden Frames (504), wie er durch den Rekonstruktionsmodus der nachfolgenden Frames festgelegt wird, entsprechend zu verkürzen, um erst an dem Ergänzungsrasterbereich (504b') zu beginnen, wodurch das zeitliche Raster in dem nachfolgenden Frame (504) unterteilt wird, und wobei die Einrichtung zum spektralen Anpassen ausgebildet ist, um die Anpassung in dem unterteilten zeitlichen Raster vorzunehmen.

16. Decodierer gemäß Anspruch 14 oder 15, bei dem die Einrichtung zum Extrahieren ausgebildet ist, um für ein Frame, dem der zweite Rekonstruktionsmodus zugeordnet ist, oder dem der erste Rekonstruktionsmodus zugeordnet ist, aber für den weder die Bedingung erfüllt ist, dass er drei Rasterbereiche aufweist und dabei der erste Rasterbereich unter den drei Rasterbereichen näher als der vorbestimmte Wert an dem vorhergehenden Frame liegt, noch die Bedingung, dass er nur zwei Rasterbereiche aufweist und dabei der erste Rasterbereich an die zeitlich hintere Framegrenze angrenzt, für jeden Rasterbereich dieses Frames einen oder mehrere Spektraleinhüllendenwerte in dem codierten Audiosignal zu erwarten und aus dem codierten Audiosignal zu extrahieren.

17. Decodierer gemäß Anspruch 16, bei dem die Einrichtung zum spektralen Anpassen derart ausgebildet ist, dass der erste Rasterbereich (220) an die zeitlich vordere Framegrenze (902a) des jeweiligen Frames angrenzt, wenn kein zweiter Rasterbereich (222a) existiert, und der erste Rasterbereich (220) an die zeitliche hintere Framegrenze (902b) des jeweiligen Frames angrenzt, wenn kein dritter Rasterbereich (222b) existiert.

18. Decodierer gemäß einem der Ansprüche 12 bis 17, bei dem die Einrichtung zum spektralen Anpassen derart ausgebildet ist, dass die Rastergrenzen im Innern von Frames, denen der zweite der zumindest zwei möglichen Rekonstruktionsmodi zugeordnet ist, zeitlich gleichmäßig verteilt angeordnet sind, so dass diese Frames nur einen Rasterbereich aufweisen oder in gleich große Rasterbereiche (906a, 906b) gegliedert sind.

19. Decodierer gemäß einem der Ansprüche 12 bis 18, bei dem die Einrichtung zum Extrahieren ausgebildet ist, um aus dem codierten Audiosignal auch eine Frameunterteilungsanzahlangabe, die jeweils Frames zugeordnet ist, denen die zweite der möglichen Rekonstruktionsmodi zugeordnet sind, zu extrahieren, wobei die Einrichtung zum spektralen Anpassen derart ausgebildet ist, dass die Rastergrenzen im Innern dieser Frames in eine Anzahl von Rasterbereichen unterteilt sind, die von der jeweiligen Frameunterteilungsanzahlangabe abhängt.

20. Decodierer gemäß einem der Ansprüche 12 bis 19, bei dem die Einrichtung zum spektralen Anpassen derart ausgebildet ist, dass unabhängig von den möglichen Rekonstruktionsmodi, die den Frames zugeordnet sind, die Framegrenzen der Frames stets mit Rastergrenzen des Rasters zusammenfallen.

21. Decodierer gemäß einem der Ansprüche 12 bis 20, bei dem die Einrichtung zum spektralen Anpassen eine Analysefilterbank (310) aufweist, die pro Filterbankzeitschlitz des decodierten Audiosignals einen Satz von Spektralwerten erzeugt, wobei jedes Frame mehrere Filterbankzeitschlitze lang ist, und wobei die Einrichtung zum spektralen Anpassen ferner eine Einrichtung (318) zum Bestimmen der Energie der Spektralwerte in der Auflösung des Rasters aufweist.

22. Decodierer gemäß Anspruch 21, bei dem die Transientenpositionsangabe in Einheiten der Filterbankzeitschlitze definiert ist.

23. Codiertes Audiosignal mit
einem codierten Niederfrequenzanteil eines Audiosignals;
einer Darstellung einer Spektraleinhüllenden eines Hochfrequenzanteils eines Audiosignals; und
Informationen über Rekonstruktionsmodi, die Frames des Audiosignals zugeordnet sind und jeweils einem von zumindest zwei Rekonstruktionsmodi entsprechen, und Transientenpositionsangaben, die jeweils Frames zugeordnet sind, denen ein erster der zumindest zwei Rekonstruktionsmodi zugeordnet ist,
derart, dass aus dem codierten Audiosignal durch folgende Schritte das Audiosignal erhaltbar ist:
Decodieren des codierten Niederfrequenzanteils des Audiosignals in Einheiten von Frames des Audiosignals;
Bereitstellen eines vorläufigen Hochfrequenzanteilsignals auf der Basis des dekodierten Niederfrequenzanteils; und
spektrales Anpassen des vorläufigen Hochfrequenzanteilsignals an die Spektraleinhüllenden durch spektrale Gewichtung des vorläufigen Hochfrequenzanteilsignals in Abhängigkeit von der Darstellung der Spektraleinhüllenden in einem zeitlichen Raster, das von den den Frames zugeordneten Rekonstruktionsmodi abhängt, derart, dass für Frames, denen der erste der zumindest zwei möglichen Rekonstruktionsmodi zugeordnet ist, die Framegrenzen dieser Frames mit Rastergrenzen des Rasters zusammenfallen, und die Rastergrenzen des Rasters im Innern dieser Frames von der Transientenpositionsangabe abhängen.

24. Verfahren zum Kodieren, das folgende Schritte aufweist:
Codieren eines Niederfrequenzanteils eines Audiosignals in Einheiten von Frames (902) des Audiosignals;
Lokalisieren von Transienten in dem audiosignal;
in Abhängigkeit von der Lokalisation, Zuordnen eines jeweiligen Rekonstruktionsmodus unter zumindest zwei möglichen Rekonstruktionsmodi zu den Frames des Audiosignals, und, für Frames, denen ein erster der zumindest zwei möglichen Rekonstruktionsmodi zugeordnet ist, Zuordnen einer jeweiligen Transientenpositionsangabe
zu diesen Frames; und
Erzeugen einer Darstellung einer Spektraleinhüllenden eines Hochfrequenzanteils des Audiosignals in einem zeitlichen Raster, das von den den Frames zugeordneten Rekonstruktionsmodi abhängt, derart, dass Frames, denen der erste der zumindest zwei möglichen Rekonstruktionsmodi zugeordnet ist, die Framegrenzen (902a, 902b) dieser Frames (902) mit Rastergrenzen des Rasters (222a, 220, 222b) zusammenfallen, und die Rastergrenzen des Rasters im Innern dieser Frames von der Transientenpositionsangabe abhängen; und
Zusammenfassen des codierten Niederfrequenzanteils, der Darstellung der Spektraleinhüllenden und von Informationen über die zugeordneten Rekonstruktionsmodi und die Transientenpositionsangaben zu einem codierten Audiosignal.

25. Verfahren zum Dekodieren, das folgende Schritte aufweist:
Extrahieren eines codierten Niederfrequenzanteils eines Audiosignals, einer Darstellung einer Spektraleinhüllenden eines Hochfrequenzanteils des Audiosignals und von Informationen über Rekonstruktionsmodi, die Frames des Audiosignals zugeordnet sind und jeweils einem von zumindest zwei Rekonstruktionsmodi entsprechen, und Transientenpositionsangaben, die jeweils Frames zugeordnet sind, denen ein erster der zumindest zwei Rekonstruktionsmodi zugeordnet sind, aus dem codierten Audiosignal;
Decodieren des codierten Niederfrequenzanteils des Audiosignals in Einheiten von Frames des Audiosignals;
Bereitstellen eines vorläufigen Hochfrequenzanteilsignals auf der Basis des dekodierten Niederfrequenzanteils; und
spektrales Anpassen des vorläufigen Hochfrequenzanteilsignals an die Spektraleinhüllenden durch spektrale Gewichtung des vorläufigen Hochfrequenzanteilsignals in Abhängigkeit von der Darstellung der Spektraleinhüllenden in einem zeitlichen Raster, das von den den Frames zugeordneten Rekonstruktionsmodi abhängt, derart, dass für Frames, denen der erste der zumindest zwei möglichen Rekonstruktionsmodi zugeordnet ist, die Framegrenzen dieser Frames mit Rastergrenzen des Rasters zusammenfallen, und die Rastergrenzen des Rasters im Innern dieser Frames von der Transientenpositionsangabe abhängen.

26. Decodierer mit
einer Einrichtung (306) zum Extrahieren eines codierten Niederfrequenzanteils eines Audiosignals, von Informationen, die ein zeitliches Raster (802a, 802b, 804a) festlegen, derart, dass sich zumindest ein Rasterbereich (802b) über eine Framegrenze von zwei benachbarten Frames (802, 804) des Audiosignals hinweg erstreckt, um mit den zwei benachbarten Frames zu überlappen, und einer Darstellung einer Spektraleinhüllenden eines Hochfrequenzanteils des Audiosignals, aus einem codierten audiosignal;
einer Einrichtung (308) zum Decodieren des codierten Niederfrequenzanteils des Audiosignals in Einheiten der Frames (802, 804) des Audiosignals;
einer Einrichtung (310) zum Bestimmen eines vorläufigen Hochfrequenzanteilsignals auf der Basis des decodierten Niederfrequenzanteils; und
einer Einrichtung (318, 312, 314) zum spektralen Anpassen des vorläufigen Hochfrequenzanteilsignals an die Spektraleinhüllenden durch spektrale Gewichtung des vorläufigen Hochfrequenzanteilsignals mittels Herleitens, aus der Darstellung der Spektraleinhüllenden in dem zeitlichen Raster (802a, 802b, 804a), einer Darstellung der Spektraleinhüllenden in einem unterteilten zeitlichen Raster (802a, 802b₁, 802b₂, 804a), bei dem der sich mit den zwei benachbarten Frames überlappende Rasterbereich (802b) in einen ersten Teilrasterbereich (802b₁) und einen zweiten Teilrasterbereich (802b₂) unterteilt ist, die an der Framegrenze aneinander angrenzen, und Vornehmens der Anpassung des vorläufigen Hochfrequenzanteilsignals an vorläufigen Hochfrequenzanteilsignals an die Spektraleinhüllenden durch spektrale Gewichtung des vorläufigen Hochfrequenzanteilsignals in dem unterteilten zeitlichen Raster.

27. Decodierer gemäß Anspruch 26, bei dem die Einrichtung zum Extrahieren ausgebildet ist, um aus dem codierten Audiosignal Informationen über Rekonstruktionsmodi, die den Frames des Audiosignals zugeordnet sind, als die Informationen, die das zeitliche Raster festlegen, zu extrahieren, wobei die Rekonstruktionsmodi jeweils Rasterbereiche des zeitlichen Rasters festlegen und jeweils einem einer Mehrzahl von möglichen Rekonstruktionsmodi entsprechen, und wobei die Einrichtung zum Extrahieren ausgebildet ist, um für Frames, denen ein vorbestimmter der möglichen Rekonstruktionsmodi zugeordnet ist, auch eine Angabe aus dem codierten Audiosignal zu extrahieren, die angibt, wie eine äußere Rastergrenze eines äußeren Rasterbereiches (802b) des Frames (802), der mit dem Frame (802) überlappt, zeitlich zu einer Framegrenze des Frames ausgerichtet sein soll, und für jeden Rasterbereich (802a,b,c) des zeitlichen Rasters einen oder mehrere Spektraleinhüllendenwerte aus dem codierten Audiosignal zu extrahieren.

28. Decodierer gemäß Anspruch 27, bei dem die Einrichtung zum spektralen Anpassen ausgebildet ist, um aus dem einen oder den mehreren Spektraleinhüllendenwerten des sich mit den zwei benachbarten Frames (802, 804) überlappenden Rasterbereichs (802b) einen ersten oder mehrere erste Spektraleinhüllendenwerte für den ersten Teilrasterbereich (802b₁) und einen zweiten oder mehrere zweite Spektraleinhüllendenwerte für den zweiten Teilrasterbereich (802b₂) zu gewinnen.

29. Decodierer gemäß Anspruch 28, bei dem die Einrichtung zum spektralen Anpassen derart ausgebildet ist, dass jeder Spektraleinhüllendenwert des sich mit den zwei benachbarten Frames (802, 804) überlappenden Rasterbereichs (802b) abhängig von einem Verhältnis einer Größe des ersten Teilrasterbereiches (802b₁) und einer Größe des zweiten Teilrasterbereiches (802b₂) auf einen jeweiligen ersten und zweiten Spektraleinhüllendenwert aufgeteilt wird.

30. Decodierer gemäß einem der Ansprüche 26 bis 29, bei dem die Einrichtung zum spektralen Anpassen eine Analysefilterbank aufweist, die pro Filterbankschlitz des decodierten Audiosignals einen Satz von Spektralwerten erzeugt, wobei jedes Frame mehrere Filterbankzeitschlitze lang ist, und wobei die Einrichtung zum spektralen Anpassen eine Einrichtung zum Bestimmen einer Energie der Spektralwerte in der Auflösung des unterteilten zeitlichen Rasters aufweist.

31. Verfahren zum Decodieren, mit folgenden Schritten:
Extrahieren eines codierten Niederfrequenzanteils eines Audiosignals, von Informationen, die ein zeitliches Raster (802a, 802b, 804a) festlegen, derart, dass sich zumindest ein Rasterbereich (802b) über eine Framegrenze von zwei benachbarten Frames (802, 804) des Audiosignals hinweg erstreckt, um mit den zwei benachbarten Frames zu überlappen, und einer Darstellung einer Spektraleinhüllenden eines Hochfrequenzanteils des Audiosignals, aus einem codierten Audiosignal;
Decodieren des codierten Niederfrequenzanteils des Audiosignals in Einheiten der Frames (802, 804) des Audiosignals;
Bestimmen eines vorläufigen Hochfrequenzanteilsignals auf der Basis des decodierten Niederfrequenzanteils; und
spektrales Anpassen des vorläufigen Hochfrequenzanteilsignals an die Spektraleinhüllenden durch spektrale Gewichtung des vorläufigen Hochfrequenzanteilsignals mittels Herleitens, aus der Darstellung der Spektraleinhüllenden in dem zeitlichen Raster (802a, 802b, 804a), einer Darstellung der Spektraleinhüllenden in einem unterteilten zeitlichen Raster (802a, 802b₁, 802b₂, 804a), bei dem der sich mit den zwei benachbarten Frames überlappende Rasterbereich (802b) in einen ersten Teilrasterbereich (802b₁) und einen zweiten Teilrasterbereich (802b₂) unterteilt ist, die an der Framegrenze aneinander angrenzen, und Vornehmens der Anpassung des vorläufigen Hochfrequenzanteilsignals an die Spektraleinhüllenden durch spektrale Gewichtung des vorläufigen Hochfrequenzanteilsignals in dem unterteilten zeitlichen Raster.

32. Codierer mit
einer Einrichtung (104, 106) zum Codieren eines Niederfrequenzanteils eines Audiosignals in Einheiten von Frames (902) des Audiosignals;
einer Einrichtung (118,116) zum Festlegen eines zeitlichen Rasters (802a, 802b, 804a), derart, dass sich zumindest ein Rasterbereich (802b) über eine Framegrenze von zwei benachbarten Frames (802, 804) des Audiosignals hinweg erstreckt, um mit den zwei benachbarten Frames zu überlappen; und
einer Einrichtung (110, 112, 114) zum Erzeugen einer Darstellung einer Spektraleinhüllenden eines Hochfrequenzanteils des Audiosignals in dem zeitlichen Raster; und
einer Einrichtung (108) zum Zusammenfassen des codierten Niederfrequenzanteils, der Darstellung der Spektraleinhüllenden und von Informationen über das zeitliche Raster zu einem codierten Audiosignal,
wobei die Einrichtung zum Erzeugen und die Einrichtung zum Zusammenfassen derart ausgebildet sind, dass die Darstellung der Spektraleinhüllenden in dem sich über die Framegrenze der zwei benachbarten Frames (802, 804) des Audiosignals hinweg erstreckenden Rasterbereich von einem Verhältnis eines mit einem der zwei benachbarten Frames überlappenden Anteils (802b₁) dieses Rasterbereiches und eines mit dem anderen der zwei benachbarten Frames überlappenden Anteils (802b₂) dieses Rasterbereiches abhängt.

33. Verfahren zum Kodieren, mit folgenden Schritten:
Codieren eines Niederfrequenzanteils eines Audiosignals in Einheiten von Frames (902) des Audiosignals;
Festlegen eines zeitlichen Rasters (802a, 802b, 804a), derart, dass sich zumindest ein Rasterbereich (802b) über eine Framegrenze von zwei benachbarten Frames (802, 804) des Audiosignals hinweg erstreckt, um mit den zwei benachbarten Frames zu überlappen; und
Erzeugen einer Darstellung einer Spektraleinhüllenden eines Hochfrequenzanteils des Audiosignals in dem zeitlichen Raster; und
Zusammenfassen des codierten Niederfrequenzanteils, der Darstellung der Spektraleinhüllenden und von Informationen über das zeitliche Raster zu einem codierten Audiosignal,
wobei
der Schritt des Erzeugens und der Schritt des Zusammenfassens derart durchgeführt werden, dass die Darstellung der Spektraleinhüllenden in dem sich über die Framegrenze der zwei benachbarten Frames (802, 804) des Audiosignals hinweg erstreckenden Rasterbereich von einem Verhältnis eines mit einem der zwei benachbarten Frames überlappenden Anteils (802b₁) dieses Rasterbereiches und eines mit dem anderen der zwei benachbarten Frames überlappenden Anteils (802b₂) dieses Rasterbereiches abhängt.

34. Codierer mit
einer Einrichtung (104, 106) zum Codieren eines Niederfrequenzanteils eines Audiosignals in Einheiten von Frames (902) des Audiosignals;
einer Einrichtung (118) zum Lokalisieren von Transienten in dem Audiosignal;
einer Einrichtung (116) zum, in Abhängigkeit von der Lokalisation, Zuordnen eines jeweiligen Rekonstruktionsmodus unter einer Mehrzahl möglicher Rekonstruktionsmodi zu den Frames des Audiosignals, und, für Frames, denen ein erster der Mehrzahl von Rekonstruktionsmodi zugeordnet ist, Zuordnen einer jeweiligen Transientenabwesenheitsanzeige zu diesen Frames; und
einer Einrichtung (110, 112, 114) zum Erzeugen einer Darstellung einer Spektraleinhüllenden eines Hochfrequenzanteils des Audiosignals in einem zeitlichen Raster, das von den Frames zugeordneten Rekonstruktionsmodi abhängt, derart, dass Frames, denen der erste der Mehrzahl von möglichen Rekonstruktionsmodi zugeordnet ist, die Framegrenzen (902a, 902b) dieser Frames (902) mit Rastergrenzen des Rasters (222a, 220, 222b) zusammenfallen; und
einer Einrichtung (108) zum Zusammenfassen des codierten Niederfrequenzanteils, der Darstellung der Spektraleinhüllenden und von Informationen über die zugeordneten Rekonstruktionsmodi und die Transientenabwesenheitsanzeige zu einem codierten Audiosignal,
wobei die Einrichtung zum Erzeugen und die Einrichtung zum Zusammenfassen ausgebildet sind, um für ein Frame (404), dem der erste Rekonstruktionsmodus zugeordnet ist, für den zeitlich ersten Rasterbereich dieses Frames abhängig von der Transientenabwesenheitsanzeige entweder keinen oder aber einen oder mehrere Spektraleinhüllendenwerte, der bzw. die die Spektraleinhüllende mit einer jeweiligen Frequenzauflösung beschreibt bzw. beschreiben, als Teil der Darstellung der Spektraleinhüllenden in das codierte Audiosignal einzubringen.

35. Codierer gemäß Anspruch 34,bei dem die Einrichtung zum Erzeugen derart ausgebildet ist, dass die Rastergrenzen im Innern von Frames, denen der zweite der zumindest zwei möglichen Rekonstruktionsmodi zugeordnet ist, zeitlich gleichmäßig verteilt angeordnet sind, so dass diese Frames nur einen Rasterbereich aufweisen oder in gleich große Rasterbereiche (906a, 906b) gegliedert sind.

36. Decodierer mit
einer Einrichtung (306) zum Extrahieren eines codierten Niederfrequenzanteils eines Audiosignals, einer Darstellung einer Spektraleinhüllenden eines Hochfrequenzanteils des Audiosignals, von Informationen über Rekonstruktionsmodi, die Frames des
Audiosignals zugeordnet sind und jeweils einem einer Mehrzahl von Rekonstruktionsmodi entsprechen, und Transientenabwesenheitsanzeigen, die jeweils Frames zugeordnet sind, denen ein erster der Mehrzahl von Rekonstruktionsmodi zugeordnet sind, aus dem codierten Audiosignal;
einer Einrichtung (308) zum Decodieren des codierten Niederfrequenzanteils des Audiosignals in Einheiten der Frames (802, 804) des Audiosignals;
einer Einrichtung (310) zum Bestimmen eines vorläufigen Hochfrequenzanteilsignals auf der Basis des decodierten Niederfrequenzanteils; und
einer Einrichtung (318, 312, 314) zum spektralen Anpassen des vorläufigen Hochfrequenzanteilsignals an die Spektraleinhüllenden durch spektrale Gewichtung des vorläufigen Hochfrequenzanteilsignals in einem zeitlichen Raster, das von den den Frames zugeordneten Rekonstruktionsmodi abhängt, derart, dass Frames, denen der erste der Mehrzahl von möglichen Rekonstruktionsmodi zugeordnet ist, die Framegrenzen (902a, 902b) dieser Frames (902) mit Rastergrenzen des Rasters (222a, 220, 222b) zusammenfallen, und die Einrichtung zum spektralen Anpassen einen oder mehrere Spektraleinhüllendenwerte pro Rasterbereich innerhalb dieser Frames zur Darstellung der Spektraleinhüllenden heranzieht,
wobei die Einrichtung zum Extrahieren ausgebildet ist, um für ein Frame (404), dem der erste Rekonstruktionsmodus zugeordnet ist, für den zeitlich ersten Rasterbereich dieses Frames abhängig von der Transientenabwesenheitsanzeige entweder einen oder mehrere Spektraleinhüllendenwerte, der bzw. die die Spektraleinhüllende mit einer jeweiligen Frequenzauflösung beschreibt bzw. beschreiben, als Teil der Darstellung der Spektraleinhüllenden aus dem codierten Audiosignal zu extrahieren, oder aber aus einem oder mehreren Spektraleinhüllendenwerten eines an den zeitlich ersten Rasterbereich angrenzenden Rasterbereichs des zeitlich vorangehenden Frames zu gewinnen.

37. Verfahren zum Kodieren, mit folgenden Schritten:
Codieren eines Niederfrequenzanteils eines Audiosignals in Einheiten von Frames (902) des Audiosignals;
Lokalisieren von Transienten in dem audiosignal;
in Abhängigkeit von der Lokalisation, Zuordnen eines jeweiligen Rekonstruktionsmodus unter einer Mehrzahl möglicher Rekonstruktionsmodi zu den Frames des Audiosignals, und, für Frames, denen ein erster der Mehrzahl von Rekonstruktionsmodi zugeordnet ist, Zuordnen einer jeweiligen Transientenabwesenheitsanzeige zu diesen Frames;
Erzeugen einer Darstellung einer Spektraleinhüllenden eines Hochfrequenzanteils des Audiosignals in einem zeitlichen Raster, das von den Frames zugeordneten Rekonstruktionsmodi abhängt, derart, dass Frames, denen der erste der Mehrzahl von möglichen Rekonstruktionsmodi zugeordnet ist, die Framegrenzen (902a, 902b) dieser Frames (902) mit Rastergrenzen des Rasters (222a, 220, 222b) zusammenfallen; und
Zusammenfassen des codierten Niederfrequenzanteils, der Darstellung der Spektraleinhüllenden und von Informationen über die zugeordneten Rekonstruktionsmodi und die Transientenabwesenheitsanzeige zu einem codierten Audiosignal,
wobei das Erzeugen und das Zusammenfassen derart durchgeführt werden, dass für ein Frame (404), dem der erste Rekonstruktionsmodus zugeordnet ist, für den zeitlich ersten Rasterbereich dieses Frames abhängig von der Transientenabwesenheitsanzeige entweder kein oder aber ein oder mehrere Spektraleinhüllendenwerte, der bzw. die die Spektraleinhüllende mit einer jeweiligen Frequenzauflösung beschreibt bzw. beschreiben, als Teil der Darstellung der Spektraleinhüllenden in das codierte Audiosignal eingebracht wird.

38. Verfahren zum Decodieren, mit folgenden Schritten:
Extrahieren eines codierten Niederfrequenzanteils eines Audiosignals, einer Darstellung einer Spektraleinhüllenden eines Hochfrequenzanteils des Audiosignals, von Informationen über Rekonstruktionsmodi, die Frames des Audiosignals zugeordnet sind und jeweils einem einer Mehrzahl von Rekonstruktionsmodi entsprechen, und Transientenabwesenheitsanzeigen, die jeweils Frames zugeordnet sind, denen ein erster der Mehrzahl von Rekonstruktionsmodi zugeordnet sind, aus dem codierten Audiosignal;
Decodieren des codierten Niederfrequenzanteils des Audiosignals in Einheiten der Frames (802, 804) des Audiosignals;
Bestimmen eines vorläufigen Hochfrequenzanteilsignals auf der Basis des decodierten Niederfrequenzanteils; und
spektrales Anpassen des vorläufigen Hochfrequenzanteilsignals an die Spektraleinhüllenden durch spektrale Gewichtung des vorläufigen Hochfrequenzanteilsignals in einem zeitlichen Raster, das von den den Frames zugeordneten Rekonstruktionsmodi abhängt, derart, dass Frames, denen der erste der Mehrzahl von möglichen Rekonstruktionsmodi zugeordnet ist, die Framegrenzen (902a, 902b) dieser Frames (902) mit Rastergrenzen des Rasters (222a, 220, 222b) zusammenfallen, und die Einrichtung zum spektralen Anpassen einen oder mehrere Spektraleinhüllendenwerte pro Rasterbereich innerhalb dieser Frames zur Darstellung der Spektraleinhüllenden heranzieht,
wobei die das Extrahieren so durchgeführt wird, dass für ein Frame (404), dem der erste Rekonstruktionsmodus zugeordnet ist, für den zeitlich ersten Rasterbereich dieses Frames abhängig von der Transientenabwesenheitsanzeige entweder ein oder mehrere Spektraleinhüllendenwerte, der bzw. die die Spektraleinhüllende mit einer jeweiligen Frequenzauflösung beschreibt bzw. beschreiben, als Teil der Darstellung der Spektraleinhüllenden aus dem codierten Audiosignal extrahiert oder aber aus einem oder mehreren Spektraleinhüllendenwerten eines an den zeitlich ersten Rasterbereich angrenzenden Rasterbereichs des zeitlich vorangehenden Frames gewonnen wird.

39. Codiertes Audiosignal mit
einem codierten Niederfrequenzanteils eines Audiosignals;
einer Darstellung einer Spektraleinhüllenden eines Hochfrequenzanteils des Audiosignals;
Informationen über Rekonstruktionsmodi, die Frames des Audiosignals zugeordnet sind und jeweils einem einer Mehrzahl von Rekonstruktionsmodi entsprechen, und Transientenabwesenheitsanzeigen, die jeweils Frames zugeordnet sind, denen ein erster der Mehrzahl von Rekonstruktionsmodi zugeordnet sind,
derart dass aus dem codierten Audiosignal durch folgende Schritte das Audiosignal erhaltbar ist:
Decodieren des codierten Niederfrequenzanteils des Audiosignals in Einheiten der Frames (802, 804) des Audiosignals;
Bestimmen eines vorläufigen Hochfrequenzanteilsignals auf der Basis des decodierten Niederfrequenzanteils; und
spektrales Anpassen des vorläufigen Hochfrequenzanteilsignals an die Spektraleinhüllenden durch spektrale Gewichtung des vorläufigen Hochfrequenzanteilsignals in einem zeitlichen Raster, das von den den Frames zugeordneten Rekonstruktionsmodi abhängt, derart, dass Frames, denen der erste der Mehrzahl von möglichen Rekonstruktionsmodi zugeordnet ist, die Framegrenzen (902a, 902b) dieser Frames (902) mit Rastergrenzen des Rasters (222a, 220, 222b) zusammenfallen, und die Einrichtung zum spektralen Anpassen einen oder mehrere Spektraleinhüllendenwerte pro Rasterbereich innerhalb dieser Frames zur Darstellung der Spektraleinhüllenden heranzieht,
wobei die das Extrahieren so durchgeführt wird, dass für ein Frame (404), dem der erste Rekonstruktionsmodus zugeordnet ist, für den zeitlich ersten Rasterbereich dieses Frames abhängig von der Transientenabwesenheitsanzeige entweder ein oder mehrere Spektraleinhüllendenwerte, der bzw. die die Spektraleinhüllende mit einer jeweiligen Frequenzauflösung beschreibt bzw. beschreiben, als Teil der Darstellung der Spektraleinhüllenden aus dem codierten Audiosignal extrahiert oder aber aus einem oder mehreren Spektraleinhüllendenwerten eines an den zeitlich ersten Rasterbereich angrenzenden Rasterbereichs des zeitlich vorangehenden Frames gewonnen wird.

40. Computer-Programm mit einem Programmcode zur Durchführung des Verfahrens nach einem der Ansprüche 24, 25, 31, 33, 37 und 38, wenn das Computer-Programm auf einem Computer abläuft.

## Claims

1. An encoder comprising
a means (104, 106) for encoding a low-frequency portion of an audio signal in units of frames (902) of the audio signal;
a means (118) for localizing transients within the audio signal;
a means (116) for, as a function of the localization, associating a respective reconstruction mode from among at least two possible reconstruction modes with the frames of the audio signal, and, for frames which have associated therewith a first one of the at least two possible reconstruction modes, associating a respective transient position indication with these frames; and
a means (110, 112, 114) for generating a representation of a spectral envelope of a high-frequency portion of the audio signal in a temporal grid which depends on reconstruction modes associated with the frames, such that for frames which have the first one of the at least two possible reconstruction modes associated therewith, the frame boundaries (902a, 902b) of these frames (902) coincide with grid boundaries of the grid (222a, 220, 222b), and the grid boundaries of the grid within these frames depend on the transient position indication; and
a means (108) for combining the encoded low-frequency portion, the representation of the spectral envelope and information on the associated reconstruction modes and the transient position indications into an encoded audio signal.

2. The encoder as claimed in claim 1, wherein the means for generating is configured such that the grid boundaries within the frame, which have the first one of the at least two possible reconstruction modes associated therewith, are located such that they specify at least a first grid area (220) whose position within the respective frame depends on the transient position indication, and whose temporal extension is smaller than 1/3 of a length of the frames, as well as a second and/or a third grid area(s) (222a, 222b) which take(s) up the remaining part of the respective frame from the first grid area to the frame boundary (902a, 902b), which is leading in terms of time and/or trailing in terms of time, of the respective frame.

3. The encoder as claimed in claim 2, wherein the means for generating and the means for combining are configured to introduce, for a frame (404) having the first reconstruction mode associated with it which comprises three grid areas (410, 412, 414) and wherein the first grid area (412) among the three grid areas is closer to a preceding frame than a predetermined value, one or several spectral envelope values describing the spectral envelope with a respective frequency resolution, only for the first and third grid areas (412, 414), into the encoded audio signal, and to introduce no spectral envelope value into the encoded audio signal for the second grid area (410) of this frame (404).

4. The encoder as claimed in claims 2 or 3, wherein the means for generating and the means for combining are configured to introduce, for a frame (502) having the first reconstruction mode associated with it, which comprises only two grid areas (502a, 502b) and wherein the first grid area (502b) borders on the frame boundary which is trailing in terms of time, one or several spectral envelope values, for both grid areas, said one or several spectral envelope value(s) - describing the spectral envelope with a respective frequency resolution, into the encoded audio signal, and to also use, for determining the spectral envelope value (s) for the first grid area (502b), parts of the audio signal located in the extension grid area (504b') in the subsequent frame (504) which borders on the trailing frame boundary, and to shorten a grid area (504a'), which is leading in terms of time, of the subsequent frame (504) as is specified by the reconstruction mode of the subsequent frame, so as to start only at the extension grid area (504b').

5. The encoder as claimed in claims 3 or 4, wherein the means for generating and the means for combining are configured to introduce one or several spectral envelope values into the encoded audio signal for a frame having the second reconstruction mode associated with it or having the first reconstruction mode associated with it, but for which neither the condition that it comprises three grid areas and that, at the same time, the first grid area among the three grid areas is located closer to the preceding frame than the predetermined value, nor the condition that it comprises only two grid areas and that, at the same time, the first grid area borders on the frame boundary which is trailing in terms of time, are fulfilled, for each grid area of this frame.

6. The encoder as claimed in claim 2, wherein the means for generating is configured such that the first grid area (220) borders on the frame boundary (902a), leading in terms of time, of the respective frame if there is no second grid area (222a), and wherein the first grid area (220) borders on the frame boundary (902b), trailing in terms of time, of the respective frame if no third grid area (222b) exists.

7. The encoder as claimed in any of the previous claims, wherein the means for generating is configured such that the grid boundaries within frames which have the second of the at least two possible reconstruction modes associated with them are located such that they are equally distributed over time, so that these frames only comprise one grid area or are subdivided into equally sized grid areas (906a, 906b).

8. The encoder as claimed in any of the previous claims, wherein the means for associating is configured to associate a frame subdivision number indication with each frame which has the second of the at least two possible reconstruction modes associated with it, the means for generating being configured such that the grid boundaries within these frames subdivide these frames into a number of grid areas, said number depending on the respective frame subdivision number indication.

9. The encoder as claimed in any of the previous claims, wherein the means for generating is configured such that the frame boundaries of the frames always coincide with grid boundaries of the grid independently of the possible reconstruction modes associated with the frames.

10. The encoder as claimed in any of the previous claims, wherein the means for generating comprises an analysis filter bank (110) which generates a set of spectral values (250) for each filter bank time slot (904) of the audio signal, each frame (902) having a length of several filter bank time slots, and the means (112) for generating further comprising a means for averaging the energy spectral values in the resolution of the grid.

11. The encoder as claimed in claim 10, wherein the transient position indication is defined in units of the filter bank time slots (904).

12. A decoder comprising
a means (306) for extracting, from the encoded audio signal, an encoded low-frequency portion of an audio signal, a representation of a spectral envelope of a high-frequency portion of the audio signal, information on reconstruction modes associated with frames of the audio signal and corresponding with one, respectively, of at least two reconstruction modes, and transient position indications associated with frames, in each case, which have a first one of the at least two reconstruction modes associated with them;
a means (308) for decoding the encoded low-frequency portion of the audio signal in units of frames of the audio signal;
a means (310) for providing a preliminary high-frequency portion signal on the basis of the decoded low-frequency portion; and
a means (318, 312, 314) for spectrally adapting the preliminary high-frequency portion signal to the spectral envelopes by means of spectral weighting of the preliminary high-frequency portion signal as a function of the representation of the spectral envelopes in a temporal grid which depends on the reconstruction modes associated with the frames, such that for frames having the first one of the at least two possible reconstruction modes associated with them, the frame boundaries of these frames coincide with grid boundaries of the grid, and the grid boundaries of the grid within these frames depend on the transient position indication.

13. The decoder as claimed in claim 12, wherein the means for spectrally adapting is configured such that the grid boundary, or grid boundaries, within a frame having the first one of the at least two possible reconstruction modes associated with it is/are located such that it/they specify/specifies at least a first grid area (220) whose position within the respective frame depends on the transient position indication, and whose temporal extension is smaller than 1/3 of a length of the frames, as well as a second and/or third grid area(s) (222a, 222b) which take(s) up the remaining part of the respective frame from the first grid area up to the frame boundary, which is leading in terms of time, or trailing in terms of time (902a, 902b), of the respective frame.

14. The decoder as claimed in claim 13, wherein the means for extracting is configured to expect one or several spectral envelope values in the encoded audio signal, and to extract same from the encoded audio signal, only for the first and third grid areas (412, 414), for a frame (404) having the first reconstruction mode associated with it which comprises three grid areas (410, 412, 414) and wherein the first grid area (412) among the three grid areas is more to a preceding frame (406) than a predetermined value, said one or several spectral envelope values describing the spectral envelope with a respective frequency resolution, and to obtain, for the second grid area (410), one or several spectral envelope values for the representation of the spectral envelope from the grid area (408), which is the last in terms of time, of the preceding frame (406).

15. The decoder as claimed in claims 13 or 14, wherein the means for extracting is configured to expect one or several spectral envelope values in the encoded audio signal, and to extract same from the encoded audio signal, for both grid areas, for a frame (502) having the first reconstruction mode associated with it which comprises two grid areas (502a, 502b) and wherein the first grid area (502b) borders on the frame boundary, trailing in terms of time, of the frame (502), said one or several spectral envelope values describing the spectral envelope with a respective frequency solution, and to obtain from the spectral envelope value(s) for the first grid area (502b) one or several spectral envelope value(s) for a supplemental grid area (504b') in the subsequent frame (504), said supplementary grid area (504b') bordering on the trailing frame boundary, and to shorten accordingly a grid area (504a'), leading in terms of time, of the subsequent frame (504), as is defined by the reconstruction mode of the subsequent frame, so as to start only at the supplementary grid area (504b'), whereby the temporal grid within the subsequent frame (504) is subdivided, the means for spectral adaptation being configured to perform the adaptation in the subdivided temporal grid.

16. The decoder as claimed in claims 14 or 15, wherein the means for extracting is configured to introduce one or several spectral envelope values into the encoded audio signal, or to extract same from the encoded audio signal, for a frame having the second reconstruction mode associated with it or having the first reconstruction mode associated with it, but for which neither the condition that it comprises three grid areas and that, at the same time, the first grid area among the three grid areas is located closer to the preceding frame than the predetermined value, nor the condition that it comprises only two grid areas and that, at the same time, the first grid area borders on the frame boundary which is trailing in terms of time, are fulfilled, for each grid area of this frame.

17. The decoder as claimed in claim 16, wherein the means for spectrally adapting is configured such that the first grid area (220) borders on the frame boundary (902a), leading in terms of time, of the respective frame if there is no second grid area (222a), and wherein the first grid area (220) borders on the frame boundary (902b), trailing in terms of time, of the respective frame if no third grid area (222b) exists.

18. The decoder as claimed in any of claims 12 to 17, wherein the means for spectrally adapting is configured such that the grid boundaries within frames which have the second of the at least two possible reconstruction modes associated with them are located such that they are equally distributed over time, so that these frames only comprise one grid area or are subdivided into equally sized grid areas (906a, 906b).

19. The decoder as claimed in any of claims 12 to 18, wherein the means for extracting is configured to extract, from the encoded audio signal, also a frame subdivision number indication which is associated, in each case, with frames which have the second of the possible reconstruction modes associated with them, the means for spectrally adaptating being configured such that the grid boundaries within these frames are subdivided into a number of grid areas, said number depending on the respective frame subdivision number indication.

20. The decoder as claimed in any of claims 12 to 19, wherein the means for spectrally adapting is configured such that the frame boundaries of the frames always coincide with grid boundaries of the grid independently of the possible reconstruction modes associated with the frames.

21. The decoder as claimed in any of claims 12 to 20, wherein the means for spectrally adapting comprises an analysis filter bank (310) which generates a set of spectral values for each filter bank time slot of the audio signal, each frame having a length of several filter bank time slots, and the means for spectrally adapting further comprising a means (318) for determining the energy of the spectral values in the resolution of the grid.

22. The decoder as claimed in claim 21, wherein the transient position indication is defined in units of the filter bank time slots.

23. An encoded audio signal comprising
an encoded low-frequency portion of an audio signal;
a representation of a spectral envelope of a high-frequency portion of an audio signal; and
information on reconstruction modes which are associated with frames of the audio signal and each correspond to one of at least two reconstruction modes, and transient position indications each associated with frames which have a first one of the at least two reconstruction modes associated with them,
such that the audio signal may be obtained from the encoded audio signal by the following steps:
decoding the encoded low-frequency portion of the audio signal in units of frames of the audio signal;
providing a preliminary high-frequency portion signal on the basis of the decoded low-frequency portion; and
spectrally adapting the preliminary high-frequency portion signal to the spectral envelopes by spectrally weighting the preliminary high-frequency portion signal as a function of the representation of the spectral envelopes in a temporal grid which depends on the reconstruction modes associated with the frames, such that for frames which have the first one of the at least two possible reconstruction modes associated with them, the frame boundaries of these frames coincide with grid boundaries of the grid, and the grid boundaries of the grid within these frames depend on the transient position indication.

24. A method of encoding, comprising the steps of:
encoding a low-frequency portion of an audio signal in units of frames (902) of the audio signal;
localizing transients within the audio signal;
associating, as a function of the localization, a respective reconstruction mode from among at least two possible reconstruction modes with the frames of the audio signal, and, for frames which have associated therewith a first one of the at least two possible reconstruction modes, associating a respective transient position indication with these frames; and
generating a representation of a spectral envelope of a high-frequency portion of the audio signal in a temporal grid which depends on the reconstruction modes associated with the frames, such that frames which have the first one of the at least two possible reconstruction modes associated therewith, the frame boundaries (902a, 902b) of these frames (902) coincide with grid boundaries of the grid (222a, 220, 222b), and the grid boundaries of the grid within these frames depend on the transient position indication; and
combining the encoded low-frequency portion, the representation of the spectral envelope and information on the associated reconstruction modes and the transient position indications into an encoded audio signal.

25. A method of decoding, comprising the steps of:
extracting, from the encoded audio signal, an encoded low-frequency portion of an audio signal, a representation of a spectral envelope of a high-frequency portion of the audio signal and information on reconstruction modes associated with frames of the audio signal and corresponding with one, respectively, of at least two reconstruction modes, and transient position indications associated with frames, in each case, which have a first one of the at least two reconstruction modes associated with them;
decoding the encoded low-frequency portion of the audio signal in units of frames of the audio signal;
providing a preliminary high-frequency portion signal on the basis of the decoded low-frequency portion; and
spectrally adapting the preliminary high-frequency portion signal to the spectral envelopes by means of spectral weighting of the preliminary high-frequency portion signal as a function of the representation of the spectral envelopes in a temporal grid which depends on the reconstruction modes associated with the frames, such that for frames having the first one of the at least two possible reconstruction modes associated with them, the frame boundaries of these frames coincide with grid boundaries of the grid, and the grid boundaries of the grid within these frames depend on the transient position indication.

26. A decoder comprising
a means (306) for extracting, from an encoded audio signal, an encoded low-frequency portion of an audio signal, information specifying a temporal grid (802a, 802b, 804a) such that at least one grid area (802b) extends across a frame boundary of two adjacent frames (802, 804) of the audio signal so as to overlap with the two adjacent frames, and a representation of a spectral envelope of a high-frequency portion of the audio signal;
a means (308) for decoding the encoded low-frequency portion of the audio signal in units of the frames (802, 804) of the audio signal;
a means (310) for determining a preliminary high-frequency portion signal on the basis of the decoded low-frequency portion; and
a means (318, 312, 314) for spectrally adapting the preliminary high-frequency portion signal to the spectral envelopes by means of spectrally weighting the preliminary high-frequency portion signal by means of deriving, from the representation of the spectral envelopes in the temporal grid (802a, 802b, 804a), a representation of the spectral envelopes in a subdivided temporal grid (802a, 802b₁, 802b₂, 804a), wherein the grid area (802b) overlapping with the two adjacent frames is subdivided into a first partial grid area (802b₁) and a second partial grid area (802b₂), which border on one another at the frame boundary, and by means of performing the adaptation of the preliminary high-frequency portion signal to the spectral envelopes by spectrally weighting the preliminary high-frequency portion signal in the subdivided temporal grid.

27. The decoder as claimed in claim 26, wherein the means for extracting is configured to extract, from the encoded audio signal, information on reconstruction modes associated with the frames of the audio signal, as the information specifying the temporal grid, the reconstruction modes, in each case, specifying grid areas of the temporal grid and corresponding to one of a plurality of possible reconstruction modes respectively, and the means for extracting being configured to extract, from the encoded audio signal, also an indication, for frames having a predetermined one of the possible reconstruction modes associated with them, which indicates how an outer grid boundary of an outer grid area (802b) of the frame (802) which overlaps with the frame (802) is to be aligned, in terms of time, with a frame boundary of the frame, and to extract, from the encoded audio signal, one or several spectral envelope values for each grid area (802a,b,c) of the temporal grid.

28. The decoder as claimed in claim 27, wherein the means for spectrally adapting is configured to obtain, from the one or several spectral envelope values of the grid area (802b) overlapping with the two adjacent frames (802, 804), a first or several first spectral envelope values for the first partial grid area (802b₁) and a second or several second spectral envelope values for the second partial grid area (802b₂).

29. The decoder as claimed in claim 28, wherein the means for spectrally adapting is configured such that each spectral envelope value of the grid area (802b) overlapping with the two adjacent frames (802, 804) is divided into first and second spectral envelope values, respectively, as a function of a ratio of a size of the first partial grid area (802b₁) and a size of the second partial grid area (802b₂).

30. The decoder as claimed in any of claims 26 to 29, wherein the means for spectrally adapting comprises an analysis filter bank generating a set of spectral values per filter bank slot of the decoded audio signal, each frame having a length of several filter bank time slots, and the means for spectrally adapting comprising a means for determining an energy of the spectral values in the resolution of the subdivided temporal grid.

31. A method of decoding, comprising the steps of:
extracting, from an encoded audio signal, an encoded low-frequency portion of an audio signal, information specifying a temporal grid (802a, 802b, 804a) such that at least one grid area (802b) extends across a frame boundary of two adjacent frames (802, 804) of the audio signal so as to overlap with the two adjacent frames, and a representation of a spectral envelope of a high-frequency portion of the audio signal;
decoding the encoded low-frequency portion of the audio signal in units of the frames (802, 804) of the audio signal;
determining a preliminary high-frequency portion signal on the basis of the decoded low-frequency portion; and
spectrally adapting the preliminary high-frequency portion signal to the spectral envelopes by means of spectrally weighting the preliminary high-frequency portion signal by means of deriving, from the representation of the spectral envelopes in the temporal grid (802a, 802b, 804a), a representation of the spectral envelopes in a subdivided temporal grid (802a, 802b₁, 802b₂, 804a), wherein the grid area (802b) overlapping with the two adjacent frames is subdivided into a first partial grid area (802b₁) and a second partial grid area (802b₂), which border on one another at the frame boundary, and by means of performing the adaptation of the preliminary high-frequency portion signal to the spectral envelopes by spectrally weighting the preliminary high-frequency portion signal in the subdivided temporal grid.

32. An encoder comprising:
a means (104, 106) for encoding a low-frequency portion of an audio signal in units of frames (902) of the audio signal;
a means (118, 116) for specifying a temporal grid (802a, 802b, 804a) such that at least one grid area (802b) extends across a frame boundary of two adjacent frames (802, 804) of the audio signal so as to overlap with the two adjacent frames; and
a means (110, 112, 114) for generating a representation of a spectral envelope of a high-frequency portion of the audio signal in the temporal grid; and
a means (108) for combining the encoded low-frequency portion, the representation of the spectral envelope and information on the temporal grid into an encoded audio signal;
the means for generating and the means for combining being configured such that the representation of the spectral envelope in the grid area extending across the frame boundary of the two adjacent frames (802, 804) of the audio signal depends on a ratio of a portion (802b₁) of this grid area which overlaps with one of the two adjacent frames, and of a portion of this grid area which overlaps with the other of the two adjacent frames (802b₂).

33. A method of encoding, comprising
encoding a low-frequency portion of an audio signal in units of frames (902) of the audio signal;
specifying a temporal grid (802a, 802b, 804a) such that at least one grid area (802b) extends across a frame boundary of two adjacent frames (802, 804) of the audio signal so as to overlap with the two adjacent frames; and
generating a representation of a spectral envelope of a high-frequency portion of the audio signal in the temporal grid; and
combining the encoded low-frequency portion, the representation of the spectral envelope and information on the temporal grid into an encoded audio signal;
wherein the step of generating and the step of combining being performed such that the representation of the spectral envelope in the grid area extending across the frame boundary of the two adjacent frames (802, 804) of the audio signal depends on a ratio of a portion (802b₁) of this grid area which overlaps with one of the two adjacent frames, and of a portion of this grid area which overlaps with the other of the two adjacent frames (802b₂).

34. An encoder comprising
a means (104, 106) for encoding a low-frequency portion of an audio signal in units of frames (902) of the audio signal;
a means (118) for localizing transients within the audio signal;
a means (116) for, as a function of the localization, associating a respective reconstruction mode from among at least two possible reconstruction modes with the frames of the audio signal, and, for frames which have associated therewith a first one of the plurality of reconstruction modes, associating a respective absence indication with these frames; and
a means (110, 112, 114) for generating a representation of a spectral envelope of a high-frequency portion of the audio signal in a temporal grid which depends on reconstruction modes associated with the frames, such that frames which have the first one of the plurality of possible reconstruction modes associated therewith, the frame boundaries (902a, 902b) of these frames (902) coincide with grid boundaries of the grid (222a, 220, 222b); and
a means (108) for combining the encoded low-frequency portion, the representation of the spectral envelope and information on the associated reconstruction modes and the transient absence indication into an encoded audio signal,
the means for generating and the means for combining being configured to introduce, for a frame (404) having the first reconstruction mode associated with it, either no or one or several spectral envelope value(s) describing the spectral envelope with a respective frequency resolution, as part of the representation of the spectral envelope, into the encoded audio signal for the first, in terms of time, grid area of this frame as a function of the transient absence indication.

35. The encoder as claimed in claim 34, wherein the means for generating is configured such that the grid boundaries within frames which have the second of the at least two possible reconstruction modes associated with them are located such that they are equally distributed over time, so that these frames only comprise one grid area or are subdivided into equally sized grid areas (906a, 906b).

36. A decoder comprising
a means (306) for extracting, from the encoded audio signal, an encoded low-frequency portion of an audio signal, a representation of a spectral envelope of a high-frequency portion of the audio signal, information on reconstruction modes associated with frames of the audio signal and corresponding with one, respectively, of a plurality of reconstruction modes, and transient absence indications associated with frames, in each case, which have a first one of the plurality of reconstruction modes associated with them;
a means (308) for decoding the encoded low-frequency portion of the audio signal in units of the frames (802, 804) of the audio signal;
a means (310) for determining a preliminary high-frequency portion signal on the basis of the decoded low-frequency portion; and
a means (318, 312, 314) for spectrally adapting the preliminary high-frequency portion signal to the spectral envelopes by means of spectral weighting of the preliminary high-frequency portion signal in a temporal grid which depends on the reconstruction modes associated with the frames, such that frames having the first one of the plurality of possible reconstruction modes associated with them, the frame boundaries (902a, 902b) of these frames (902) coincide with grid boundaries of the grid (222a, 220, 222b), and the means for spectrally adapting utilizes one or several spectral envelope values per grid area within these frames for representing the spectral envelopes,
the means for extracting being configured to extract, for a frame (404) having the first reconstruction mode associated with it, for the first, in terms of time, grid area of this frame, as a function of the transient absence indication, either one or several spectral envelope values describing the spectral envelope with a respective frequency solution as part of the representation of the spectral envelope from the encoded audio signal, or to obtain same from one or several spectral envelope values of a grid area, which is adjacent to the first, in terms of time, grid area, of the frame leading in terms of time.

37. A method of encoding, comprising the steps of:
encoding a low-frequency portion of an audio signal in units of frames (902) of the audio signal;
localizing transients within the audio signal;
associating, as a function of the localization, a respective reconstruction mode from among a plurality of possible reconstruction modes with the frames of the audio signal, and, for frames which have associated therewith a first one of the plurality of reconstruction modes, associating a respective transient absence indication with these frames;
generating a representation of a spectral envelope of a high-frequency portion of the audio signal in a temporal grid which depends on reconstruction modes associated with the frames, such that frames which have the first one of the plurality of possible reconstruction modes associated therewith, the frame boundaries (902a, 902b) of these frames (902) coincide with grid boundaries of the grid (222a, 220, 222b); and
combining the encoded low-frequency portion, the representation of the spectral envelope and information on the associated reconstruction modes and the transient absence indication into an encoded audio signal,
the generating and combining being performed such that, for a frame (404) having the first reconstruction mode associated with it, either no or one or several spectral envelope value(s) describing the spectral envelope with a respective frequency resolution is/are introduced, as part of the representation of the spectral envelope, into the encoded audio signal for the first, in terms of time, grid area of this frame as a function of the transient absence indication.

38. A method of decoding, comprising the steps of:
extracting, from the encoded audio signal, an encoded low-frequency portion of an audio signal, a representation of a spectral envelope of a high-frequency portion of the audio signal, information on reconstruction modes associated with frames of the audio signal and corresponding with one, respectively, of a plurality of reconstruction modes, and transient absence indications associated with frames, in each case, which have a first one of the plurality of reconstruction modes associated with them;
decoding the encoded low-frequency portion of the audio signal in units of the frames (802, 804) of the audio signal;
determining a preliminary high-frequency portion signal on the basis of the decoded low-frequency portion; and
spectrally adapting the preliminary high-frequency portion signal to the spectral envelopes by means of spectral weighting of the preliminary high-frequency portion signal in a temporal grid which depends on the reconstruction modes associated with the frames, such that frames having the first one of the plurality of possible reconstruction modes associated with them, the frame boundaries (902a, 902b) of these frames (902) coincide with grid boundaries of the grid (222a, 220, 222b), and the means for spectrally adapting utilizes one or several spectral envelope values per grid area within these frames for representing the spectral envelopes,
the extracting being performed such that, for a frame (404) having the first reconstruction mode associated with it, for the first, in terms of time, grid area of this frame, as a function of the transient absence indication, either one or several spectral envelope values describing the spectral envelope with a respective frequency solution is extracted as part of the representation of the spectral envelope from the encoded audio signal, or that same is obtained from one or several spectral envelope values of a grid area, which is adjacent to the first, in terms of time, grid area, of the frame leading in terms of time.

39. An encoded audio signal comprising
an encoded low-frequency portion of an audio signal;
a representation of a spectral envelope of a high-frequency portion of the audio signal;
information on reconstruction modes associated with frames of the audio signal and corresponding with one, respectively, of a plurality of reconstruction modes, and transient absence indications associated with frames, in each case, which have a first one of the plurality of reconstruction modes associated with them,
such that the audio signal may be obtained from the encoded audio signal by the following steps:
decoding the encoded low-frequency portion of the audio signal in units of the frames (802, 804) of the audio signal;
determining a preliminary high-frequency portion signal on the basis of the decoded low-frequency portion; and
spectrally adapting the preliminary high-frequency portion signal to the spectral envelopes by means of spectral weighting of the preliminary high-frequency portion signal in a temporal grid which depends on the reconstruction modes associated with the frames, such that frames having the first one of the plurality of possible reconstruction modes associated with them, the frame boundaries (902a, 902b) of these frames (902) coincide with grid boundaries of the grid (222a, 220, 222b), and the means for spectrally adapting utilizes one or several spectral envelope values per grid area within these frames for representing the spectral envelopes,
the extracting being performed such that extract, for a frame (404) having the first reconstruction mode associated with it, for the first, in terms of time, grid area of this frame, as a function of the transient absence indication, either one or several spectral envelope values describing the spectral envelope with a respective frequency solution is extracted as part of the representation of the spectral envelope from the encoded audio signal, or that same is obtained from one or several spectral envelope values of a grid area, which is adjacent to the first, in terms of time, grid area, of the frame leading in terms of time.

40. A computer program comprising a program code for performing the method as claimed in any of claims 24, 25, 31, 33, 37 and 38, when the computer program runs on a computer.

## Revendications

1. Codeur, avec
un moyen (104, 106) pour coder une part de basses fréquences d'un signal audio en unités de trames (902) du signal audio;
un moyen (118) pour localiser des transitoires dans le signal audio;
un moyen (116) pour associer, en fonction de la localisation, un mode de reconstruction respectif parmi au moins deux modes de reconstruction possibles aux trames du signal audio et, pour les trames auxquelles est associé un premier parmi les au moins deux modes de reconstruction possibles, associer une indication de position de transitoires respective à ces trames; et
un moyen (110, 112, 114) pour générer une représentation d'une enveloppe spectrale d'une part de hautes fréquences du signal audio dans une trame dans le temps qui est fonction des modes de reconstruction associés aux trames, de sorte que, pour les trames auxquelles est associé le premier parmi les au moins deux modes de reconstruction possibles, les limites (902a, 902b) de ces trames (902) coïncident avec les limites de la trame (222a, 220, 222b) et les limites de la trame à l'intérieur de ces trames dépendent de l'indication de position de transitoires; et
un moyen (108) pour regrouper la part de basses fréquences codée, la représentation de l'enveloppe spectrale et les informations relatives aux modes de reconstruction associés et les indications de position de transitoires, pour obtenir un signal audio codé.

2. Codeur selon la revendication 1, dans lequel le moyen pour générer est réalisé de sorte que les limites de trame à l'intérieur des trames auxquelles est associé le premier parmi les au moins deux modes de reconstruction possibles se trouvent de sorte qu'elles déterminent au moins une première zone de trame (220) dont la position à l'intérieur de la trame respective est fonction de l'indication de position de transitoire et dont l'extension dans le temps est inférieure à 1/3 d'une longueur des trames, ainsi qu'une deuxième et/ou une troisième zone de trame (222a, 222b) qui occupe ou occupent la partie restante de la trame respective de la première zone de trame à la limite de trame précédente dans le temps ou suivante dans le temps (902a, 902b) de la trame respective.

3. Codeur selon la revendication 2, dans lequel le moyen pour générer et le moyen pour regrouper sont réalisés pour introduire dans le signal audio codé, pour une trame (404) à laquelle est associé le premier mode de reconstruction et qui présente trois zones de trame (410, 412, 414), et dans laquelle la première zone de trame (412) parmi les trois zones de trame est plus rapprochée d'une trame précédente que d'une valeur prédéterminée, uniquement pour la première et la troisième zone de trame (412, 414) une ou plusieurs valeurs d'enveloppe spectrale décrivant l'enveloppe spectrale avec une résolution de fréquence respective, et pour ne pas introduire dans le signal audio codé, pour la deuxième zone (410) de cette trame (404), de valeur d'enveloppe spectrale.

4. Codeur selon la revendication 2 ou 3, dans lequel le moyen pour générer et le moyen pour regrouper sont réalisés pour introduire dans le signal audio codé, pour une trame (502) à laquelle est associé le premier mode de reconstruction et qui ne présente que deux zones de trame (502a, 502b) et dans laquelle la première zone de trame (502b) est adjacente à la limite de trame arrière dans le temps, pour les deux zones de trame une ou plusieurs valeurs d'enveloppe spectrale décrivant l'enveloppe spectrale avec une résolution de fréquence respective, et pour utiliser, pour déterminer la ou les valeurs d'enveloppe spectrale pour la première zone de trame (502b), également des parties du signal audio qui se trouvent dans une zone de trame d'extension (504b') dans la trame suivante (504) qui est adjacente à la limite de trame arrière, et pour raccourcir en conséquence une zone de trame la plus avant dans le temps (504a') de la trame suivante (504) telle que fixée par le mode de reconstruction de la trame suivante, pour ne commencer qu'à la zone de trame d'extension (504b').

5. Codeur selon la revendication 3 ou 4, dans lequel le moyen pour générer et le moyen pour regrouper sont réalisés pour introduire dans le signal audio codé, pour une trame à laquelle est associé le deuxième mode de reconstruction ou à laquelle est associé le premier mode de reconstruction, mais pour laquelle n'est remplie ni la condition qu'elle présente trois zones de trame et que la première zone de trame parmi les trois zones de trame se trouve plus rapprochée de la trame précédente que de la valeur prédéterminée, ni la condition qu'elle ne présente que deux zones de trame et que la première zone de trame est adjacente à la limite de trame arrière dans le temps, pour chaque zone de cette trame une ou plusieurs valeurs d'enveloppe spectrale.

6. Codeur selon la revendication 2, dans lequel le moyen pour générer est réalisé de sorte que la première zone de trame (220) soit adjacente à la limite de trame avant dans le temps (902a) de la trame respective lorsqu'il n'existe pas de deuxième zone de trame (222a) et que la première zone de trame (220) est adjacente à la limite de trame arrière dans le temps (902b) de la trame respective lorsqu'il n'existe pas de troisième zone de trame (222b).

7. Codeur selon l'une des revendications précédentes, dans lequel le moyen pour générer est réalisé de sorte que les limites de trame à l'intérieur de trames auxquelles est associé le deuxième parmi les au moins deux modes de reconstruction possibles sont disposées de manière répartie uniformément dans le temps, de sorte que ces trames ne présentent qu'une seule zone de trame ou sont divisées en zones de trame de même grandeur (906a, 906b).

8. Codeur selon l'une des revendications précédentes, dans lequel le moyen pour associer est réalisé pour associer, à chaque trame à l'intérieur de trames auxquelles est associé le deuxième parmi les au moins deux modes de reconstruction possibles, une indication de nombre de subdivisions de trame, le moyen pour générer étant réalisé de sorte que les limites de trame à l'intérieur de ces trames subdivisent ces trames en un nombre de zones de trame qui est fonction de l'indication de nombre de subdivisions de trame respective.

9. Codeur selon l'une des revendications précédentes, dans lequel le moyen pour générer est réalisé de sorte que, indépendamment des modes de reconstruction possibles associés aux trames, les limites des trames coïncident toujours avec des limites de la trame.

10. Codeur selon l'une des revendications précédentes, dans lequel le moyen pour générer présente un banc de filtres d'analyse (110) qui génère, par fenêtre de temps de banc de filtres (904) du signal audio, un ensemble de valeurs spectrales (250), chaque trame (902) étant d'une longueur de plusieurs fenêtres de temps de banc de filtres, et le moyen (112) pour générer présentant, par ailleurs, un moyen pour établir la moyenne des valeurs spectrales d'énergie dans la résolution de la trame.

11. Codeur selon la revendication 10, dans lequel l'indication de position de transitoires est définie en unités de fenêtre de temps de banc de filtres (904).

12. Décodeur, avec
un moyen (306) pour extraire du signal audio codé une partie de basses fréquences codée d'un signal audio, une représentation d'une enveloppe spectrale d'une part de hautes fréquences du signal audio, les informations relatives aux modes de reconstruction associés à des trames du signal audio et correspondant, chacun, à l'un parmi au moins deux modes de reconstruction, et les indications de position de transitoires associées, chacune, à des trames auxquelles est associé un premier parmi les au moins deux modes de reconstruction;
un moyen (308) pour décoder la part de basses fréquences codée du signal audio en unités de trames du signal audio;
un moyen (310) pour préparer un signal de part de hautes fréquences provisoire sur base de la part de basses fréquences décodée; et
un moyen (318, 312, 314) pour l'adaptation spectrale du signal de part de hautes fréquences provisoire à l'enveloppe spectrale par pondération spectrale du signal de part de hautes fréquences provisoire en fonction de la représentation de l'enveloppe spectrale dans une trame dans le temps qui est fonction des modes de reconstruction associés aux trames, de sorte que, pour les trames auxquelles est associé le premier parmi les au moins deux modes de reconstruction possibles, les limites de ces trames coïncident avec des limites de la trame, et que les limites de la trame à l'intérieur de ces trames soient fonction de l'indication de position de transitoire.

13. Décodeur selon la revendication 12, dans lequel le moyen pour l'adaptation spectrale est réalisé de sorte que la ou les limites de trame se situent à l'intérieur d'une trame à laquelle est associé le premier parmi les au moins deux modes de reconstruction possibles de sorte qu'elles fixent au moins une première zone de trame (220) dont la position à l'intérieur de la trame respective dépend de l'indication de position de transitoires et donc l'extension dans le temps est inférieure à 1/3 d'une longueur des trames, ainsi qu'une deuxième et/ou une troisième zone de trame (222a, 222b) qui occupe ou occupent la partie restante de la trame respective de la première zone de trame à la limite de trame avant dans le temps ou arrière dans le temps (902a, 902b) de la trame respective.

14. Décodeur selon la revendication 13, dans lequel le moyen pour extraire est réalisé pour attendre dans le signal audio codé et extraire du signal audio codé, pour une trame (404) à laquelle est associé le premier mode de reconstruction qui présente trois zones de trame (410, 412, 414) et dans laquelle la première zone de trame (412) parmi les trois zones de trame est rapprochée de plus d'une valeur prédéterminée d'une trame précédente (406), uniquement pour la première et la troisième zone de trame (412, 414) une ou plusieurs valeurs d'enveloppe spectrale décrivant l'enveloppe spectrale avec une résolution de fréquence respective, et pour obtenir, pour la deuxième zone de trame (410), une ou plusieurs valeurs d'enveloppe spectrale pour la représentation de l'enveloppe spectrale à partir de la dernière zone de trame dans le temps (408) de la trame précédente (406).

15. Décodeur selon la revendication 13 ou 14, dans lequel le moyen pour extraire est réalisé pour attendre dans le signal audio codé et extraire du signal audio codé, pour une trame (502), à laquelle est associé le premier mode de reconstruction, qui présente deux zones de trame (502a, 502b) et dans laquelle la première zone de trame (502b) est adjacente à la limite de trame arrière dans le temps (502), pour les deux zones de trame une ou plusieurs valeurs d'enveloppe spectrale décrivant l'enveloppe spectrale avec une résolution de fréquence respective, et pour obtenir à partir de la ou des valeurs d'enveloppe spectrale, pour la première zone de trame (502b), une ou plusieurs valeurs d'enveloppe spectrale pour une zone de trame complémentaire (504b') dans la trame suivante (504) adjacente à la limite de trame arrière, et pour raccourcir en conséquence une zone de trame la plus en avant dans le temps (504a') de la trame suivante (504), telle que fixée par le mode de reconstruction de la trame suivante, pour ne commencer qu'à la zone de trame complémentaire (504b'), d'où la trame dans le temps dans la trame suivante (504) est subdivisée, et le moyen pour l'adaptation spectrale étant adapté pour procéder à l'adaptation dans la trame dans le temps subdivisée.

16. Décodeur selon la revendication 14 ou 15, dans lequel le moyen pour extraire est réalisé pour attendre dans le signal audio codé et extraire du signal audio codé, pour une trame à laquelle est associé le deuxième mode de reconstruction ou à laquelle est associé le premier mode de reconstruction, mais pour lequel n'est remplie ni la condition qu'elle présente trois zones de trame et que la première zone de trame parmi les trois zones de trame se rapproche de la trame précédente de plus de la valeur prédéterminée, ni la condition qu'elle présente deux zones de trame et que la première zone de trame soit adjacente à la limite de trame arrière dans le temps, pour chaque zone de cette trame une ou plusieurs valeurs d'enveloppe spectrale.

17. Décodeur selon la revendication 16, dans lequel le moyen pour l'adaptation spectrale est réalisé de sorte que la première zone de trame (220) est adjacente à la limite de trame avant dans le temps (902a) de la trame respective lorsqu'il n'existe pas de deuxième zone de trame (222a), et la première zone de trame (220) est adjacente à la limite de trame arrière dans le temps (902b) de la trame respective lorsqu'il n'existe pas de troisième zone de trame (222b).

18. Décodeur selon l'une des revendications 12 à 17, dans lequel le moyen pour l'adaptation spectrale est réalisé de sorte que les limites de trame à l'intérieur de trames auxquelles est associé le deuxième parmi les au moins deux modes de reconstruction possibles sont disposées de manière réparties uniformément dans le temps, de sorte que ces trames ne présentent qu'une seule zone de trame ou sont subdivisées en zones de trame de même grandeur (906a, 906b).

19. Décodeur selon l'une des revendications 12 à 18, dans lequel le moyen pour extraire est réalisé pour extraire du signal audio également une indication de nombre de subdivisions de trame associée chaque fois à des trames auxquelles est associé le deuxième parmi les modes de reconstruction possibles, le moyen pour l'adaptation spectrale étant réalisé de sorte que les limites de trame à l'intérieur de ces trames soient subdivisées en un nombre de zones de trame qui est fonction de l'indication de nombre de subdivisions de trame respective.

20. Décodeur selon l'une des revendications 12 à 19, dans lequel le moyen pour l'adaptation spectrale est réalisé de sorte que, indépendamment des modes de reconstruction possibles associés aux trames, les limites des trames coïncident toujours avec les limites de la trame.

21. Décodeur selon l'une des revendications 12 à 20, dans lequel le moyen pour l'adaptation spectrale présente un banc de filtres d'analyse (310) qui génère, par fenêtre de temps de banc de filtres du signal audio décodé, un ensemble de valeurs spectrales, chaque trame étant d'une longueur de plusieurs fenêtres de temps de banc de filtres, et le moyen pour l'adaptation spectrale présentant par ailleurs un moyen (318) pour déterminer l'énergie des valeurs spectrales dans la résolution de la trame.

22. Décodeur selon la revendication 21, dans lequel l'indication de position de transitoires est définie en unités de fenêtre de temps de banc de filtres.

23. Signal audio codé, avec
une part de basses fréquences codée d'un signal audio;
une représentation d'une enveloppe spectrale d'une part de hautes fréquences d'un signal audio; et
des informations sur les modes de reconstruction associés aux trames du signal audio et correspondant, chacun, à l'un d'au moins deux modes de reconstruction, et des indications de position de transitoires associées, chacune, à des trames auxquelles est associé un premier des au moins deux modes de reconstruction,
de sorte qu'à partir du signal audio codé, le signal audio puisse être obtenu par les étapes suivantes consistant à:
décoder la part de basses fréquences codée du signal audio en unités de trames du signal audio;
préparer un signal de part de hautes fréquences provisoire sur base de la part de basses fréquences décodée; et
adapter de manière spectrale le signal de part de hautes fréquences provisoire à l'enveloppe spectrale par pondération spectrale du signal de part de hautes fréquences provisoire en fonction de la représentation de l'enveloppe spectrale dans une trame dans le temps qui est fonction des modes de reconstruction associés aux trames, de sorte que, pour les trames auxquelles est associé le premier parmi les au moins deux modes de reconstruction possibles, les limites de ces trames coïncident avec les limites de la trame, et que les limites de la trame à l'intérieur de ces trames soient fonction de l'indication de position de transitoire.

24. Procédé de codage, présentant les étapes suivantes consistant à:
coder une part de basses fréquences d'un signal audio en unités de trame (902) du signal audio;
localiser les transitoires dans le signal audio en fonction de la localisation, associer un mode de reconstruction respectif parmi au moins deux modes de reconstruction possibles aux trames du signal audio et, pour les trames auxquelles est associé un premier parmi les au moins deux modes de reconstruction possibles, associer une indication de position de transitoires respective à ces trames; et
générer une représentation d'une enveloppe spectrale d'une part de hautes fréquences du signal audio dans une trame dans le temps qui est fonction des modes de reconstruction associés aux trames, de sorte que, pour les trames auxquelles est associé le premier parmi au moins deux modes de reconstruction possible, les limites (902a, 902b) de ces trames (902) coïncident avec des limites de la trame (222a, 220, 222b), et que les limites de la trame à l'intérieur de ces trames soient fonction de l'indication de position de transitoires; et
regrouper la part de basses fréquences codée, la représentation de l'enveloppe spectrale et les informations sur les modes de reconstruction associés et les indications de position de transitoires, pour obtenir un signal audio codé.

25. Procédé de décodage, présentant les étapes suivantes consistant à:
extraire du signal audio codé une part de basses fréquences codée d'un signal audio, une représentation d'une enveloppe spectrale d'une part de hautes fréquences du signal audio et des informations sur les modes de reconstruction associés aux trames du signal audio et correspondant, chacun, à l'un parmi les au moins deux modes de reconstruction, et des indications de position de transitoire associées, chacune, à des trames auxquelles est associé le premier parmi les au moins deux modes de reconstruction;
décoder la part de basses fréquences codée du signal audio en unités de trames du signal audio;
préparer un signal de part de hautes fréquences provisoire sur base de la part de basses fréquences décodée; et
adapter de manière spectrale le signal de part de hautes fréquences provisoire à l'enveloppe spectrale par pondération spectrale du signal de part de hautes fréquences provisoire en fonction de la représentation de l'enveloppe spectrale dans une trame dans le temps qui est fonction des modes de reconstruction associés aux trames, de sorte que, pour les trames auxquelles est associé le premier parmi les au moins deux modes de reconstruction possibles, les limites de ces trames coïncident avec des limites de la trame, et les limites de la trame à l'intérieur de ces trames soient fonction de l'indication de position de transitoires.

26. Décodeur, avec
un moyen (306) pour extraire d'un signal audio codé une part de basses fréquences codée d'un signal audio, des informations fixant une trame dans le temps (802a, 802b, 804a), de sorte qu'au moins une zone de trame (802b) s'étende au-delà d'une limite de deux trames adjacentes (802, 804) du signal audio, pour venir en recouvrement avec les deux trames adjacentes, et une représentation d'une enveloppe spectrale d'une part de hautes fréquences du signal audio;
un moyen (308) pour décoder la part de basses fréquences codée du signal audio en unités des trames (802, 804) du signal audio;
un moyen (310) pour déterminer un signal de part de hautes fréquences provisoire sur base de la part de basses fréquences décodée; et
un moyen (318, 312, 314) pour l'adaptation spectrale du signal de part de hautes fréquences provisoire à l'enveloppe spectrale par pondération spectrale du signal de part de hautes fréquences provisoire par dérivation, de la représentation de l'enveloppe spectrale dans la trame dans le temps (802a, 802b, 804a), d'une représentation de l'enveloppe spectrale dans une trame dans le temps subdivisée (802a, 802b₁, 802b₂, 804a) dans laquelle la zone de trame (802b) venant en recouvrement avec les deux trames adjacentes est subdivisée en une première zone de trame partielle (802b₁) et une deuxième zone de trame partielle (802b₂) adjacentes l'une à l'autre à la limite de trame, et en vue de l'adaptation du signal de part de hautes fréquences provisoire à l'enveloppe spectrale par pondération spectrale de la part de hautes fréquences provisoire dans la trame dans le temps subdivisée.

27. Décodeur selon la revendication 26, dans lequel le moyen pour extraire est réalisé pour extraire du signal audio codé, comme informations, des informations sur les modes de reconstruction associés aux trames du signal audio qui fixent la trame dans le temps, les modes de reconstruction fixant, chacun, des zones de la trame dans le temps et correspondant, chacun, à l'un parmi une pluralité de modes de reconstruction possibles, et le moyen pour extraire est réalisé pour extraire du signal audio codé, pour les trames auxquelles est associé l'un prédéterminé des modes de reconstruction possibles, également une indication qui indique la manière dont une limite de trame extérieure (802b) de la trame (802) venant en recouvrement avec la trame (802) doit être orientée dans le temps vers une limite de la trame, et pour extraire du signal audio codé, pour chaque zone de trame (802a, b, c) de la trame dans le temps, une ou plusieurs valeurs d'enveloppe spectrale.

28. Décodeur selon la revendication 27, dans lequel le moyen pour 1 l'adaptation spectrale est réalisé pour obtenir, à partir de l'une ou des plusieurs valeurs d'enveloppe spectrale de la zone de trame (802b) venant en recouvrement avec les deux trames adjacentes (802, 804), une première ou plusieurs premières valeurs d'enveloppe spectrale pour la première zone de trame partielle (802b₁) et une deuxième ou plusieurs deuxièmes valeurs d'enveloppe spectrale pour la deuxième zone de trame partielle (802b₂).

29. Décodeur selon la revendication 28, dans lequel le moyen pour l'adaptation spectrale est réalisé de sorte que chaque valeur d'enveloppe spectrale de la zone de trame (802b) venant en recouvrement avec les deux trames adjacentes (802, 804) soit divisée, en fonction d'un rapport entre une grandeur de la première zone de trame partielle (802b₁) et une grandeur de la deuxième zone de trame partielle (802b₂), en une première et une deuxième valeur d'enveloppe spectrale respective.

30. Décodeur selon l'une des revendications 26 à 29, dans lequel le moyen pour l'adaptation spectrale présente un banc de filtres d'analyse générant, par fenêtre de banc de filtres du signal audio décodé, un ensemble de valeurs spectrales, chaque trame étant d'une longueur de plusieurs fenêtres de banc de filtres, et le moyen pour l'adaptation spectrale présentant un moyen pour déterminer une énergie de la valeur spectrale dans la résolution de la trame dans le temps subdivisée.

31. Procédé de décodage, aux étapes suivantes consistant à:
extraire d'un signal audio codé une part de basses fréquences codée d'un signal audio, des informations fixant une trame dans le temps (802a, 802b, 804a), de sorte qu'au moins une zone de trame (802b) s'étende au-delà d'une limite de deux trames adjacentes (802, 804) du signal audio, pour venir en recouvrement avec les deux trames adjacentes, et une représentation d'une enveloppe spectrale d'une part de hautes fréquences du signal audio ;
décoder la part de basses fréquences codée du signal audio en unités des trames (802, 804) du signal audio;
déterminer une part de signal de hautes fréquences sur base de la part de basses fréquences décodée; et
adapter de manière spectrale la part de signal de hautes fréquences provisoire à l'enveloppe spectrale par pondération spectrale du signal de hautes fréquences provisoire par dérivation, de la représentation de l'enveloppe spectrale dans la trame dans le temps (802a, 802b, 804a), d'une représentation de l'enveloppe spectrale dans une trame dans le temps subdivisée (802a, 802bi, 802b₂, 804a) dans laquelle la zone de trame (802b) venant en recouvrement avec les deux trames adjacentes est subdivisée en une première zone de trame partielle (802b₁) et en une deuxième zone de trame partielle (802b₂) qui sont adjacentes l'une à l'autre à la limite de trame, et en vue de l'adaptation de la part de signal de hautes fréquences provisoire à l'enveloppe spectrale par pondération spectrale de la part de signal de hautes fréquences provisoire dans la trame dans le temps subdivisée.

32. Codeur, avec
un moyen (104, 106) pour coder une part de basses fréquences d'un signal audio en unités de trames (902) du signal audio;
un moyen (118,116) pour fixer une trame dans le temps (802a, 802b, 804a), de sorte qu'au moins une zone de trame (802b) s'étende au-delà d'une limite de deux trames adjacentes (802, 804) du signal audio, pour venir en recouvrement avec les deux trames adjacentes; et
un moyen (110, 112, 114) pour générer une représentation d'une enveloppe spectrale d'une part de hautes fréquences du signal audio dans la trame dans le temps; et
un moyen (108) pour regrouper la part de basses fréquences codée, la représentation de l'enveloppe spectrale et les informations sur la trame dans le temps, pour obtenir un signal audio codé,
le moyen pour générer et le moyen pour regrouper étant réalisés de sorte que la représentation de l'enveloppe spectrale dans la zone de trame s'étendant au-delà de la limite des deux trames adjacentes (802, 804) du signal audio est fonction d'un rapport entre une part (802bi) de cette zone de trame venant en recouvrement avec l'une des deux trames adjacentes et une part (802b₂) de cette zone de trame venant en recouvrement avec l'autre des deux trames adjacentes.

33. Procédé de codage, aux étapes suivantes consistant à:
coder une part de basses fréquences d'un signal audio en unités de trames (902) du signal audio;
fixer une trame dans le temps (802a, 802b, 804a), de sorte qu'au moins une zone de trame (802b) s'étende au-delà d'une limite de trame de deux trames adjacentes (802, 804) du signal audio, pour venir en recouvrement avec les deux trames adjacentes; et
générer une représentation d'une enveloppe spectrale d'une part de hautes fréquences du signal audio dans la trame dans le temps; et
regrouper la part de basses fréquences codée, la représentation de l'enveloppe spectrale et les informations sur la trame dans le temps, pour obtenir un signal audio codé,
l'étape consistant à générer et l'étape consistant à regrouper étant effectuées de sorte que la représentation de l'enveloppe spectrale dans la zone de trame s'étendant au-delà de la limite de trame des deux trames adjacentes (802, 804) du signal audio dépende d'un rapport entre une part (802bi) de cette zone de trame venant en recouvrement avec l'une des deux trames adjacentes et une part (802b₂) de cette zone de trame venant en recouvrement avec l'autre des deux trames adjacentes.

34. Codeur, avec
un moyen (104, 106) pour coder une part de basses fréquences d'un signal audio en unités de trames (902) du signal audio;
un moyen (118) pour localiser des transitoires dans le signal audio;
un moyen (116) pour associer aux trames du signal audio, en fonction de la localisation, un mode de reconstruction respectif parmi une pluralité de modes de reconstruction possibles et pour associer à ces trames, pour les trames auxquelles est associé un premier parmi la pluralité de modes de reconstruction, une indication d'absence de transitoires respective; et
un moyen (110, 112, 114) pour générer une représentation d'une enveloppe spectrale d'une part de hautes fréquences du signal audio dans une trame dans le temps qui est fonction des modes de reconstruction associés aux trames, de sorte que, pour les trames auxquelles est associé le premier parmi la pluralité de modes de reconstruction possibles, les limites (902a, 902b) de ces trames (902) coïncident avec les limites de la trame (222a, 220, 222b); et
un moyen (108) pour regrouper la part de basses fréquences codée, la représentation de l'enveloppe spectrale et les informations sur les modes de reconstruction associés et l'indication d'absence de transitoires, pour obtenir un signal audio codé,
le moyen pour générer et le moyen pour regrouper étant réalisés pour introduire comme partie de la représentation de l'enveloppe spectrale dans le signal audio codé, pour une trame (404) à laquelle est associé le premier mode de reconstruction, pour la première zone de trame dans le temps de cette trame, en fonction de l'indication d'absence de transitoires, soit aucune, soit une ou plusieurs valeurs d'enveloppe spectrale décrivant l'enveloppe spectrale avec une résolution de fréquence respective.

35. Codeur selon la revendication 34, dans lequel le moyen pour générer est réalisé de sorte que les limites de trame à l'intérieur des trames auxquelles est associé le deuxième parmi les au moins deux modes de reconstruction possibles soient disposées de manière réparties uniformément dans le temps, de sorte que ces trames ne présentent qu'une seule zone de trame ou soient divisées en zones de trame de même grandeur (906a, 906b).

36. Décodeur, avec
un moyen (306) pour extraire du signal audio codé une part de basses fréquences codée d'un signal audio, une représentation d'une enveloppe spectrale d'une part de hautes fréquences du signal audio, les informations sur les modes de reconstruction associés à des trames du signal audio et correspondant, chacun, à l'un parmi une pluralité de modes de reconstruction, et les indications d'absence de transitoires associées, chacune, à des trames auxquelles est associé un premier parmi la pluralité de modes de reconstruction;
un moyen (308) pour décoder la part de basses fréquences du signal audio en unités des trames (802, 804) du signal audio;
un moyen (310) pour déterminer un signal de part de hautes fréquences provisoire sur base de la part de basses fréquences décodée; et
un moyen (318, 312, 314) pour l'adaptation spectrale du signal de part de hautes fréquences provisoire à l'enveloppe spectrale par pondération spectrale de la part de hautes fréquences provisoire dans une trame provisoire qui est fonction des modes de reconstruction associés aux trames, de sorte que, pour les trames auxquelles est associé le premier parmi la pluralité de modes de reconstruction possibles, les limites de trame (902a, 902b) de ces trames (902) coïncident avec les limites de la trame (222a, 220, 222b), et le moyen pour l'adaptation spectrale utilisant une ou plusieurs valeurs d'enveloppe spectrale par zone de trame à l'intérieur de ces trames pour la représentation de l'enveloppe spectrale,
le moyen pour extraire étant réalisé pour soit extraire du signal audio codé, comme partie de la représentation de l'enveloppe spectrale, pour une trame (404) à laquelle est associé le premier mode de reconstruction, pour la première zone de trame dans le temps de cette trame, en fonction de l'indication d'absence de transitoires, une ou plusieurs valeurs d'enveloppe spectrale décrivant l'enveloppe spectrale avec une résolution de fréquence respective, soit les obtenir à partir d'une ou plusieurs valeurs d'enveloppe spectrale d'une zone de trame, adjacente à la première zone de trame dans le temps, de la trame précédente dans le temps.

37. Procédé de codage, aux étapes suivantes consistant à:
coder une part de basses fréquences d'un signal audio en unités de trames (902) du signal audio;
localiser des transitoires dans le signal audio;
en fonction de la localisation, associer un mode de reconstruction respectif parmi une pluralité de modes de reconstruction possibles aux trames du signal audio et, pour les trames auxquelles est associé un premier mode de reconstruction parmi la pluralité de modes de reconstruction, associer une indication d'absence de transitoires respective à ces trames;
générer une représentation d'une enveloppe spectrale d'une part de hautes fréquences du signal audio dans une trame dans le temps qui est fonction des modes de reconstruction associés aux trames, de sorte que, pour les trames auxquelles est associé le premier parmi la pluralité de modes de reconstruction possibles, lés limites de trame (902a, 902b) de ces trames (902) coïncident avec les limites de la trame (222a, 220, 222b); et
regrouper la part de basses fréquences codée, la représentation de l'enveloppe spectrale et les informations sur les modes de reconstruction associés et l'indication d'absence de transitoires, pour obtenir un signal audio codé,
la génération et le regroupement étant réalisés de sorte que soient introduites dans le signal audio codé, comme partie de la représentation de l'enveloppe spectrale, pour une trame (404) à laquelle est associé le premier mode de reconstruction, pour la première zone de trame dans le temps de cette trame, en fonction de l'indication d'absence de transitoires, soit pas de, soit une ou plusieurs valeurs d'enveloppe spectrale décrivant l'enveloppe spectrale avec une résolution de fréquence respective.

38. Procédé de décodage, aux étapes suivantes consistant à:
extraire du signal audio codé une part de basses fréquences codée d'un signal audio, une représentation d'une enveloppe spectrale d'une part de hautes fréquences du signal audio, des informations sur les modes de reconstruction associés aux trames du signal audio et correspondant, chacun, à l'un parmi une pluralité de modes de reconstruction, et les indications d'absence de transitoires associées, chacune, à des trames auxquelles est associé un premier parmi la pluralité de modes de reconstruction; décoder la part de basses fréquences codée du signal audio en unités des trames (802, 804) du signal audio;
déterminer un signal de part de hautes fréquences provisoire sur base de la part de basses fréquences décodée; et
adapter de manière spectrale le signal de part de hautes fréquences provisoire à l'enveloppe spectrale par pondération spectrale du signal de part de hautes fréquences provisoire dans une trame dans le temps qui dépend des modes de reconstruction associés aux trames, de sorte que, pour les trames auxquelles est associé le premier parmi la pluralité de modes de reconstruction possibles, les limites de trame (902a, 902b) de ces trames (902) coïncident avec des limites de la trame (222a, 220, 222b), et le moyen d'adaptation spectrale utilise une ou plusieurs valeurs d'enveloppe spectrale par zone de trame à l'intérieur de ces trames pour la représentation de l'enveloppe spectrale,
l'extraction étant réalisée de sorte que, pour une trame (404) à laquelle est associé le premier mode de reconstruction, soit soient extraites du signal audio codé, comme part de la représentation de l'enveloppe spectrale, pour la première zone de trame dans le temps de cette trame, en fonction de l'indication d'absence de transitoires, une ou plusieurs valeurs d'enveloppe spectrale décrivant l'enveloppe spectrale avec une résolution de fréquence respective, soit qu'elles soient obtenues à partir d'une ou plusieurs valeurs d'enveloppe spectrale d'une zone de trame, adjacente à la première zone de trame dans le temps, de la trame précédente dans le temps.

39. Signal audio codé, avec
une part de basses fréquences codée d'un signal audio;
une représentation d'une enveloppe spectrale d'une part de hautes fréquences du signal audio;
des informations sur les modes de reconstruction associés aux trames du signal audio et correspondant, chacune, à l'un d'une pluralité de modes de reconstruction, et des indications d'absence de transitoires associées, chacune, à des trames auxquelles est associé un premier parmi la pluralité de modes de reconstruction, de sorte qu'à partir du signal audio codé puisse être obtenu le signal audio par les étapes suivantes consistant à:
décoder la part de basses fréquences codée du signal audio en unités des trames (802, 804) du signal audio;
déterminer un signal de part de hautes fréquences provisoire sur base de la part de basses fréquences décodée; et
adapter de manière spectrale le signal de part de hautes fréquences provisoire à l'enveloppe spectrale par pondération spectrale du signal de part de hautes fréquences provisoire dans une trame dans le temps qui est fonction des modes de reconstruction associés aux trames, de sorte que pour les trames auxquelles est associé le premier parmi la pluralité de modes de reconstruction possibles, les limites de trame (902a, 902b) de ces trames (902) coïncident avec les limites de la trame (222a, 220, 222b), et le moyen pour l'adaptation spectrale utilise une ou plusieurs valeurs d'enveloppe spectrale par zone de trame à l'intérieur de ces trames pour la représentation de l'enveloppe spectrale,
l'extraction étant réalisée de sorte que, pour une trame (404) à laquelle est associé le premier mode de reconstruction, soit soient extraites du signal audio codé, comme partie de la représentation de l'enveloppe spectrale, pour la première zone de trame dans le temps de cette trame, en fonction de l'indication d'absence de transitoires, une ou plusieurs valeurs d'enveloppe spectrale décrivant l'enveloppe spectrale avec une résolution de fréquence respective, soit elles soient obtenues à partir d'une ou plusieurs valeurs d'enveloppe spectrale d'une zone de trame, adjacente à la première zone de trame dans le temps, de la trame précédente dans le temps.

40. Programme d'ordinateur avec un code de programme pour réaliser le procédé selon l'une des revendications 24, 25, 31, 33, 37 et 38 lorsque le programme d'ordinateur est exécuté sur un ordinateur.
